(19) Europäisches Patentamt
European Patent Office
Office européen des brevets

(11) EP 4 112 321 A1

(12) EUROPEAN PATENT APPLICATION
published in accordance with Art. 153(4) EPC

(43) Date of publication:
**04.01.2023 Bulletin 2023/01**

(21) Application number: **21759900.0**

(22) Date of filing: **25.02.2021**

(51) International Patent Classification (IPC):
***B41N 1/14*** (2006.01) ***G03F 7/00*** (2006.01)
***G03F 7/004*** (2006.01) ***G03F 7/029*** (2006.01)
***G03F 7/031*** (2006.01) ***G03F 7/11*** (2006.01)

(52) Cooperative Patent Classification (CPC):
**B41N 1/14; G03F 7/00; G03F 7/004; G03F 7/029; G03F 7/031; G03F 7/11**

(86) International application number:
**PCT/JP2021/007164**

(87) International publication number:
**WO 2021/172453 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.02.2020 JP 2020034242**

(71) Applicant: **FUJIFILM Corporation**
**Tokyo 106-8620 (JP)**

(72) Inventors:
- **SAKAGUCHI, Akira**
  **Haibara-gun, Shizuoka 421-0396 (JP)**
- **NOGOSHI, Keisuke**
  **Haibara-gun, Shizuoka 421-0396 (JP)**

(74) Representative: **HGF**
**HGF Limited**
**1 City Walk**
**Leeds LS11 9DX (GB)**

# (54) LITHOGRAPHIC PRINTING PLATE ORIGINAL PLATE, LITHOGRAPHIC PRINTING PLATE MANUFACTURING METHOD, AND LITHOGRAPHIC PRINTING METHOD

(57) Provided is a lithographic printing plate precursor having a support, an image-recording layer, and an overcoat layer in this order, in which the image-recording layer contains a polymerization initiator, a polymerizable compound, and particles, and the overcoat layer contains a discoloring compound. Also provided is a method of preparing a lithographic printing plate or a lithographic printing method that uses the lithographic printing plate precursor.

EP 4 112 321 A1

## Description

BACKGROUND OF THE INVENTION

1. Field of the Invention

The present disclosure relates to a lithographic printing plate precursor, a method of preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is applied to a method exploiting the mutual repulsion of water and oil-based ink, in which the lipophilic image area and the hydrophilic non-image area of a lithographic printing plate are used as an ink-receiving portion and a dampening water-receiving portion (that is, non-ink-receiving portion) respectively, the adhesiveness of ink is varied within the surface of the lithographic printing plate so that only the image area receives the ink, and then printing is performed by the transfer of the ink to a printing substrate such as paper.

In the related art, in order to prepare this lithographic printing plate, a lithographic printing plate precursor (also called PS plate) has been widely used which is obtained by providing a lipophilic photosensitive resin layer (also called image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. Examples of a method of preparing lithographic printing plate in a simple way include a method called "on-press development". That is, on-press development is a method of exposing a lithographic printing plate precursor, then immediately mounting the precursor on a printer without performing development of the related art, and removing an unnecessary portion of the image-recording layer at an early stage of the ordinary printing step.

In the present disclosure, a lithographic printing plate precursor that can be used for such on-press development is called "on-press development type lithographic printing plate precursor".

Examples of the lithographic printing plate precursors in the related art include those described in WO2019/219560A or JP2008-503365A.

WO2019/219560A describes a lithographic printing plate precursor that has an upper most layer on a photopolymerizable layer and develops color by heat and/or infrared irradiation, in which the upper most layer has a film thickness of 0.1 g/m to 1.75 g/m and contains an infrared absorbing compound having a functional group cleaved by heat and/or infrared irradiation.

JP2008-503365A describes a lithographic printing plate precursor having an image-recording layer containing a polymer binder in the form of particles.

SUMMARY OF THE INVENTION

An object to be achieved by an embodiment of the present disclosure is to provide a lithographic printing plate precursor making it possible to obtain a lithographic printing plate capable of suppressing plate missing.

An object of another embodiment of the present disclosure is to provide a method of preparing a lithographic printing plate or a lithographic printing method using the lithographic printing plate precursor.

Here, the term "plate missing" in the present disclosure refers to the following phenomenon.

That is, in a case where solids such as fibers of paper or threads of the worker’s clothing adhere to the surface of an image area in a lithographic printing plate, and the lithographic printing plate is used for printing as it is, the pressure applied to the image area locally increases at the site to which the solids have adhered, a part of the image area is damaged and removed accordingly, and ink does not stick to some parts, which is a phenomenon called plate missing. The increase of the number of sheets printed from the lithographic printing plate until the occurrence of "plate missing" is an indicator showing "plate missing is further suppressed".

The plate missing that occurs in a case where a UV ink is used as an ink is called "UV plate missing".

Means for achieving the above objects include the following aspects.

<1> A lithographic printing plate precursor having a support, an image-recording layer, and an overcoat layer in this order,

in which the image-recording layer contains a polymerization initiator, a polymerizable compound, and particles, and
the overcoat layer contains a discoloring compound.

<2> The lithographic printing plate precursor described in <1>, in which the particles are addition polymerization-type resin particles.
<3> The lithographic printing plate precursor described in <1>, in which the particles are polyaddition-type resin particles.
<4> The lithographic printing plate precursor described in <3>, in which the polyaddition-type resin particles have a three-dimensional crosslinked structure.
<5> The lithographic printing plate precursor described in <1>, in which the particles are thermoplastic resin particles.
<6> The lithographic printing plate precursor described in any one of <1> to <5>, in which the particles contain a hydrophilic group, and

the hydrophilic group includes a group represented by Formula Z.

-Q-W-Y Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

<7> The lithographic printing plate precursor described in <6>, in which any of the hydrophilic structures include a polyalkylene oxide structure.
<8> The lithographic printing plate precursor described in any one of <1> to <7>, in which the particles further contain a polymerizable group.
<9> The lithographic printing plate precursor described in any one of <1> to <8>, in which an arithmetic mean particle diameter of the particles is 1 nm to 500 nm.
<10> The lithographic printing plate precursor described in any one of <1> to <9>, in which in a case where the lithographic printing plate precursor is exposed to infrared having a wavelength of 830 nm at an energy density of 110 $mJ/cm^2$, a brightness change $\Delta L$ before and after the exposure is 1 or more.
<11> The lithographic printing plate precursor described in any one of <1> to <10>, in which the discoloring compound includes a decomposable compound that decomposes due to exposure to infrared.
<12> The lithographic printing plate precursor described in <11>, in which the discoloring compound includes a decomposable compound that decomposes by either or both of heat and electron transfer resulting from exposure to infrared.
<13> The lithographic printing plate precursor described in <11> or <12>, in which the decomposable compound is a cyanine dye.
<14> The lithographic printing plate precursor described in any one of <11> to <13>, in which the decomposable compound is a compound represented by Formula 1-1.

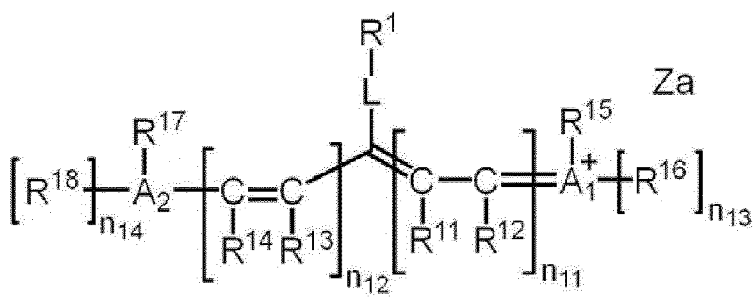
Formula 1-1

In Formula 1-1, $R^1$ represents a group that is represented by any of Formula 2 to Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently

represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

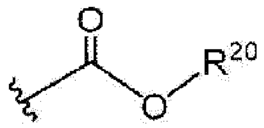

Formula 2

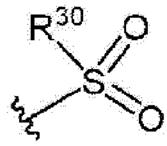

Formula 3

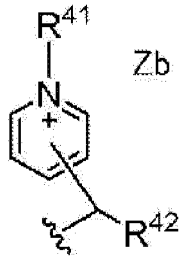

Formula 4

In Formula 2 to Formula 4, $R^{20}$, $R^{30}$, $R^{41}$, and $R^{42}$ each independently represent an alkyl group or an aryl group, Zb represents a counterion that neutralizes charge, a wavy line represents a binding site with the group represented by L in Formula 1-1.

<15> The lithographic printing plate precursor described in any one of <1> to <14>, in which the discoloring compound includes an acid color former.

<16> The lithographic printing plate precursor described in any one of <1> to <15>, in which the overcoat layer further contains a water-soluble polymer.

<17> The lithographic printing plate precursor described in <16>, in which the water-soluble polymer includes polyvinyl alcohol having a saponification degree of 50% or more.

<18> The lithographic printing plate precursor described in any one of <1> to <17>, in which the overcoat layer further contains an oil sensitizing agent.

<19> The lithographic printing plate precursor described in any one of <1> to <18>, in which the polymerization initiator includes an electron-donating polymerization initiator and an electron-accepting polymerization initiator.

<20> The lithographic printing plate precursor described in <19>, in which the polymerization initiator includes a compound in the form of a conjugate salt of the electron-donating polymerization initiator and the electron-accepting polymerization initiator.

<21> The lithographic printing plate precursor described in <19>, in which the electron-accepting polymerization initiator includes a compound represented by Formula (II).

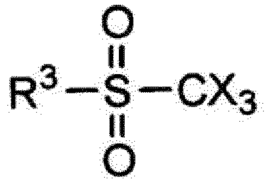 (II)

In Formula (II), X represents a halogen atom, and $R^3$ represents an aryl group.

<22> The lithographic printing plate precursor described in any one of <19> to <21>, in which the image-recording layer is an infrared absorber, and

HOMO of the infrared absorber - HOMO of the electron-donating polymerization initiator is 0.70 eV or less.

<23> The lithographic printing plate precursor described in any one of <19> to <22>,

in which the image-recording layer contains an infrared absorber, and LUMO of the electron-accepting polymerization initiator - LUMO of the infrared absorber is 0.70 eV or less.

<24> The lithographic printing plate precursor described in any one of <1> to <23>, in which the polymerizable compound includes a polymerizable compound having functionalities of 7 or more.

<25> The lithographic printing plate precursor described in any one of <1> to <24>, in which the polymerizable compound includes a polymerizable compound having functionalities of 10 or more.

<26> The lithographic printing plate precursor according to any one of <1> to <25>, in which the support has an aluminum plate and an anodic oxide film of aluminum disposed on the aluminum plate,

the anodic oxide film is at a position closer to a side of the image-recording layer than the aluminum plate and has micropores extending in a depth direction from a surface of the anodic oxide film on the side of the image-recording layer, and
an average diameter of the micropores within the surface of the anodic oxide film is more than 10 nm and 100 nm or less.

<27> The lithographic printing plate precursor described in <26>, in which the micropores are each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communication position,

an average diameter of the large diameter portion within the surface of the anodic oxide film is 15 nm to 100 nm, and
an average diameter of the small diameter portion at the communication position is 13 nm or less.

<28> A method of preparing a lithographic printing plate, including: a step of subjecting the lithographic printing plate precursor described in any one of <1> to <27> to image-wise light exposure,
a step of supplying at least one material selected from the group consisting of a printing ink and dampening water on a printer so as to remove the image-recording layer in a non-image area.
<29> A lithographic printing method, including a step of subjecting the lithographic printing plate precursor described in any one of <1> to <27> to image-wise light exposure,

a step of supplying at least one material selected from the group consisting of a printing ink and dampening water on a printer so as to remove the image-recording layer in a non-image area and to prepare a lithographic printing plate, and
a step of performing printing by using the obtained lithographic printing plate.

According to an embodiment of the present disclosure, it is possible to provide a lithographic printing plate precursor that makes it possible to obtain a lithographic printing plate capable of suppressing plate missing and is excellent in visibility of an exposed portion.
According to another embodiment of the present disclosure, it is possible to provide a method of preparing a lithographic printing plate or a lithographic printing method in which the lithographic printing plate precursor is used.

BRIEF DESCRIPTION OF THE DRAWINGS

Fig. 1 is a schematic cross-sectional view of an embodiment of an aluminum support.
Fig. 2 is a schematic cross-sectional view of another embodiment of the aluminum support.
Fig. 3 is an example of a waveform graph of alternating current used for an electrochemical roughening treatment in a method for manufacturing an aluminum support.
Fig. 4 is a lateral view showing an example of a radial cell in an electrochemical roughening treatment using alternating current in a method for manufacturing an aluminum support.
Fig. 5 is a schematic view of an anodic oxidation treatment device used for an anodic oxidation treatment in a method for manufacturing an aluminum support having an anodic oxide film.

DESCRIPTION OF THE PREFERRED EMBODIMENTS

Hereinafter, the contents of the present disclosure will be specifically described. The following constituents will be described on the basis of typical embodiments of the present disclosure, but the present disclosure is not limited to such embodiments.
In the present specification, a numerical range expressed using "to" includes numerical values listed before and after "to" as the lower limit and the upper limit.
In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).
In the present specification, "(meth)acryl" is a term used to explain a concept including both the acryl and

methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved.

In the present disclosure, "% by mass" has the same definition as "% by weight", and "part by mass" has the same definition as "part by weight".

In the present disclosure, unless otherwise specified, as each component contained in a composition or each constitutional unit contained in a polymer, one kind of component or one kind of constitutional unit may be used alone, or two or more kinds of components or two or more kinds of constitutional units may be used in combination.

Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

In the present disclosure, a combination of two or more preferable aspects is a more preferable aspect.

In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "excellent in printing durability" means that a large number of sheets can be printed using a lithographic printing plate, and printing durability exhibited in a case where a UV ink used as a printing ink will be also described as "UV printing durability" hereinafter.

In the present disclosure, "*" in a chemical structural formula represents a binding position with other structures.

Hereinafter, the present disclosure will be specifically described.

«Lithographic printing plate precursor»

The lithographic printing plate precursor according to the present disclosure has a support, an image-recording layer, and an overcoat layer in this order, in which the image-recording layer contains a polymerization initiator, a polymerizable compound, and particles, and the overcoat layer contains a discoloring compound.

The lithographic printing plate precursor according to the present disclosure is preferably an on-press development type lithographic printing plate precursor or a negative tone lithographic printing plate precursor.

In recent years, a technique has been known in which a discoloring compound is used in an overcoat layer on an image-recording layer as in the lithographic printing plate precursor described in WO2019/219560A so that the visibility of exposed portions is obtained.

Although the lithographic printing plate precursor in JP2019/219560A makes it possible to obtain the visibility of exposed portions, this precursor has a problem of causing "plate missing" when the number of printed sheets is still small. Presumably, because the overcoat layer (corresponding to the upper most layer in WO2019/219560A) contains an infrared absorbing compound, the curing reaction of the image-recording layer during exposure may be hindered, which may deteriorate the film hardness and lead to the above problem.

The inventors of the present invention conducted intensive studies on the above problem. As a result, the inventors have found that combining an overcoat layer containing a discoloring compound and an image-recording layer containing particles makes it possible to provide a lithographic printing plate precursor capable of suppressing plate missing. The mechanism that brings about this effect is unclear. Presumably, the particles in the image-recording layer may exhibit a filler effect, which may improve the film hardness of the image-recording layer regardless of exposure.

Furthermore, because the lithographic printing plate precursor according to the present disclosure includes the overcoat layer containing a discoloring compound, the visibility of exposed portions is excellent.

Hereinafter, each of the constituents of the lithographic printing plate precursor according to the present disclosure will be specifically described.

<Overcoat layer>

The overcoat layer in the present disclosure contains a discoloring compound.

The overcoat layer in the present disclosure may contain other components such as a water-soluble polymer, a hydrophobic polymer, an oil sensitizing agent, an acid generator, and an infrared absorber, in addition to the discoloring compound.

[Brightness change ΔL]

From the viewpoint of improving visibility of exposed portions, in a case where the lithographic printing plate precursor according to the present disclosure is exposed to infrared with a wavelength of 830 nm at an energy density of 110 $mJ/cm^2$, a brightness change ΔL between the brightness of the precursor before exposure and the brightness of the precursor after exposure is preferably 1 or more.

The brightness change ΔL is more preferably 3 or more, even more preferably 5 or more, particularly preferably 8 or more, and most preferably 10 or more.

The upper limit of the brightness change ΔL is, for example, 20.

The brightness change ΔL is measured by the following method.

In Luxel PLATESETTER T-9800 manufactured by FUJIFILM Global Graphic Systems that is equipped with an infrared semiconductor laser with a wavelength of 830 nm, the lithographic printing plate precursor is exposed under the conditions of output of 99.5%, outer drum rotation speed of 220 rpm (revolutions per minute), and resolution of 2,400 dpi (dots per inch, 1 inch = 25.4 mm (energy density of 110 $mJ/cm^2$). The exposure is performed in an environment of 25°C and 50%RH.

The brightness change of the lithographic printing plate precursor before and after exposure is measured.

The brightness change is measured using a spectrocolorimeter eXact manufactured by X-Rite, Incorporated. By using the L* value (brightness) in the L*a*b* color system, the absolute value of a difference between the L* value of the image-recording layer after the exposure and the L* value of the image-recording layer before the exposure is adopted as the brightness change ΔL.

[Discoloring compound]

In the present disclosure, "discoloring compound" refers to a compound which undergoes change in absorption in the visible light region (wavelength: 400 nm or more and less than 750 nm) due to the exposure to infrared. That is, in the present disclosure, "discoloring" means that the absorption in the visible light region (wavelength: 400 nm or more and less than 750 nm) changes due to the exposure to infrared.

Specifically, examples of the discoloring compound in the present disclosure include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.

The infrared in the present disclosure is a ray having a wavelength of 750 nm to 1 mm, and preferably a ray having a wavelength of 750 nm to 1,400 nm.

The discoloring compound in the present disclosure preferably includes a decomposable compound that decomposes due to the exposure to infrared, and particularly preferably includes a decomposable compound that decomposes by either or both of heat and electron transfer due to the exposure to infrared.

More specifically, the discoloring compound in the present disclosure is preferably a compound that decomposes due to the exposure to infrared (more preferably, decomposes by either or both of heat or electron transfer due to the exposure to infrared) and absorbs more light in the visible light region than before the exposure to infrared or is made capable of absorbing light of longer wavelengths and thus capable of absorbing light in the visible light region.

"Decomposes by electron transfer" mentioned herein means that electrons excited to the lowest unoccupied molecular orbital (LUMO) from the highest occupied molecular orbital (HOMO) of the discoloring compound by exposure to infrared move to electron accepting groups (groups having potential close to LUMO) in a molecule by means of intramolecular electron transfer and thus result in decomposition.

[Decomposable compound]

Hereinafter, as an example of the discoloring compound, a decomposable compound will be described.

There are no limitations on the decomposable compound as long as it absorbs at least a part of light in the

infrared wavelength region (wavelength region of 750 nm to 1 mm, preferably a wavelength region of 750 nm to 1,400 nm) and decomposes. The decomposable compound is preferably a compound having maximum absorption wavelength in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by the exposure to infrared (specifically, $R^1$ in General Formulas 1-1 to 1-7).

From the viewpoint of improving visibility of exposed portions, the decomposable compound is more preferably a compound represented by Formula 1-1.

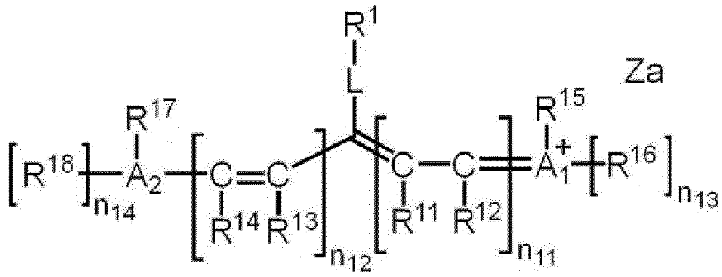

Formula 1-1

In Formula 1-1, $R^1$ represents a group that is represented by any of Formula 2 to Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

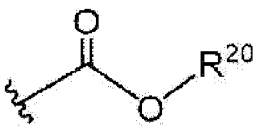

Formula 2

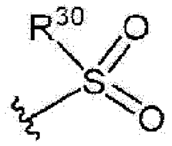

Formula 3

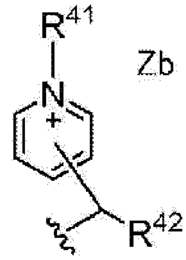

Formula 4

In Formula 2 to Formula 4, $R^{20}$, $R^{30}$, $R^{41}$, and $R^{42}$ each independently represent an alkyl group or an aryl group, Zb represents a counterion that neutralizes charge, a wavy line represents a binding site with the group represented by L in Formula 1-1.

In a case where the compound represented by Formula 1-1 is exposed to infrared, the $R^1$-L bond is cleaved, L turns into =O, =S, or $=NR^{10}$, and the compound is discolored.

In Formula 1-1, $R^1$ represents a group represented by any of Formula 2 to Formula 4.

Hereinafter, each of the group represented by Formula 2, the group represented by Formula 3, and the group represented by Formula 4 will be described.

In Formula 2, $R^{20}$ represents an alkyl group or an aryl group, and the portion of the wavy line represents a binding site with the group represented by L in Formula 1-1.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is even more preferable.

The alkyl group may be linear or branched, or may have a ring structure.

The aryl group represented by $R^{20}$ is preferably an aryl group having 6 to 30 carbon atoms, more preferably an aryl group having 6 to 20 carbon atoms, and even more preferably an aryl group having 6 to 12 carbon atoms.

From the viewpoint of improving visibility of exposed portions, $R^{20}$ is preferably an alkyl group.

From the viewpoint of improving visibility of exposed portions, the alkyl group represented by $R^{20}$ is preferably a secondary alkyl group or a tertiary alkyl group, and more preferably a tertiary alkyl group.

Furthermore, from the viewpoint of improving visibility of exposed portions, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Specific examples of the group represented by Formula 2 will be shown below. However, the present disclosure is not limited thereto. In the following structural formulas, ● represents a binding site with the group represented by L in Formula 1-1.

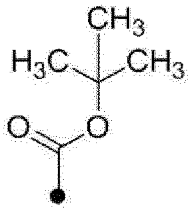 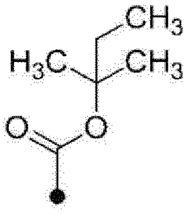 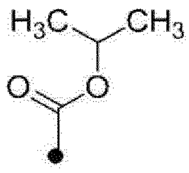 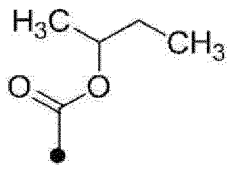 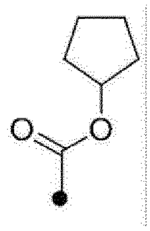

In Formula 3, $R^{30}$ represents an alkyl group or an aryl group, and the portion of the wavy line represents a binding site with the group represented by L in Formula 1-1.

The alkyl group and aryl group represented by $R^{30}$ are the same as the alkyl group and aryl group represented by $R^{20}$ in Formula 2, and the preferable aspects thereof are also the same.

From the viewpoint of improving visibility of exposed portions, the alkyl group represented by $R^{30}$ is preferably a secondary alkyl group or a tertiary alkyl group, and more preferably a tertiary alkyl group.

Furthermore, from the viewpoint of improving visibility of exposed portions, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

In addition, from the viewpoint of improving visibility of exposed portions, the alkyl group represented by $R^{30}$ is preferably an alkyl group or a substituted alkyl group, more preferably a fluoro-substituted alkyl group, even more preferably a perfluoroalkyl group, and particularly preferably a trifluoromethyl group.

From the viewpoint of improving visibility of exposed portions, the aryl group represented by $R^{30}$ is preferably a substituted aryl group. Examples of the substituent include an alkyl group (preferably an alkyl group having 1 to 4 carbon atoms), an alkoxy group (preferably an alkoxy group having 1 to 4 carbon atoms), and the like.

Specific examples of the group represented by Formula 3 will be shown below. However, the present disclosure is not limited thereto. In the following structural formulas, ● represents a binding site with the group represented by L in Formula 1-1.

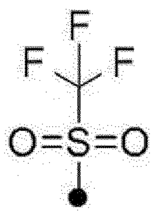 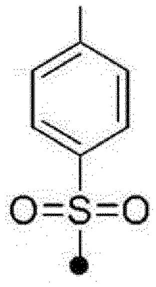

In Formula 4, $R^{41}$ and $R^{42}$ each independently represent an alkyl group or an aryl group, Zb represents a counterion that neutralizes charge, and the portion of the wavy line represents a binding site with the group represented by L in Formula 1-1.

The alkyl group and aryl group represented by $R^{41}$ or $R^{42}$ are the same as the alkyl group and aryl group represented by $R^{20}$ in Formula 2, and preferable aspects thereof are also the same.

From the viewpoint of improving visibility of exposed portions, $R^{41}$ is preferably an alkyl group.

From the viewpoint of improving visibility of exposed portions, $R^{42}$ is preferably an alkyl group.

From the viewpoint of improving visibility of exposed portions, the alkyl group represented by $R^{41}$ is preferably an alkyl group having 1 to 5 carbon atoms, more preferably an alkyl group having 1 to 3 carbon atoms, and particularly preferably a methyl group.

From the viewpoint of improving visibility of exposed portions, the alkyl group represented by $R^{42}$ is preferably a secondary alkyl group or a tertiary alkyl group, and more preferably a tertiary alkyl group.

Furthermore, from the viewpoint of improving visibility of exposed portions, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4 may be a counterion that neutralizes charge, and may be included in Za in Formula 1-1 in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4 will be shown below. However, the present disclosure is not limited thereto. In the following structural formulas, ● represents a binding site with the group represented by L in Formula 1-1.

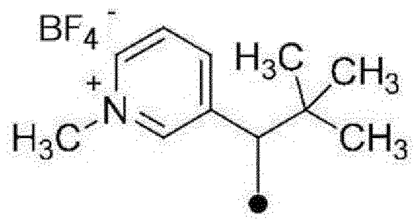

L in Formula 1-1 is preferably an oxygen atom or $-NR^{10}-$, and particularly preferably an oxygen atom.

Furthermore, $R^{10}$ in $-NR^{10}-$ is preferably an alkyl group. The alkyl group represented by $R^{10}$ is preferably an alkyl group having 1 to 10 carbon atoms. The alkyl group represented by $R^{10}$ may be linear or branched, or may have a ring structure.

Among the alkyl groups represented by $R^{10}$, a methyl group, a tert-butyl group, or a cyclohexyl group is preferable.

In a case where $R^{10}$ in $-NR^{10}-$ represents an aryl group, the aryl group is preferably an aryl group having 6 to 30 carbon atoms, more preferably an aryl group having 6 to 20 carbon atoms, and even more preferably an aryl group having 6 to 12 carbon atoms. These aryl groups may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and even more preferably a hydrocarbon group having 1 to 10 carbon atoms. The hydrocarbon group represented by $R^a$ to $R^e$ may be linear or branched, or may have a ring structure.

As the hydrocarbon group represented by $R^a$ to $R^e$, an alkyl group is particularly preferable.

The aforementioned alkyl group is preferably an alkyl group having 1 to 30 carbon atoms, more preferably an alkyl group having 1 to 15 carbon atoms, and even more preferably an alkyl group having 1 to 10 carbon atoms.

The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The above alkyl group may have a substituent.

Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, groups obtained by combining these, and the like.

$R^{11}$ to $R^{14}$ in Formula 1-1 preferably each independently represent a hydrogen atom or $-R^a$ (that is, a hydrocarbon group), more preferably each independently represent a hydrogen atom or an alkyl group, and even more preferably each independently represent a hydrogen atom except in the cases described below.

Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene

ring, and a polycyclic ring such as an indene ring or an indole ring.

Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably $-R^a$ (that is, a hydrocarbon group).

Furthermore, it is preferable that $R^{16}$ be linked to $R^{12}$ bonded to the carbon atom to which $A_1^+$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably $-R^a$ (that is, a hydrocarbon group).

Furthermore, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula 1-1 be the same group. Furthermore, $R^{15}$ and $R^{17}$ are preferably $-R^a$ (that is, a hydrocarbon group), more preferably an alkyl group, and even more preferably a substituted alkyl group.

From the viewpoint of improving water solubility, $R^{15}$ and $R^{17}$ in the compound represented by Formula 1-1 are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}-R^{W1} \qquad (a1)$$

$$-R^{W2}-CO_2M \qquad (a2)$$

$$-R^{W3}-PO_3M_2 \qquad (a3)$$

$$-R^{W4}-SO_3M \qquad (a4)$$

In Formula (a1) to Formula (a4), $R^{W0}$ represents an alkylene group having 2 to 6 carbon atoms, W represents a single bond or an oxygen atom, and $n_{W1}$ represents an integer of 1 to 45, $R^{W1}$ represents an alkyl group having 1 to 12 carbon atoms or $-C(=O)-R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, an isohexyl group, and the like. Among these, an ethylene group, a n-propylene group, an isopropylene group, or a n-butylene group is preferable, and a n-propylene group is particularly preferable.

$n_{W1}$ is preferably 1 to 10, more preferably 1 to 5, and particularly preferably 1 to 3.

Specific examples of the alkyl group represented by $R^{W1}$ include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group, a n-propyl group, an isopropyl group, a n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferable aspects of the alkyl group represented by $R^{W5}$ are the same as preferable aspects of the alkyl group represented by $R^{W1}$.

Specific examples of the group represented by Formula (a1) will be shown below. However, the present disclosure is not limited thereto. In the following structural formulas, Me represents a methyl group, Et represents an ethyl group, and * represents a binding site.

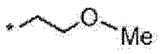 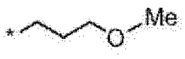 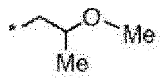 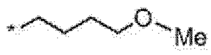 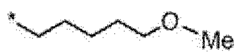

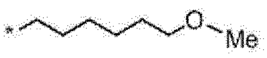 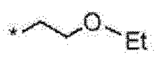 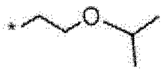 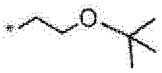

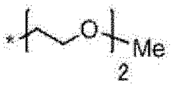 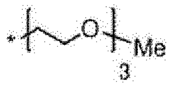 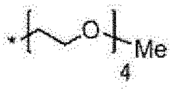 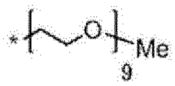 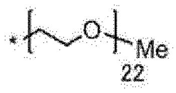

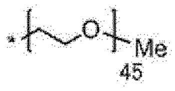 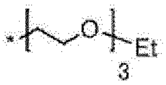 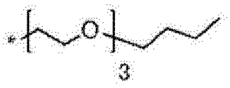 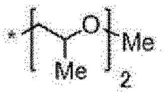 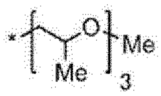

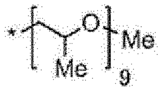 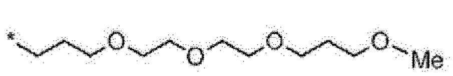

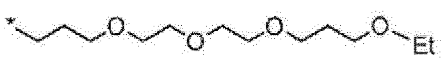 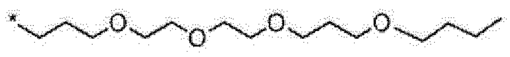

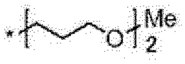 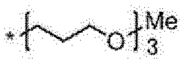 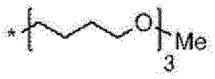

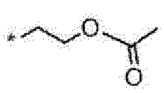 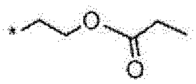 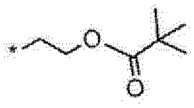 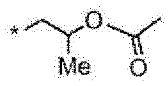 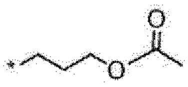

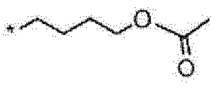 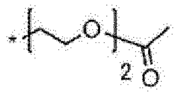 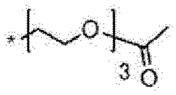 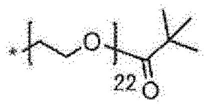

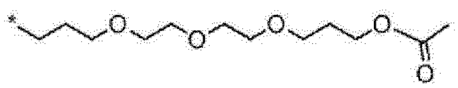

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, a n-dodecylene group, and the like. Among these, an ethylene group, a n-propylene group, an isopropylene group, or a n-butylene group is preferable, and an ethylene group or a n-propylene group is particularly preferable.

In Formula (a3), two Ms may be the same or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1), Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable.

$A_1$ and $A_2$ in Formula 1-1 are preferably the same atoms.

Za in Formula 1-1 represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine dye represented by Formula 1-1 has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, a sulfonium ion, and the like. Among these, a sodium ion, a potassium ion, an ammonium ion, a pyridinium ion, or a sulfonium ion is preferable, and a sodium ion, a potassium ion, or an ammonium ion is more preferable.

From the viewpoint of improving visibility of exposed portions, the decomposable compound is more preferably a compound represented by Formula 1-2 (that is, a cyanine dye).

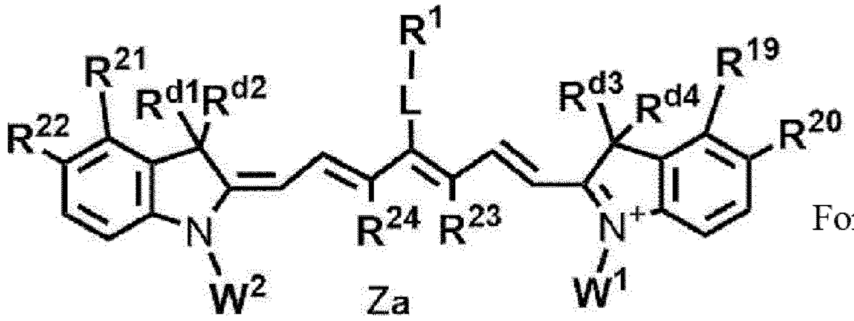

Formula 1-2

In Formula 1-2, $R^1$ represents a group represented by any of Formula 2 to Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent a hydrogen atom or $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$ in Formula 1-2 has the same definition as $R^1$ in Formula 1-1, and preferable aspects thereof are also the same.

In Formula 1-2, $R^{19}$ to $R^{22}$ preferably each independently represent a hydrogen atom, a halogen atom, $-R^a$, $-OR^b$, or -CN.

More specifically, $R^{19}$ and $R^{21}$ are preferably a hydrogen atom or $-R^a$.

Furthermore, $R^{20}$ and $R^{22}$ are preferably a hydrogen atom, $-R^a$, $-OR^b$, or -CN.

$-R^a$ represented by $R^{19}$ to $R^{22}$ is preferably an alkyl group or an alkenyl group.

In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring.

Examples of the ring formed of $R^{19}$ and $R^{20}$ or $R^{21}$ and $R^{22}$ linked to each other include a benzene ring, a cyclohexane ring, a cyclopentane ring, and the like.

$R^{23}$ and $R^{24}$ in Formula 1-2 are preferably linked to each other to form a monocyclic or polycyclic ring.

The ring formed of $R^{23}$ and $R^{24}$ linked to each other may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.

$R^{d1}$ to $R^{d4}$ in Formula 1-2 are preferably an unsubstituted alkyl group. Furthermore, all of $R^{d1}$ to $R^{d4}$ are preferably the same group.

Examples of the unsubstituted alkyl group include a methyl group, an ethyl group, and the like. Among these,

a methyl group is preferable.

From the viewpoint of improving water solubility of the compound represented by Formula 1-2, $W^1$ and $W^2$ in Formula 1-2 preferably each represent a substituted alkyl group.

Examples of the substituted alkyl group represented by $W^1$ and $W^2$ include a group represented by any of Formula (a1) to Formula (a4) in Formula 1-1, and preferable aspects thereof are also the same.

Za represents a counterion that neutralizes charge in the molecule.

In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion structure or a cation structure. For example, in a case where two among $R^{19}$ to $R^{22}$, $R^{23}$ and $R^{24}$, $R^{d1}$ to $R^{d4}$, $W^1$, $W^2$, and $R^1$-L have an anion structure, Za can be a countercation.

In a case where the compound represented by Formula 1-2 has such a structure that the overall charge of the compound is neutral except for Za, Za is unnecessary.

Examples of the case where Za is a counteranion are the same as such examples of Za in Formula 1-1, and preferable aspects thereof are also the same. Furthermore, examples of the case where Za is a countercation are the same as such examples of Za in Formula 1-1, and preferable aspects thereof are also the same.

From the viewpoint of improving visibility of exposed portions, the cyanine dye as a decomposable compound is even more preferably a compound represented by any of Formula 1-3 to Formula 1-7.

Particularly, from the viewpoint of improving visibility of exposed portions, the cyanine dye is preferably a compound represented by any of Formula 1-3, Formula 1-5, and Formula 1-6.

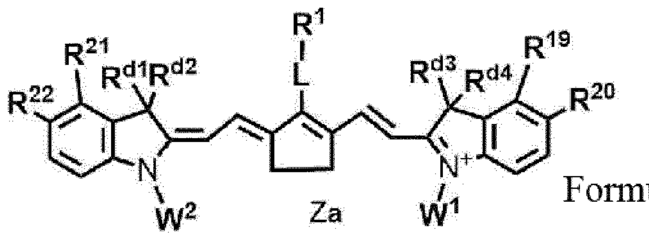

Formula 1-3

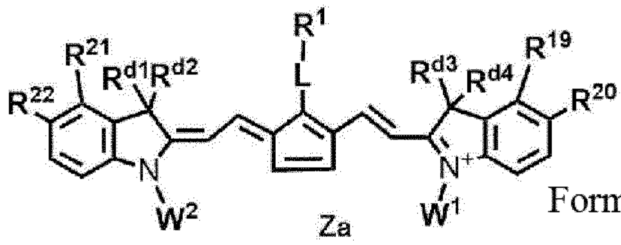

Formula 1-4

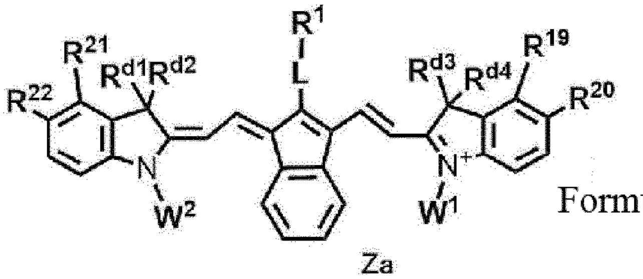

Formula 1-5

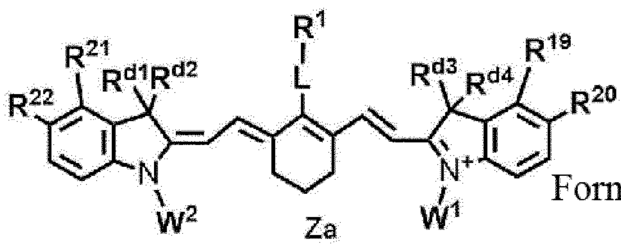

Formula 1-6

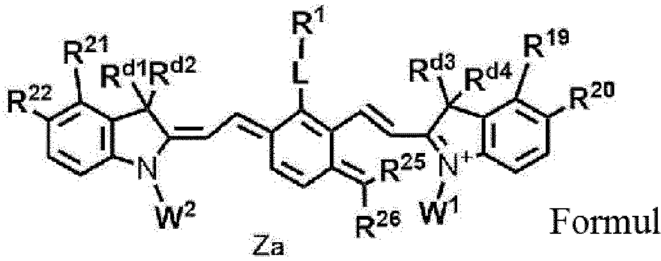

Formula 1-7

In Formula 1-3 to Formula 1-7, $R^1$ represents a group represented by any of Formula 2 to Formula 4, and $R^{19}$ to $R^{22}$ each independently represent a hydrogen atom, a halogen atom, $-R^a$, $-OR^b$, -CN, $-SR^c$, or $-NR^dR^e$, and $R^{25}$ and $R^{26}$ each independently represent a hydrogen atom, a halogen atom, or $-R^a$, and $R^a$ to $R^e$ each independently represent a hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, and $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to $R^{22}$, $R^{d1}$ to $R^{d4}$, $W^1$, $W^2$, and L in Formula 1-2, and preferable aspects thereof are also the same.

It is preferable that $R^{25}$ and $R^{26}$ in Formula 1-7 each independently represent a hydrogen atom or a methyl group.

Specific examples of the cyanine dye as a decomposable compound will be shown below. However, the present disclosure is not limited thereto.

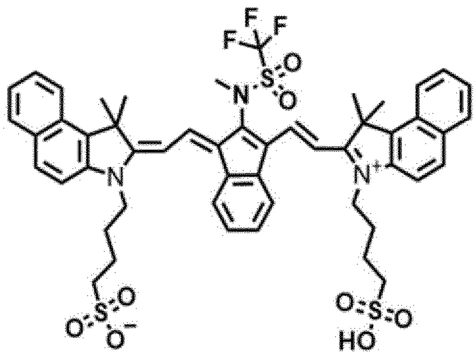

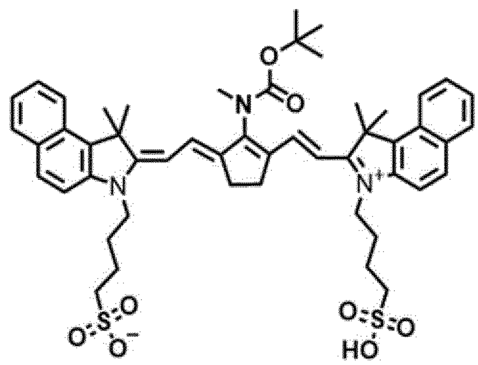

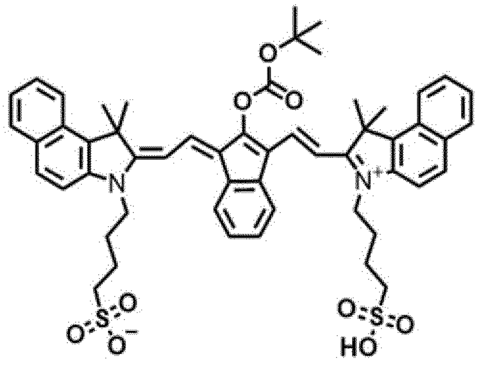

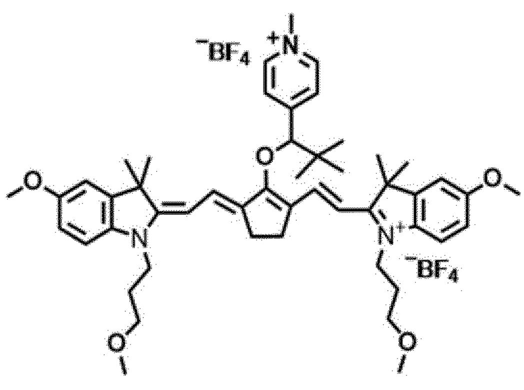

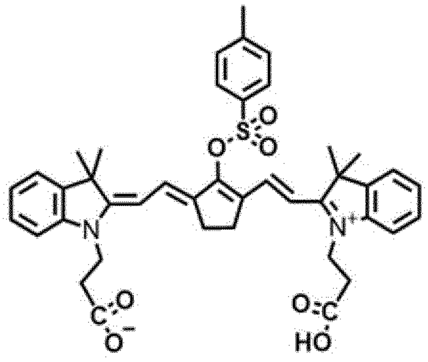

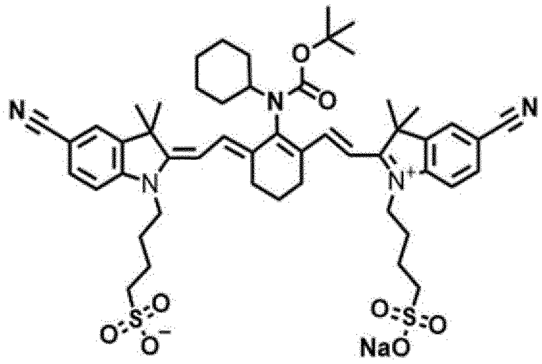

Furthermore, as the cyanine dye which is a decomposable compound, the infrared absorbing compound described in WO2019/219560A can be suitably used.

[Acid color former]

Next, an acid color former which is an example of a discoloring compound will be described.

The discoloring compound in the present disclosure may include an acid color former.

"Acid color former" in the present disclosure means a compound that is discolored by being heated in a state of accepting an electron accepting compound (specifically, a proton of an acid or the like generated from the acid generator that will be described later).

The acid color former is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

From the viewpoint of improving visibility of exposed portions, it is preferable to use a leuco colorant as the acid color former.

The leuco colorant is not particularly limited as long as it has a leuco structure. The leuco colorant preferably has a spiro structure, and more preferably has a spirolactone ring structure.

From the viewpoint of improving visibility of exposed portions, the leuco colorant preferably has a phthalide structure or a fluoran structure.

Furthermore, from the viewpoint of improving visibility of exposed portions, the leuco colorant having a phthalide structure or a fluoran structure is preferably a compound represented by any of Formula (Le-1) to Formula (Le-3), and more preferably a compound represented by Formula (Le-2).

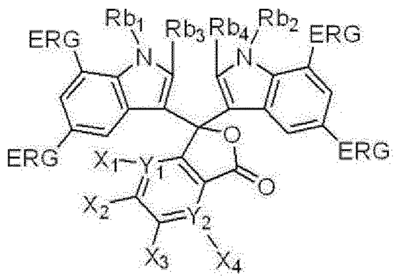

(Le-1)

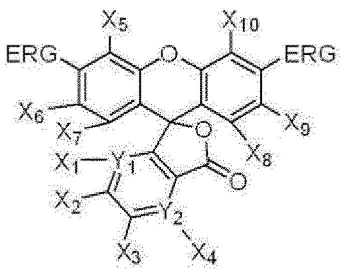

(Le-2)

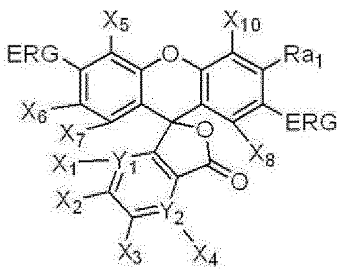

(Le-3)

In Formula (Le-1) to Formula (Le-3), ERG each independently represents an electron donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

As the electron donating groups represented by ERG in Formula (Le-1) to Formula (Le-3), from the viewpoint of color developability and visibility of exposed portions, an amino group, an alkylamino group, an arylamino group, a

dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group, an arylamino group, or a diarylamino group is even more preferable, and an arylamino group or a monoalkyl monoarylamino group is particularly preferable.

From the viewpoint of improving visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of improving visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, or an cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of improving visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of improving visibility of exposed portions, $Ra_1$ in Formula (Le-3) is preferably an alkyl group or an alkoxy group, more preferably an alkoxy group, and particularly preferably a methoxy group.

From the viewpoint of improving visibility of exposed portions, $Rb_1$ to $Rb_4$ in Formula (Le-1) preferably each independently represent a hydrogen atom or an alkyl group, more preferably each independently represent an alkyl group, and particularly preferably each independently represent a methyl group.

Furthermore, from the viewpoint of improving visibility of exposed portions, the leuco colorant having a phthalide structure or a fluoran structure is more preferably a compound represented by any of Formula (Le-4) to Formula (Le-6), and even more preferably a compound represented by Formula (Le-5).

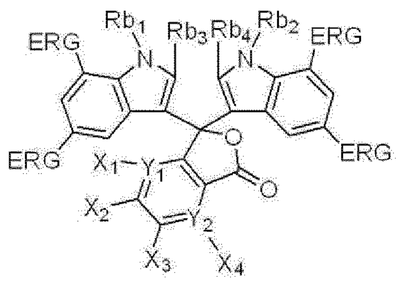

(Le-4)

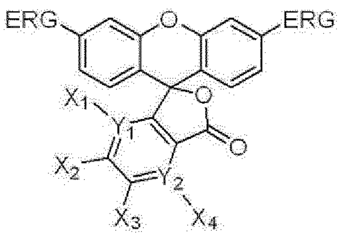

(Le-5)

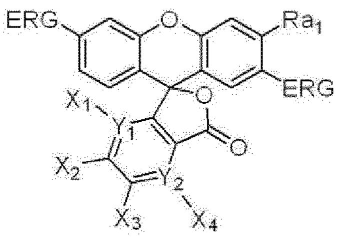

(Le-6)

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

ERG, $X_1$ to $X_4$, $Y_1$, $Y_2$, Rai, and $Rb_1$ to $Rb_4$ in Formula (Le-4) to Formula (Le-6) have the same definitions as ERG, $X_1$ to $X_4$, $Y_1$, $Y_2$, Rai, and $Rb_1$ to $Rb_4$ in Formula (Le-1) to Formula (Le-3) respectively, and preferable aspects thereof are also the same.

Furthermore, from the viewpoint of improving visibility of exposed portions, the leuco colorant having a phthalide structure or a fluoran structure is more preferably a compound represented by any of Formula (Le-7) to Formula (Le-9), and particularly preferably a compound represented by Formula (Le-8).

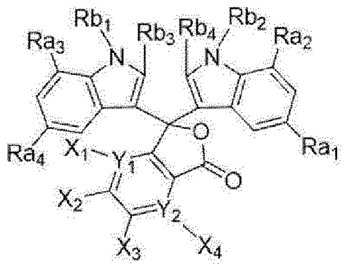

(Le - 7)

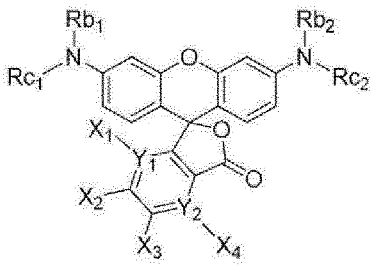

(Le - 8)

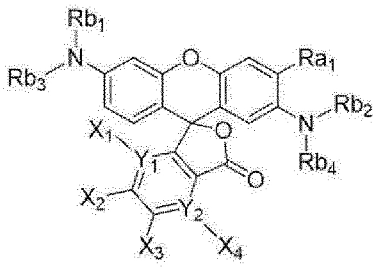

(Le - 9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferable aspects thereof are also the same.

From the viewpoint of improving visibility of exposed portions,$Ra_1$ to $Ra_4$ in Formula (Le-7) or Formula (Le-9) preferably each independently represent an alkyl group or an alkoxy group, more preferably each independently represent an alkoxy group, and particularly preferably each independently represent a methoxy group.

From the viewpoint of improving visibility of exposed portions, $Rb_1$ to $Rb_4$ in Formula (Le-7) to Formula (Le-9) preferably each independently represent a hydrogen atom, an alkyl group, or an aryl group substituted with an alkyl group or alkoxy group, more preferably each independently represent a hydrogen atom or an alkyl group, and particularly preferably each independently represent a hydrogen atom or a methyl group.

From the viewpoint of improving visibility of exposed portions, $Rc_1$ and $Rc_2$ in Formula (Le-8) preferably each independently represent a phenyl group or an alkylphenyl group, and more preferably each independently represent a phenyl group.

In Formula (Le-8), from the viewpoint of improving visibility of exposed portions, $X_1$ to $X_4$ preferably each represent a hydrogen atom, and $Y_1$ and $Y_2$ preferably each represent C.

From the viewpoint of improving visibility of exposed portions, $Rb_1$ and $Rb_2$ in Formula (Le-8) preferably each independently represent a hydrogen atom, an alkyl group, or an aryl group substituted with an alkyl group or an alkoxy group, more preferably each independently represent a hydrogen atom or an alkyl group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, a cyano group, and the like. These substituents may be further substituted with these substituents.

Specific examples of the leuco colorant having a phthalide structure or a fluoran structure that are suitably used include the following compounds (S-1) to (S-15).

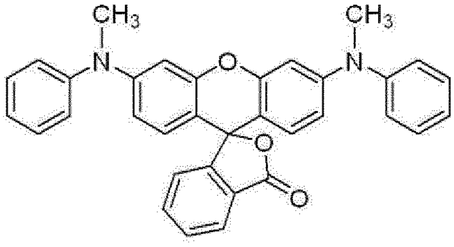

S - 1

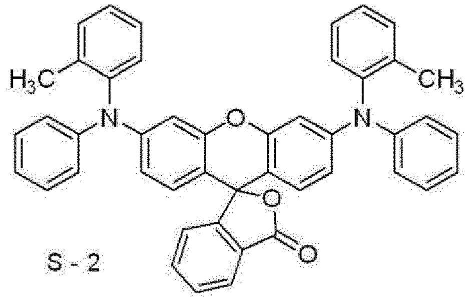

S - 2

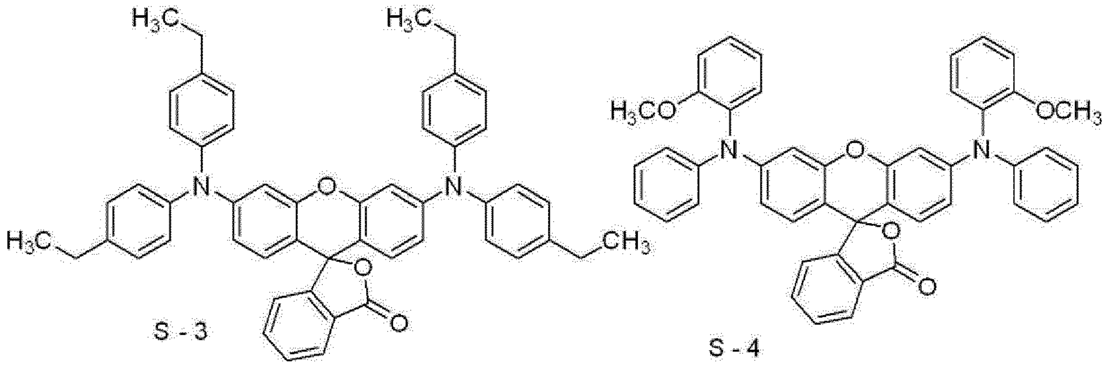

S - 3

S - 4

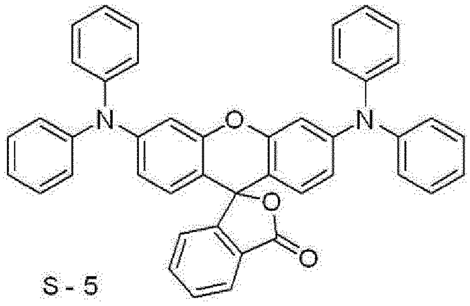

S - 5

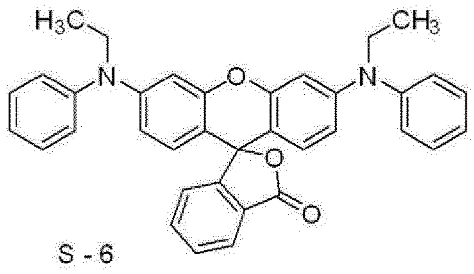

S - 6

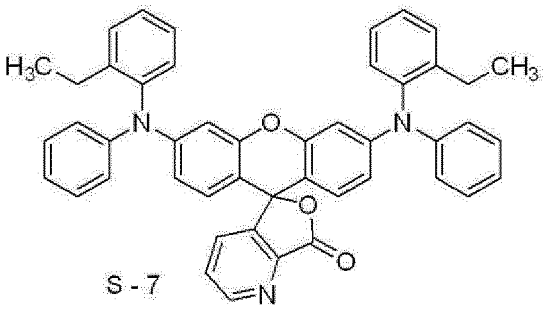

S - 7

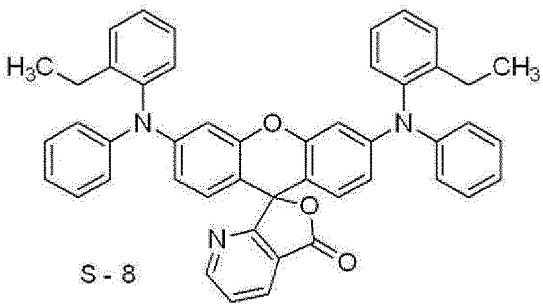

S - 8

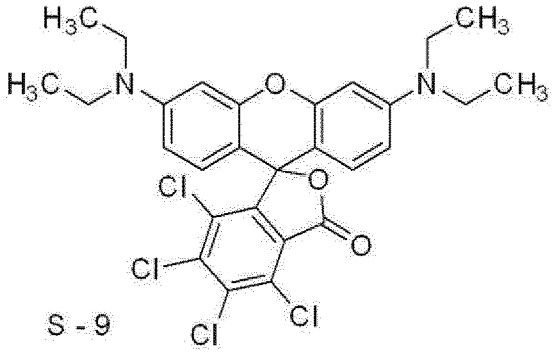

S - 9

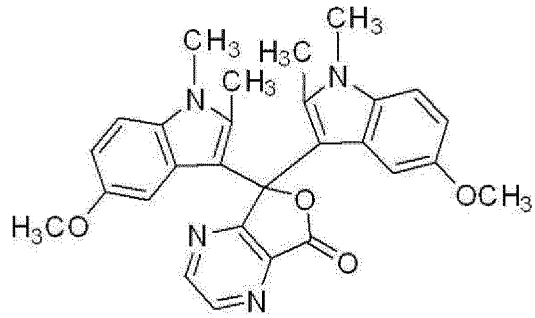

S - 10

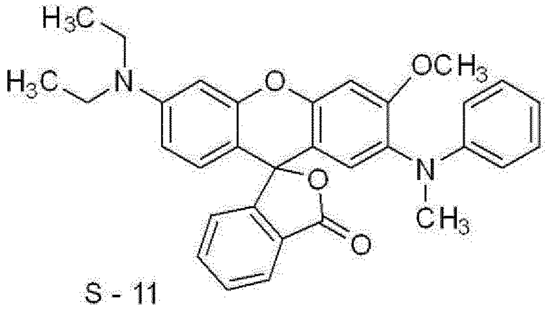

S - 11

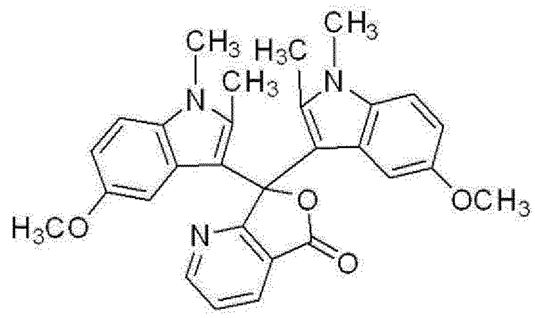

S - 12

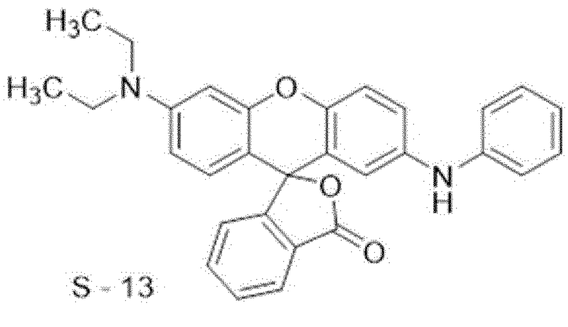

S - 13

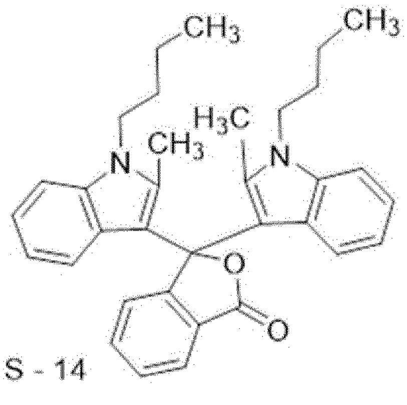

S - 14

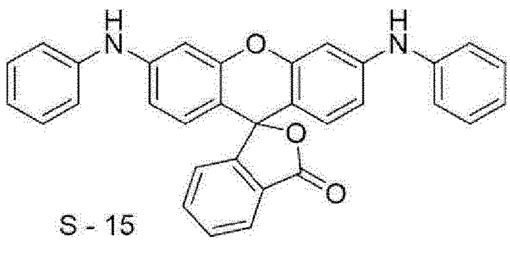

S - 15

As the acid color former, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like.

Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

As the leuco colorant, from the viewpoint of improving visibility of exposed portions, for example, the following compound can also be suitably used.

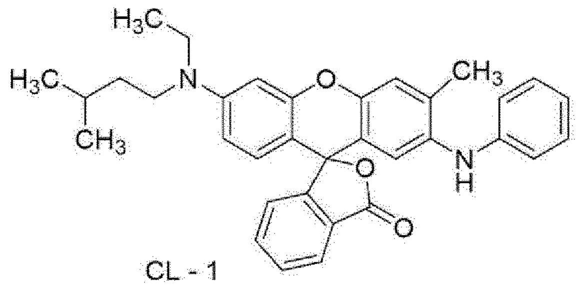

CL - 1

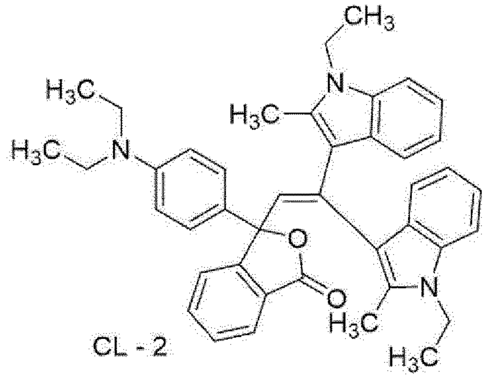

CL - 2

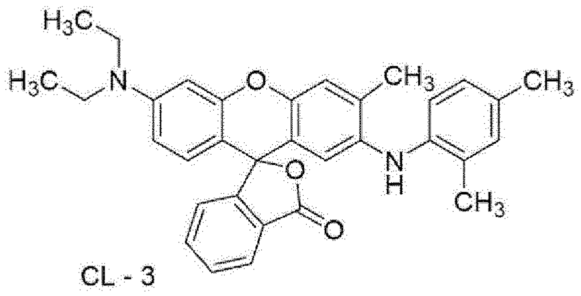

CL - 3

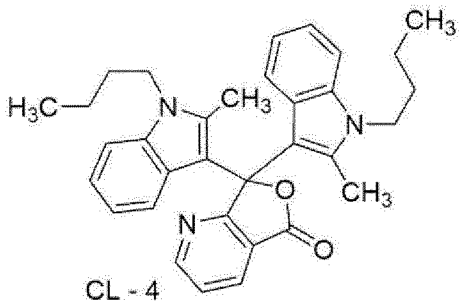

CL - 4

One kind of discoloring compound may be used alone, or two or more kinds of components may be combined and used as the discoloring compound.

As the discoloring compound, the decomposable compound described above and the acid generator described above may be used in combination.

The content of the discoloring compound in the overcoat layer with respect to the total mass of the overcoat layer is preferably 0.1% by mass to 50% by mass, more preferably 0.3% by mass to 30% by mass, and even more preferably 1% by mass to 20% by mass.

[Water-soluble polymer]

From the viewpoint of development removability (more preferably, on-press developability), it is preferable that the overcoat layer in the present disclosure contain a water-soluble polymer.

In the present disclosure, a water-soluble polymer refers to a polymer that dissolves 1 g or more in 100 g of pure water at 70°C and is not precipitated even though a solution of 1 g of the polymer in 100 g of pure water at 70°C is cooled to 25°C.

Examples of the water-soluble polymer used in the overcoat layer include polyvinyl alcohol, modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples of the modified polyvinyl alcohol include modified polyvinyl alcohols described in JP2005-250216A and JP2006-259137A.

Preferable examples of the water-soluble polymer include polyvinyl alcohol. Particularly, as the water-soluble polymer to be used, polyvinyl alcohol having a saponification degree of 50% or more is more preferable.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

Preferable examples of the water-soluble polymer also include polyvinylpyrrolidone.

As the water-soluble polymer, it is also preferable to use polyvinyl alcohol and polyvinylpyrrolidone in combination.

One kind of water-soluble polymer may be used alone, or two or more kinds of water-soluble polymers may be used in combination.

In a case where the overcoat layer contains a water-soluble polymer, the content of the water-soluble polymer with respect to the total mass of the overcoat layer is preferably 1% by mass to 99.5% by mass, more preferably 1% by mass to 99% by mass, even more preferably 3% by mass to 97% by mass, and particularly preferably 5% by mass to 95% by mass.

Furthermore, from the viewpoint of development removability (more preferably, from the viewpoint of on-press developability), the content of the water-soluble polymer with respect to the total mass of the overcoat layer is preferably 50% by mass to 99.5% by mass. From the viewpoint of development removability (more preferably, from the viewpoint of on-press developability) and from the viewpoint of improving visibility of exposed portions, the content of the water-soluble polymer with respect to the total mass of the overcoat layer is more preferably 50% by mass to 99% by mass.

[Other components]

The overcoat layer in the present disclosure may contain other components such as a hydrophobic polymer, an oil sensitizing agent, an acid generator, and an infrared absorber, in addition to the discoloring compound and the water-soluble polymer described above.

Hereinafter, those other components will be described.

(Hydrophobic polymer)

The overcoat layer in the present disclosure may contain a hydrophobic polymer.

The hydrophobic polymer refers to a polymer that dissolves less than 1 g in 100 g of pure water at 70°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these polymers, and the like.

One kind of hydrophobic polymer may be used alone, or two or more kinds of hydrophobic polymers may be used in combination.

In a case where the overcoat layer contains a hydrophobic polymer, the content of the hydrophobic polymer with respect to the total mass of the overcoat layer is preferably 1% by mass to 80% by mass, more preferably 5% by mass to 50% by mass, and even more preferably 15% by mass to 40% by mass.

(Oil sensitizing agent)

The overcoat layer in the present disclosure may contain an oil sensitizing agent.

The SP value of the oil sensitizing agent is preferably less than 18, more preferably 14 or more and less than 18, even more preferably 15 to 17, and particularly preferably 16 to 16.9.

Furthermore, the oil sensitizing agent may be a compound having a molecular weight (weight-average molecular weight in a case where the compound has molecular weight distribution) of 2,000 or more, or a compound having a molecular weight less than 2,000.

In the present disclosure, as the SP value (solubility parameter, (unit: $(MPa)^{1/2}$)), the Hansen solubility parameters are used.

The Hansen solubility parameters are obtained by dividing the solubility parameters introduced by Hildebrand into three components, a dispersion element $\delta d$, a polarity element $\delta p$, and a hydrogen bond element $\delta h$, and expressing the parameters in a three-dimensional space. In the present disclosure, the SP value is expressed as $\delta$ (unit: $(MPa)^{1/2}$), and a value calculated by the following equation is used.

$$\delta\ (MPa)^{1/2} = (\delta d^2 + \delta p^2 + \delta h^2)^{1/2}$$

The dispersion element $\delta d$, the polarity element $\delta p$, and the hydrogen bond element $\delta h$ of various substances have been found by Hansen and his successors, and are described in detail in the Polymer Handbook (fourth edition), VII-698 to 711.

In the present disclosure, the SP value of a resin or polymer is calculated from the molecular structure of the resin or polymer by the Hoy method described in Polymer Handbook (fourth edition).

Examples of the oil sensitizing agent include an onium salt compound, a nitrogen-containing low-molecular-weight compound, an ammonium compound such as an ammonium group-containing polymer, and the like.

From the viewpoint of receptivity, the oil sensitizing agent is preferably an onium salt compound.

Examples of the onium salt compound include a phosphonium compound, an ammonium compound, a sulfonium compound, and the like. As the onium salt compound, from the viewpoint described above, at least one kind of compound selected from the group consisting of a phosphonium compound and an ammonium compound is preferable.

The onium salt compound, which will be described later, in a development accelerator and electron-accepting polymerization initiator is a compound having an SP value more than 18, and is not included in the oil sensitizing agent.

Examples of the phosphonium compound include the phosphonium compounds described in JP2006-297907A and JP2007-50660A. Specific examples thereof include 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate, and the like.

Preferable examples of the ammonium compound include a nitrogen-containing low-molecular-weight compound, an ammonium group-containing polymer, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts.

Among these, quaternary ammonium salts and pyridinium salts are preferable.

Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 150,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacryl ate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)

As the oil sensitizing agent contained in the overcoat layer, from the viewpoint of improving ink receptivity, a phosphonium compound, a nitrogen-containing low-molecular-weight compound, an ammonium group-containing polymer, and the like are preferable.

One kind of oil sensitizing agent may be used alone, or two or more kinds of oil sensitizing agents may be used in combination.

In a case where the overcoat layer contains an oil sensitizing agent, the content of the oil sensitizing agent with respect to the total mass of the overcoat layer is preferably 0.5% by mass to 30% by mass, more preferably 1% by mass to 20% by mass, and even more preferably 1% by mass to 5% by mass.

(Acid generator)

In a case where an acid color former is used as a discoloring compound, it is preferable that the overcoat layer in the present disclosure contain an acid generator.
"Acid generator" in the present disclosure is a compound that generates an acid by light or heat. Specifically, the acid generator refers to a compound that generates an acid by being decomposed by exposure to infrared.
The acid to be generated is preferably a strong acid having a pKa of 2 or less, such as sulfonic acid or hydrochloric acid. The acid generated from the acid generator enables the acid color former to discolor.
Specifically, as the acid generator, from the viewpoint of sensitivity and stability, an onium salt compound is preferable.
Specific examples of onium salts suitable as the acid generator include the compounds described in paragraphs "0121" to "0124" of WO2016/047392A.
Particularly, as the acid generator, sulfonate, carboxylate, $BPh4^-$, $BF_4^-$, $PF_6^-$, $ClO_4^-$ of triarylsulfonium or diaryliodonium, and the like are preferable. Ph represents a phenyl group.
One kind of acid generator may be used alone, or two or more kinds of acid generators may be used in combination.
In a case where the overcoat layer contains an acid generator, the content of the acid generator with respect to the total mass of the overcoat layer is preferably 0.5% by mass to 30% by mass, more preferably 1% by mass to 20% by mass, and even more preferably 1% by mass to 10% by mass.
The overcoat layer in the present disclosure may contain known additives such as an inorganic lamellar compound and a surfactant, in addition to the components described above.
The overcoat layer is formed by coating by a known method and drying.
The coating amount of the overcoat layer (solid content) is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.
The film thickness of the overcoat layer is preferably 0.1 $\mu$m to 5.0 $\mu$m, and more preferably 0.3 $\mu$m to 4.0 $\mu$m.
The film thickness of the overcoat layer in the present disclosure/film thickness of the image-recording layer which will be described later is preferably 1.1/1 to 5.0/1, and more preferably 1.5/1 to 3.0/1.

<Image-recording layer>

The lithographic printing plate precursor according to the present disclosure has an image-recording layer between the aforementioned overcoat layer and a support.
The image-recording layer in the present disclosure contains a polymerization initiator, a polymerizable compound, and particles.
The image-recording layer in the present disclosure is preferably a negative tone image-recording layer, and more preferably a water-soluble or water-dispersible negative tone image-recording layer.
In the lithographic printing plate precursor of the present disclosure, from the viewpoint of on-press developability, a non-exposed portion of the image-recording layer is preferably removable by at least any of dampening water or printing ink.
Hereinafter, each of the components to be incorporated into the image-recording layer will be specifically described.

[Polymerization initiator]

The image-recording layer in the present disclosure contains a polymerization initiator.
The polymerization initiator is not particularly limited, and examples thereof include an electron-accepting polymerization initiator, an electron-donating polymerization initiator, and the like.
In the present disclosure, it is preferable that the image-recording layer contain an electron-accepting polymerization initiator and an electron-donating polymerization initiator as a polymerization initiator.

[Electron-accepting polymerization initiator]

It is preferable that the image-recording layer in the present disclosure contain an electron-accepting polymerization initiator as a polymerization initiator.
The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that can be dissociated by little energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Examples of the radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium salt compound.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H08-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties of the image-recording layer, an oxime ester compound and an onium salt compound are preferable. Particularly, from the viewpoint of UV printing durability, an iodonium salt compound, a sulfonium salt compound, or an azinium salt compound is preferable, an iodonium salt compound or a sulfonium salt compound is more preferable, and an iodonium salt compound is even more preferable.

Specific examples of these compounds will be shown below, but the present disclosure is not limited thereto.

As the iodonium salt compound, for example, a diaryliodonium salt compound is preferable. Particularly, a diphenyl iodonium salt compound substituted with an electron donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below, but the present disclosure is not limited thereto. In the following specific examples, Ph represents a phenyl group, Me represents a methyl group, and Et represents an ethyl group.

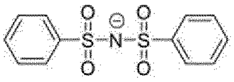
I-1

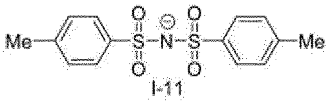
I-11

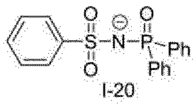
I-20

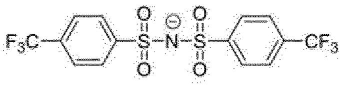
I-2

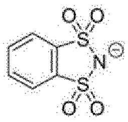
I-12

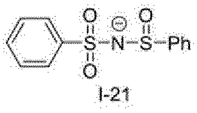
I-21

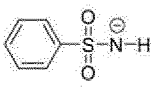
I-22

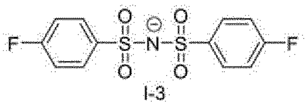
I-3

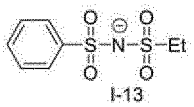
I-13

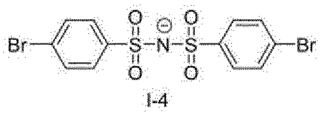
I-4

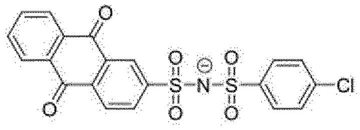
I-23

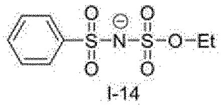
I-14

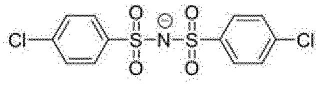
I-5

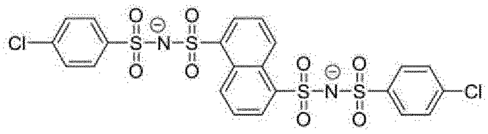
I-24

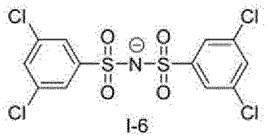
I-6

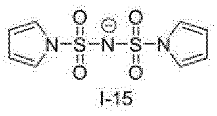
I-15

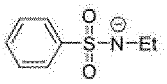
I-16

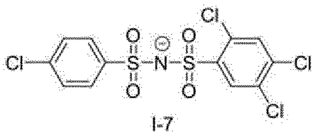
I-7

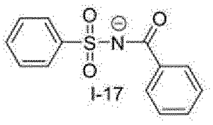
I-17

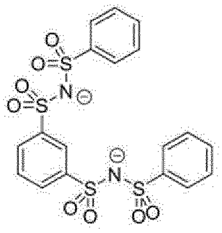
I-25

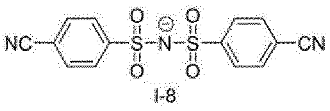
I-8

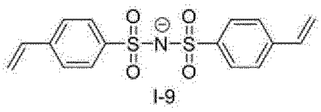
I-9

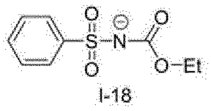
I-18

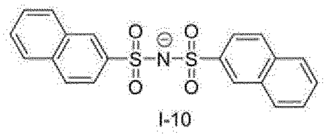
I-10

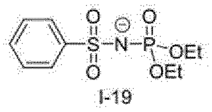
I-19

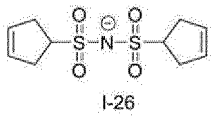
I-26

From the viewpoint of temporal color developability after exposure, developability, and UV printing durability of the lithographic printing plate to be obtained, as the electron-accepting polymerization initiator, a compound represented by Formula (I) can be suitably used.

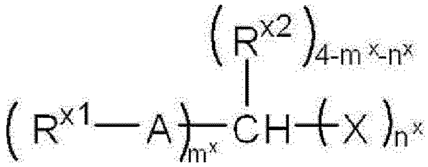
(I)

In Formula, X represents a halogen atom. Specifically, examples thereof include a fluorine atom, a chlorine

atom, a bromine atom, and an iodine atom. Among these, a chlorine atom or a bromine atom is preferable because these have excellent sensitivity, and a bromine atom is particularly preferable.

A represents a divalent linking group selected from the group consisting of -CO-, -SO-, $-SO_2-$, -PO-, and $-PO_2-$. Among these, -CO-, -SO-, and $-SO_2-$ are more preferable, and -CO- and $-SO_2-$ are particularly preferable. $R^{X1}$ and $R^{X2}$ each independently represent a hydrogen atom or a monovalent hydrocarbon group having 1 to 20 carbon atoms.

Examples of the hydrocarbon constituting the hydrocarbon group include the hydrocarbons described in paragraphs "0013" and "0014" of JP2002-162741A, and the like. Specifically, examples of the hydrocarbons include aliphatic hydrocarbons having 1 to 30 carbon atoms such as methane, ethane, propane, butane, hexane, nonane, decane, octadecane, cyclopentane, cyclohexane, adamantane, norbornane, decahydronaphthalene, tricyclo[5.2.1.0$^{2,6}$]decane, ethylene, propylene, 1-butene, 1-hexene, 1-heptadecene, 2-butene, 2-hexene, 4-nonene, 7-tetradecene, butadiene, piperylene, 1,9-decadien, cyclopentene, cyclohexene, cyclooctene, 1,4-cyclohexadiene, 1,5-cyclooctadiene, 1,5,9-cyclododecatriene, norbornylene, octahydronaphthalene, bicyclo[2.2.1]hepta-2,5-diene, acetylene, 1-propyne, and 2-hexyne; and aromatic hydrocarbons such as benzene, naphthalene, anthracene, indene, and fluorene.

One or more carbon atoms constituting the above hydrocarbon group may be substituted with a hetero- atom selected from an oxygen atom, a nitrogen atom, and a sulfur atom.

Except for hydrogen, for example, a group of monovalent non-metal atoms can be used as substituents. Examples thereof include a halogen atom (-F, -Br, -Cl, or -I), a hydroxyl group, an alkoxy group, an aryloxy group, a mercapto group, an alkylthio group, an arylthio group, an alkyldithio group, an aryldithio group, an amino group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, a N,N-dialkylcarbamoyloxy group, a N,N-diarylcarbamoyloxy group, a N-alkyl-N-arylcarbamoyloxy group, an alkyl sulfoxy group, an aryl sulfoxy group, an acylthio group, an acylamino group, a N-alkylacylamino group, a N-arylacylamino group, a ureido group, a N'-alkylureido group, a N',N'-dialkylureido group, a N'-arylureido group, a N',N'-diarylureido group, a N'-alkyl-N'-arylureido group, a N-alkylureido group, a N-arylureido group, a N'-alkyl-N-alkylureido group, a N'-alkyl-N-arylureido group, a N',N'-dialkyl-N-alkylureido group, a N',N'-dialkyl-N-arylureido group, a N'-aryl-N-alkylureido group, a N'-aryl-N-arylureido group, a N',N'-diaryl-N-alkylureido group, a N',N'-diaryl-N-arylureido group, a N'-alkyl-N'-aryl-N-alkylureido group, a N'-alkyl-N'-aryl-N-arylureido group, an alkoxycarbonylamino group, an aryloxycarbonylamino group, a N-alkyl-N-alkoxycarbonylamino group, a N-alkyl-N-aryloxycarbonylamino group, a N-aryl-N-alkoxycarbonylamino group, a N-aryl-N-aryloxycarbonylamino group, a formyl group, an acyl group, a carboxyl group and a conjugated base group thereof, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, an alkylsulfinyl group, an arylsulfinyl group, an alkylsulfonyl group, an arylsulfonyl group, a sulfo group ($-SO_3H$) and a conjugated base group thereof, an alkoxysulfonyl group, an aryloxysulfonyl group, a sulfinamoyl group, a N-alkylsulfinamoyl group, a N,N-dialkylsulfinamoyl group, a N-arylsulfinamoyl group, a N,N-diarylsulfinamoyl group, a N-alkyl-N-arylsulfinamoyl group, a sulfamoyl group, a N-alkylsulfamoyl group, a N,N-dialkylsulfamoyl group, a N-arylsulfamoyl group, a N,N-diarylsulfamoyl group, a N-alkyl-N-arylsulfamoyl group, a N-acylsulfamoyl group and a conjugated base group thereof, a N-alkylsulfonyl sulfamoyl group ($-SO_2NHSO_2$(alkyl)) and a conjugated base group thereof, a N-arylsulfonylsulfamoyl group ($-SO_2NHSO_2$(aryl)) and a conjugated base group thereof, a N-alkylsulfonylcarbamoyl group ($-CONHSO_2$(alkyl)) and a conjugated base group thereof, a N-arylsulfonylcarbamoyl group ($-CONHSO_2$(aryl)) and a conjugated base group thereof, an alkoxysilyl group ($-Si(Oalkyl)_3$), an aryloxysilyl group ($-Si(Oaryl)_3$), a hydroxysilyl group ($-Si(OH)_3$) and a conjugated base group thereof, a phosphono group ($-PO_3H_2$) and a conjugated base group thereof, a dialkylphosphono group ($-PO_3(alkyl)_2$), a diarylphosphono group ($-PO_3(aryl)_2$), an alkylarylphosphono group ($-PO_3$(alkyl)(aryl)), a monoalkylphosphono group ($-PO_3H$(alkyl)) and a conjugated base group thereof, a monoarylphosphono group ($-PO_3H$(aryl)) and a conjugated base group thereof, a phosphonooxy group ($-OPO_3H_2$) and a conjugated base group thereof, a dialkylphosphonooxy group ($-OPO_3(alkyl)_2$), a diarylphosphonooxy group ($-OPO_3(aryl)_2$), an alkylarylphosphonooxy group ($-OPO_3$(alkyl)(aryl)), a monoalkylphosphonooxy group ($-OPO_3H$(alkyl)) and a conjugated base group thereof, a monoarylphosphonooxy group ($-OPO_3H$(aryl)) and a conjugated base group thereof, a cyano group, a nitro group, a dialkylboryl group ($-B(alkyl)_2$), a diarylboryl group ($-B(aryl)_2$), an alkylarylboryl group (-B(alkyl)(aryl)), a dihydroxyboryl group ($-B(OH)_2$) and a conjugated base group thereof, an alkylhydroxyboryl group (-B(alkyl)(OH)) and a conjugated base group thereof, an arylhydroxyboryl group (-B(aryl)(OH)) and a conjugated base group thereof, an aryl group, an alkyl group, an alkenyl group, and an alkynyl group.

If possible, these substituents may be bonded to each other or bonded to the substituted hydrocarbon group so as to form a ring, or may be further substituted with substituents.

As substituents, for example, a halogen atom, an alkoxy group, an aryloxy group, an alkyl group, an alkenyl group, an alkynyl group, and an aryl group are preferable.

$m^x$ and $n^x$ each represent an integer of 1 to 3. However, $m^x + n^x = 2$ to 4. In view of sensitivity, it is preferable that $m^x = 1$ and $n^x = 3$, or $m^x = 2$ and $n^x = 2$. In a case where each of $m^x$ and $n^x$ is 2 or more, (R1-A) and X may be different from each other. Furthermore, in a case where $m^x = 1$ and $n^x = 1$, $R^{x2}$'s may be different from each other.

Among the compounds represented by Formula (I), in view of excellent visibility, compounds represented by Formulas (II) and (III) are preferable, and a compound represented by Formula (II) is particularly preferable.

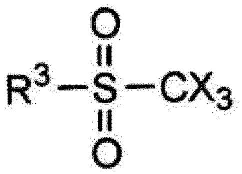
(II)

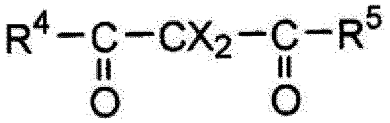
(III)

In Formulas (II) and (III), X represents a halogen atom, and $R^3$, $R^4$, and $R^5$ each independently represent a monovalent hydrocarbon group having 1 to 20 carbon atoms.

In Formula (II), X preferably represents a halogen atom, and $R^3$ preferably represents an aryl group.

X in Formulas (II) and (III) has the same definition as X in Formula (I), and the preferable aspects thereof are also the same.

$R^3$, $R^4$, and $R^5$ in Formulas (II) and (III) preferably each independently represent an aryl group. Particularly, from the viewpoint of excellent balance between sensitivity and storage stability, $R^3$, $R^4$, and $R^5$ preferably each represent an aryl group substituted with an amide group.

Among the compounds represented by Formulas (II) and (III), a compound represented by Formula (IV) is particularly preferable.

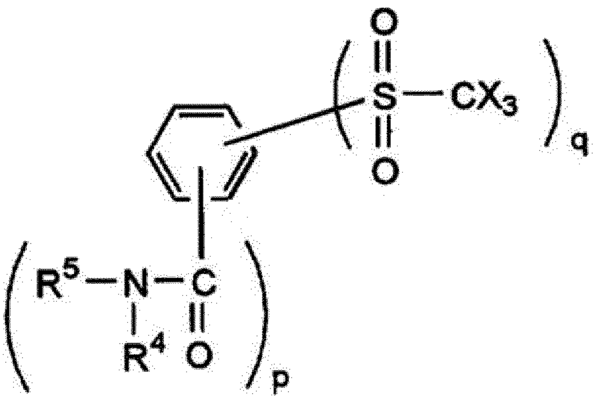
(IV)

In Formula (IV), $R^4$ and $R^5$ each independently represent a hydrogen atom or a monovalent hydrocarbon group having 1 to 20 carbon atoms. p and q each independently represent an integer of 1 to 5. Here, p + q = 2 to 6.

Specific examples of the electron-accepting polymerization initiator represented by Formula (I) include compounds represented by the following formulas. However, the present disclosure is not limited thereto.

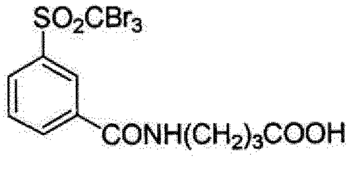
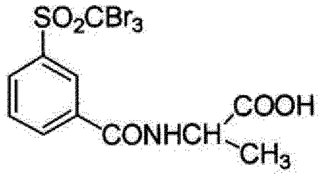
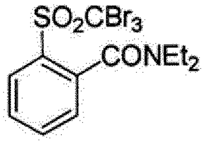

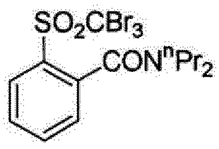
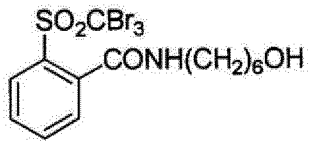
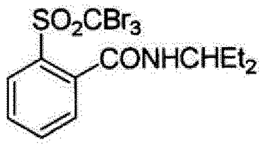

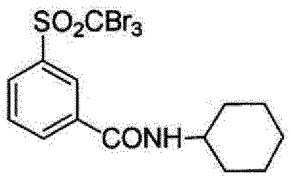 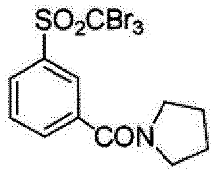 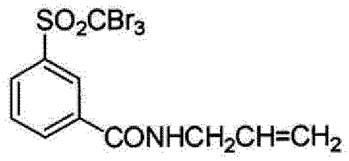

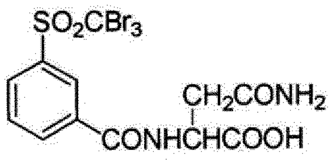 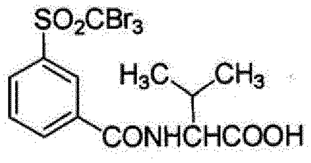 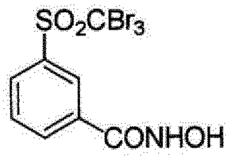

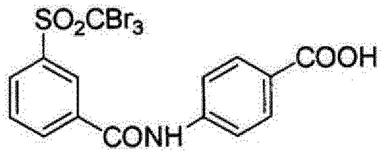 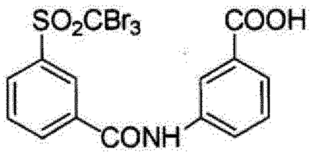 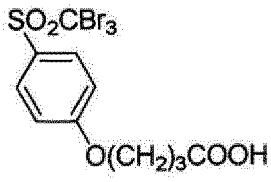

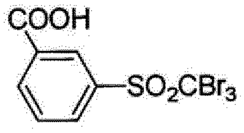 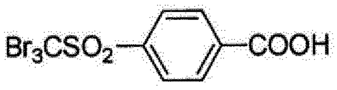 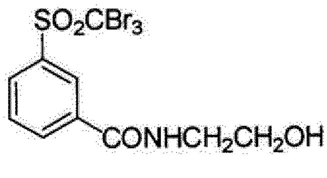

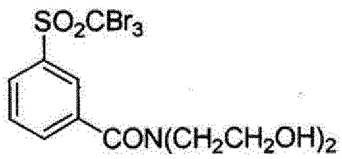 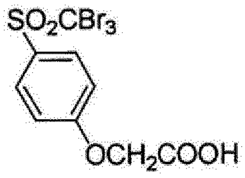 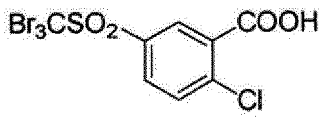

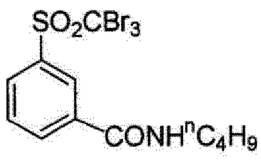 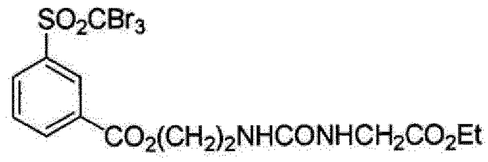

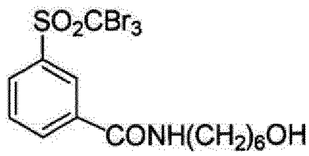 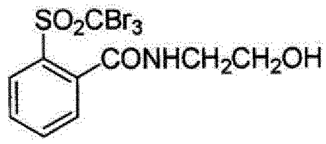

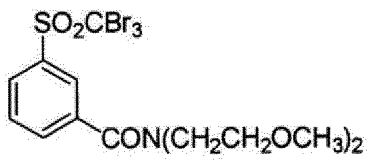 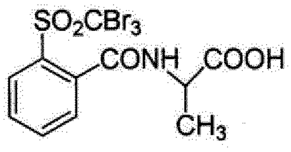

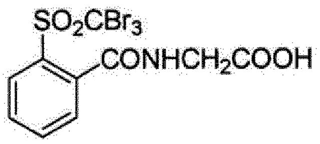
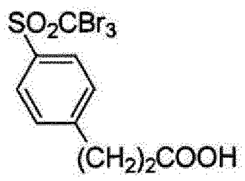
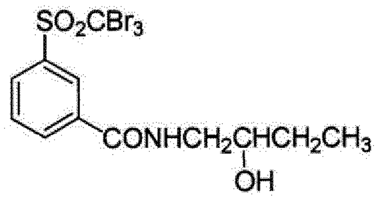

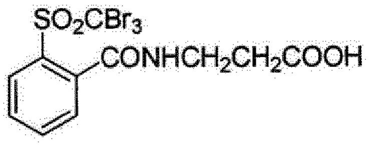
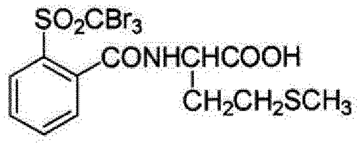

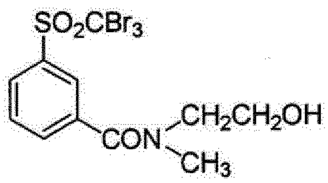
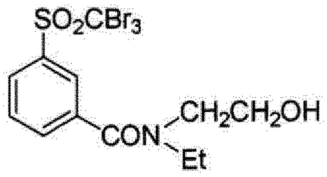
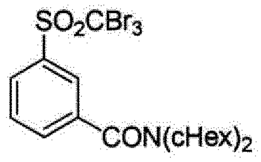

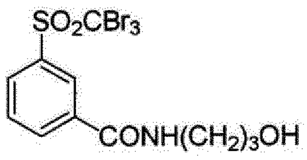
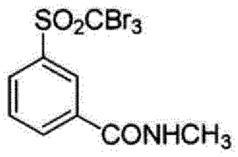
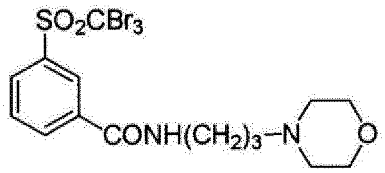

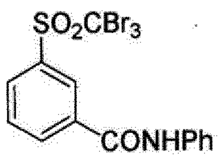
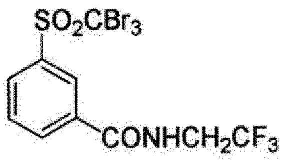
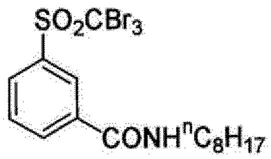

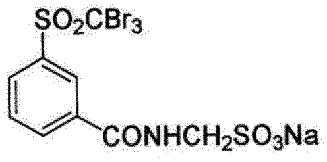
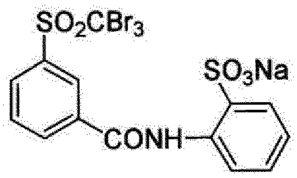
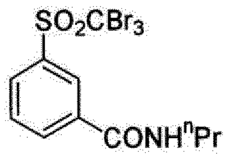

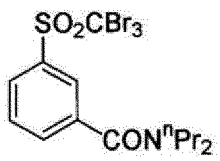
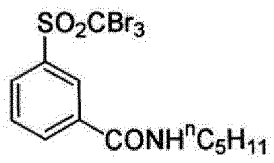
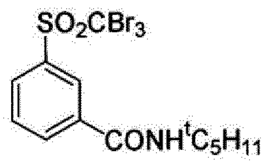

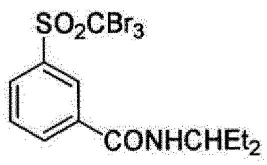
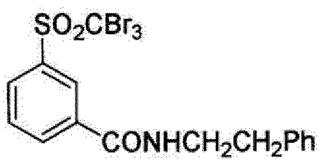
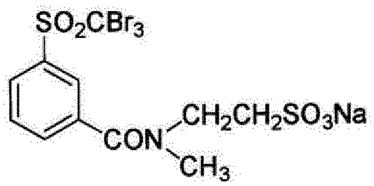

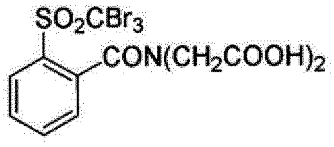
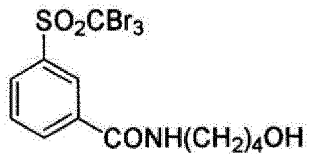

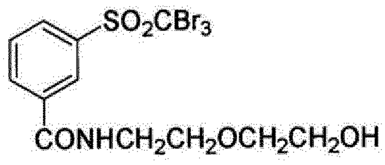
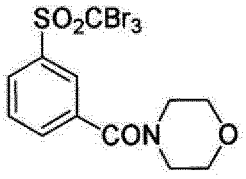
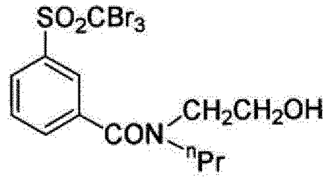

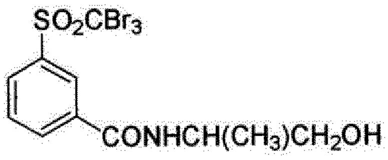
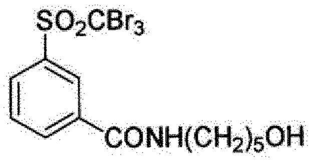

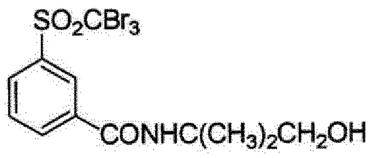
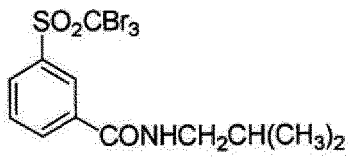

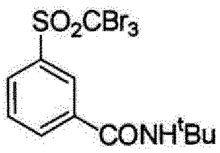
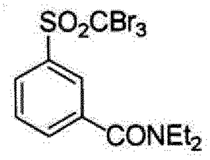
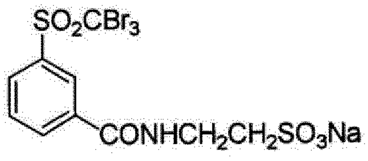

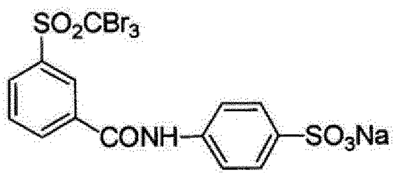
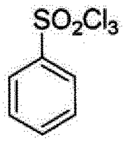
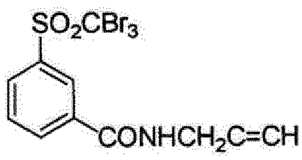

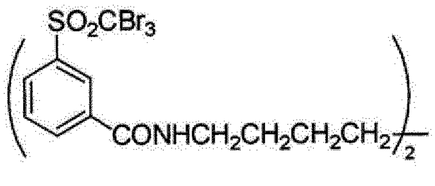
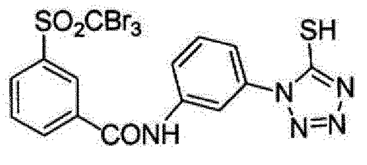

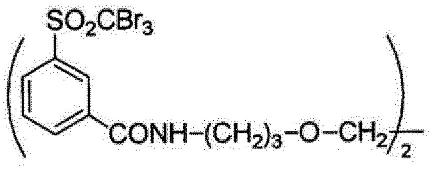
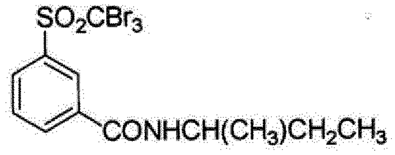

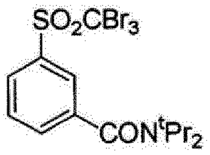
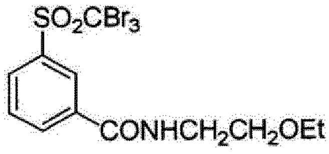
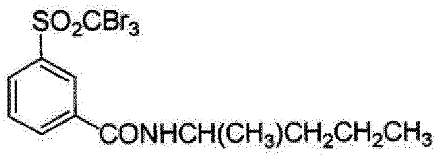

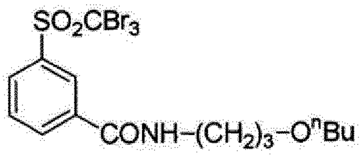
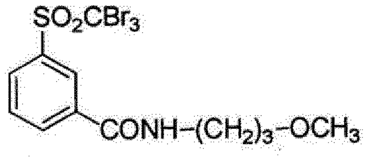

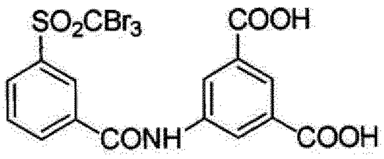
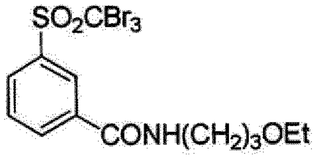

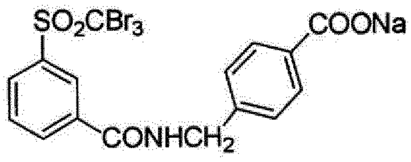
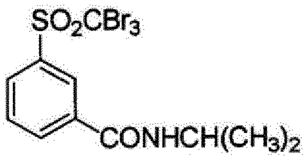

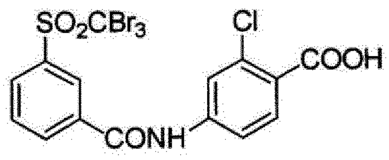
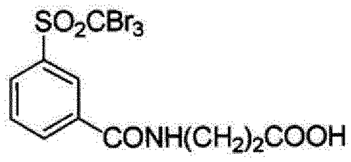

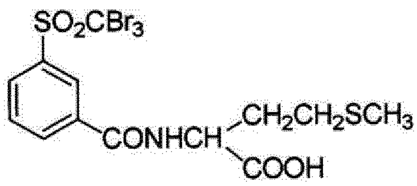
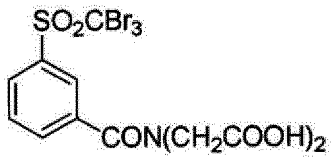

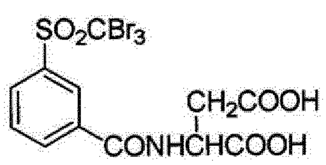
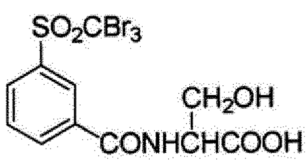
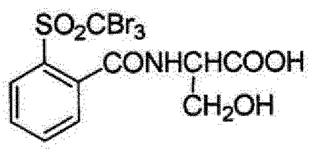

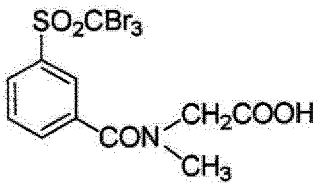
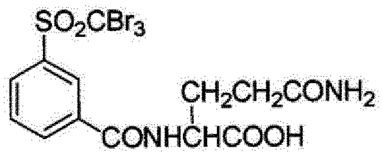
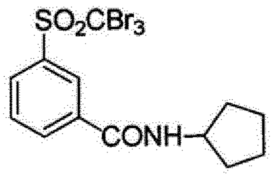

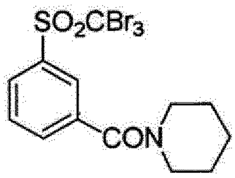

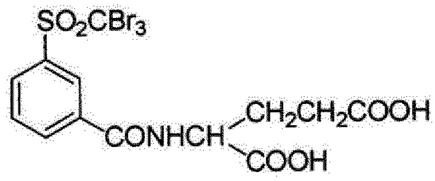

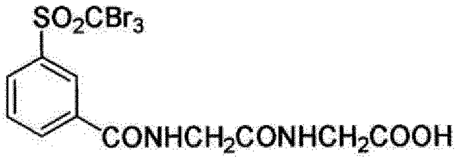

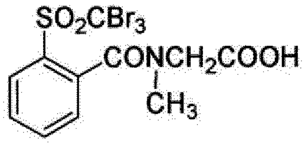

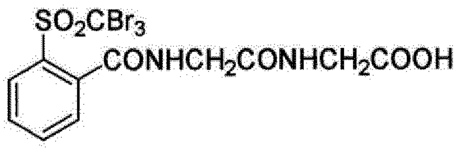

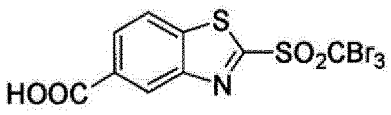

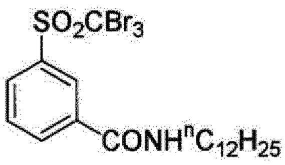

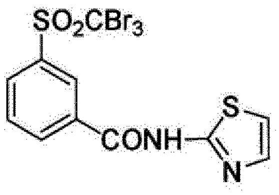

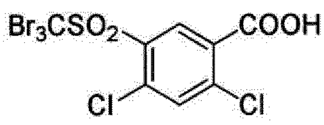

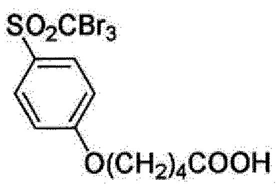

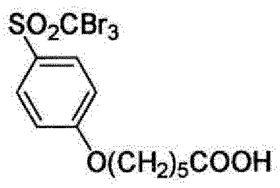

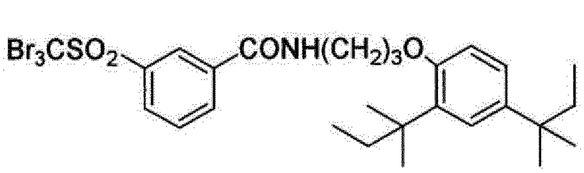

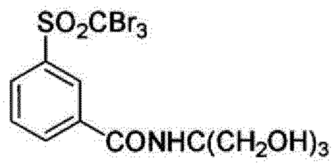

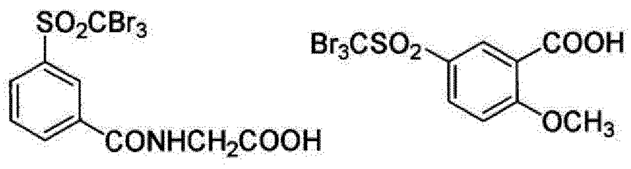

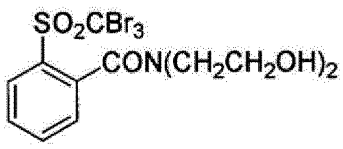

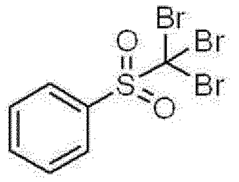

(IS-1)

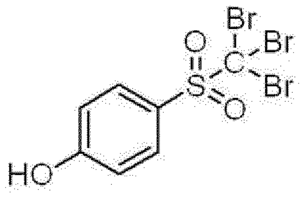

(IS-2)

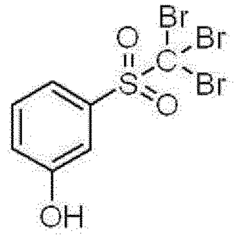

(IS-3)

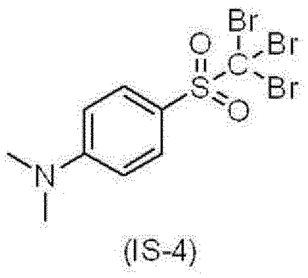

(IS-4)

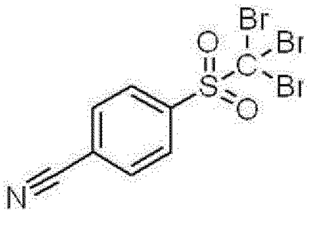

(IS-5)

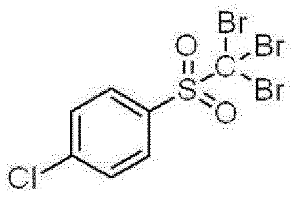

(IS-6)

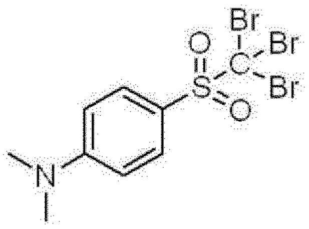

(IS-7)

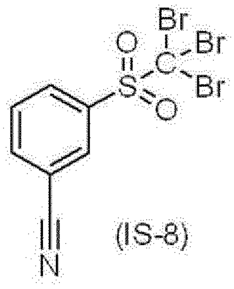

(IS-8)

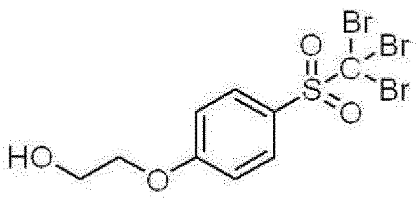

(IS-9)

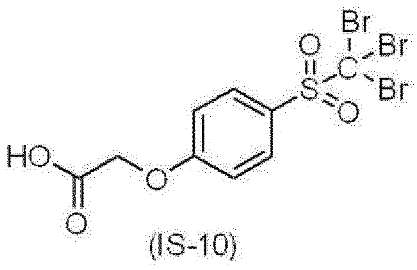

(IS-10)

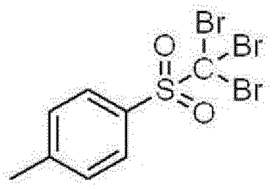

(IS-11)

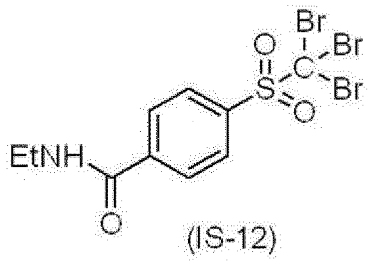

(IS-12)

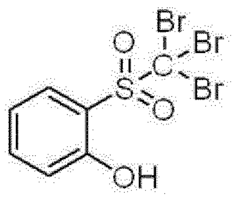

(IS-13)

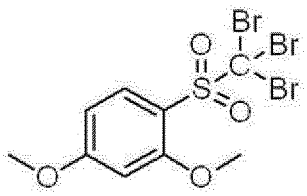

(IS-14)

From the viewpoint of chemical resistance and UV printing durability of the lithographic printing plate to be obtained, the lowest unoccupied molecular orbital (LUMO) of the electron-accepting polymerization initiator is preferably -3.00 eV or less, and more preferably -3.02 eV or less.

The lower limit of LUMO is preferably -3.80 eV or more, and more preferably -3.60 eV or more.

One kind of electron-accepting polymerization initiator may be used alone, or two or more kinds of electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

[Electron-donating polymerization initiator]

From the viewpoint of making a contribution to improvement of chemical resistance and UV printing durability of the lithographic printing plate, it is preferable that the image-recording layer in the present disclosure contain an electron-donating polymerization initiator as a polymerization initiator.

Examples of the electron-donating polymerization initiator include the following five kinds of initiators.

(i) Alkyl or arylate complex: considered to generate active radicals by oxidative cleavage of carbon-hetero bond. Specific examples thereof include a borate salt compound and the like.
(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group.), N-phenyl iminodiacetic acids (which may have a substituent in a phenyl group), and the like.
(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acids (which may have a substituent on a phenyl group) and the like.
(iv) Tin-containing compound: compound obtained by substituting nitrogen atoms of the aforementioned amino acetate compound with tin atoms and capable of generating active radicals by the same action as that of the amino acetate compound.
(v) Sulfinates: capable of generating active radicals by oxidation. Specific examples thereof include sodium aryl sulfinate and the like.

It is preferable that the image-recording layer contain the borate salt compound among the above electron-donating polymerization initiators. As the borate salt compound, a tetraaryl borate salt compound or a monoalkyltriaryl borate salt compound is preferable. From the viewpoint of compound stability, a tetraaryl borate salt compound is more preferable, and a tetraphenyl borate salt compound is particularly preferable.

A countercation that the borate salt compound has is not particularly limited, but is preferably an alkali metal ion or a tetraalkyl ammonium ion and more preferably a sodium ion, a potassium ion, or a tetrabutylammonium ion.

Specifically, preferable examples of the borate salt compound include sodium tetraphenyl borate.

From the viewpoint of chemical resistance and UV printing durability of the lithographic printing plate, the highest occupied molecular orbital (HOMO) of the electron-donating polymerization initiator used in the present disclosure is preferably -6.00 eV or more, more preferably -5.95 eV or more, and even more preferably -5.93 eV or more.

The upper limit of HOMO is preferably -5.00 eV or less, and more preferably -5.40 eV or less.

In the present disclosure, the highest occupied molecular orbital (HOMO) and the lowest unoccupied molecular orbital (LUMO) are calculated by the following methods.

First, the counteranion in the compound as a subject of calculation is ignored.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO in the present disclosure.

$$\text{Escaled} = 0.823168 \times 27.2114 \times \text{Ebare} - 1.07634$$

27.2114 is a simply a coefficient for converting hartree into eV, and 0.823168 and -1.07634 are adjustment coefficients. These are determined such that the calculated values of HOMO and LUMO of the compound as a calculation object match the measured values.

Specifically, as the electron-donating polymerization initiator, for example, compounds B-1 to B-8 and other compounds shown below are preferable. It goes without saying that the present disclosure is not limited thereto. In the following chemical formulas, Bu represents a n-butyl group, and Z represents a countercation.

Examples of the countercation represented by $Z^+$ include $Na^+$, $K^+$, $N^+(Bu)_4$, and the like. Bu in $N^+(Bu)_4$ represents a n-butyl group.

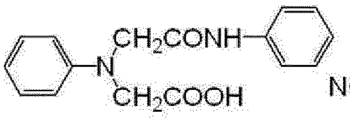

B-1

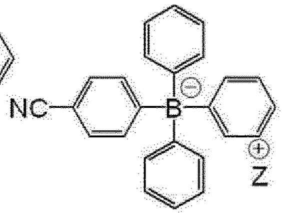

B-2

HOMO=-6.052eV

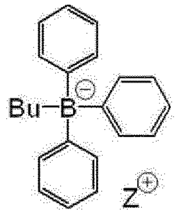

B-3

HOMO=-5.772eV

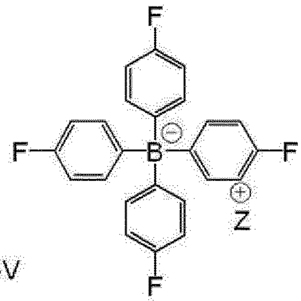

B-4

HOMO=-5.957eV

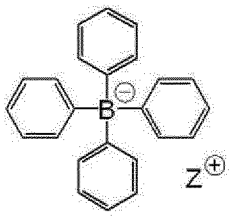

B-5

HOMO=-5.905eV

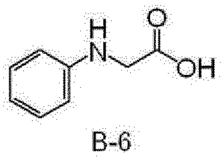

B-6

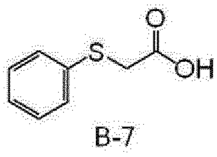

B-7

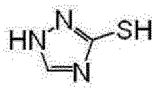

B-8

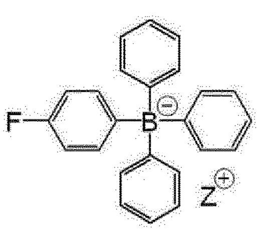

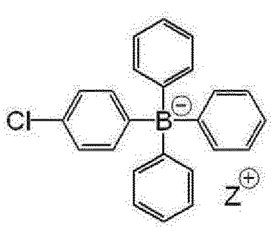

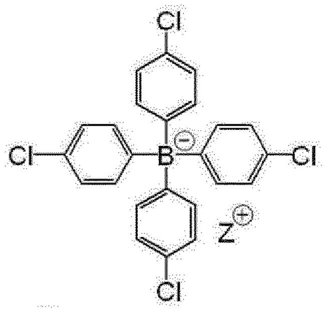

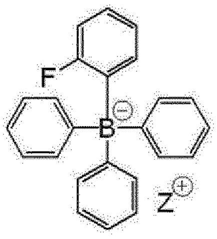

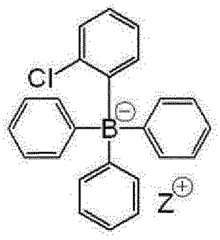

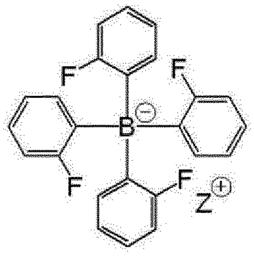

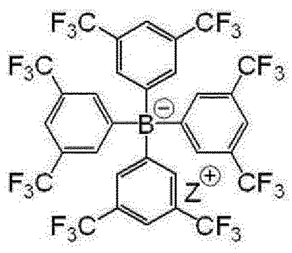

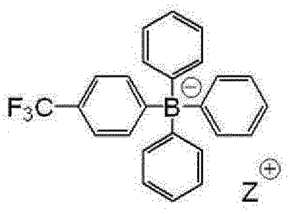

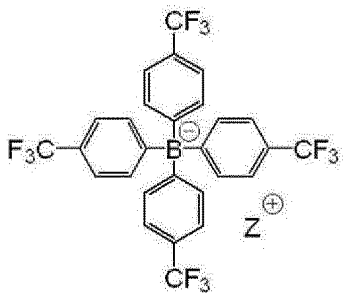

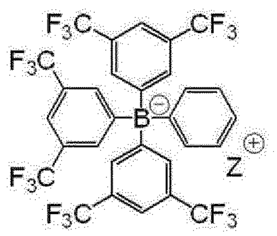

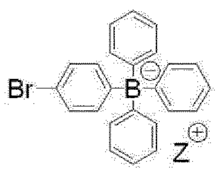
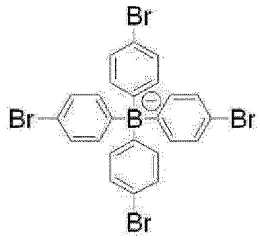
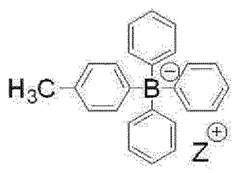
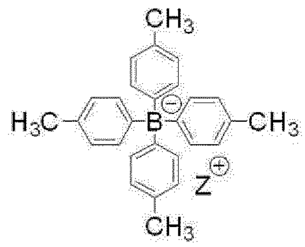

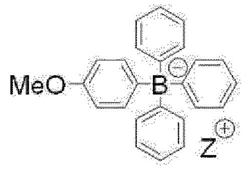
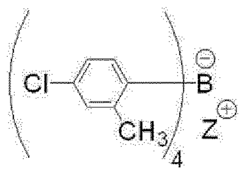
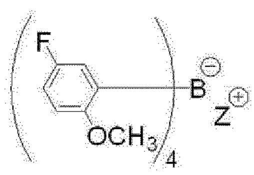
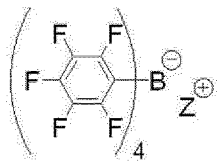

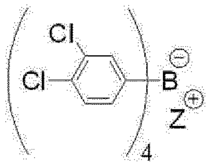
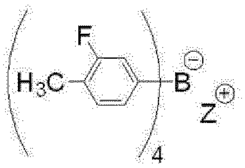
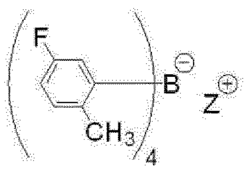
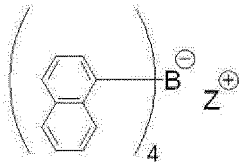

One kind of electron-donating polymerization initiator may be used alone, or two or more kinds of electron-donating polymerization initiators may be used in combination.

The content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

From the viewpoint of UV printing durability and temporal stability, it is preferable that the image-recording layer in the present disclosure use an onium salt compound as an electron-accepting polymerization initiator and a borate salt compound as an electron-donating polymerization initiator.

In the present disclosure, it is also preferable that the polymerization initiator include a compound in the form of a conjugate salt of an electron-donating polymerization initiator and an electron-accepting polymerization initiator.

From the viewpoint of UV printing durability of the lithographic printing plate to be obtained, the compound in the form of a conjugate salt of an electron-donating polymerization initiator and an electron-accepting polymerization initiator is preferably a compound in the form of a conjugate salt of an anion in the aforementioned electron-donating polymerization initiator and a cation in the aforementioned electron-accepting polymerization initiator, more preferably a compound in the form of a conjugate salt of an onium cation and a borate anion, even more preferably a compound in the form of a conjugate salt of an iodonium cation or sulfonium cation and a borate anion, and particularly preferably a compound in the form of a conjugate salt of a diaryliodonium cation or a triarylsulfonium cation and a tetraarylborate anion.

Preferable aspects of the anion in the electron-donating polymerization initiator and the cation in the electron-accepting polymerization initiator are the same as the preferable aspects of the anion in the aforementioned electron-donating polymerization initiator and the cation in the aforementioned electron-accepting polymerization initiator.

Specific examples of compounds in the form of a conjugate salt of an electron-accepting polymerization initiator and an electron-donating polymerization initiator will be shown below. However, the present disclosure is not limited thereto.

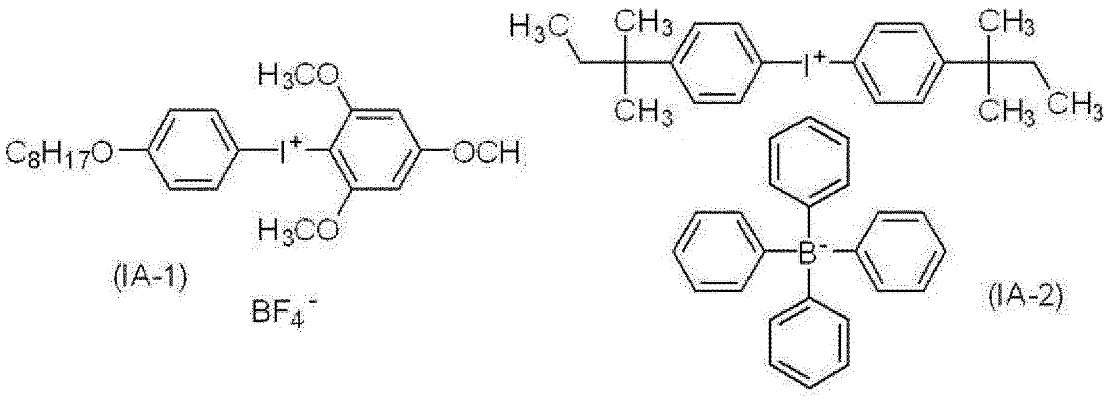

(IA-1) (IA-2)

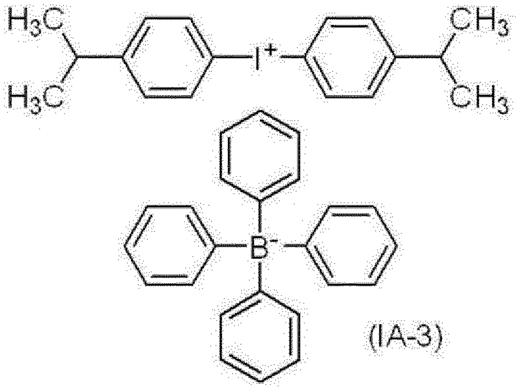

(IA-3)

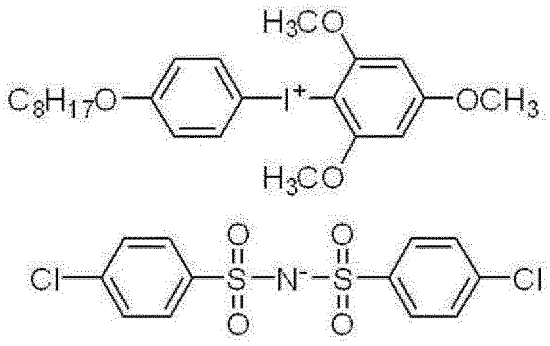

(IA-4)

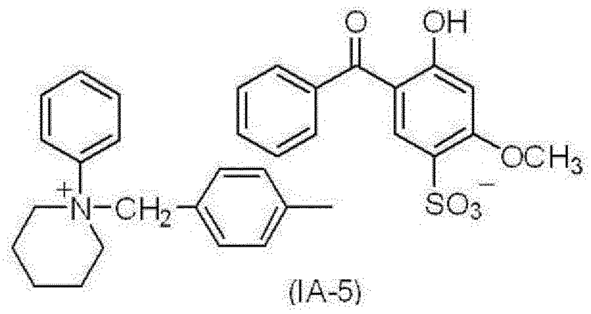

(IA-5)

Specific examples of the compound in the form of a conjugate salt of an electron-accepting polymerization initiator and an electron-donating polymerization initiator include a compound that has the onium cation in the aforementioned electron-accepting polymerization initiator as the countercation represented by $Z^+$ in the preferable specific examples of the aforementioned electron-donating polymerization initiator.

One kind of compound in the form of a conjugate salt of an electron-donating polymerization initiator and an electron-accepting polymerization initiator may be used alone, or two or more kinds of such compounds may be used in combination.

The compound in the form of a conjugate salt of an electron-donating polymerization initiator and an electron-accepting polymerization initiator may be used in combination with the aforementioned electron-donating polymerization initiator or used in combination with the aforementioned electron-accepting polymerization initiator.

The content of the compound in the form of a conjugate salt of an electron-donating polymerization initiator and an electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

In the present disclosure, in a case where the image-recording layer contains the compound in the form of a conjugate salt of an electron-donating polymerization initiator and an electron-accepting polymerization initiator, such an image-recording layer is included in the aspect of the image-recording layer containing an electron-accepting polymerization initiator and an electron-donating polymerization initiator.

[Polymerizable compound]

The image-recording layer in the present disclosure contains a polymerizable compound.
In the present disclosure, a polymerizable compound refers to a compound having a polymerizable group. The polymerizable compound has, for example, a chemical form such as a monomer, a prepolymer (that is, a dimer, a trimer, or an oligomer), or a mixture of these.
In the present disclosure, a compound that corresponds to resin particles and binder polymer that will be described later is regarded as not corresponding to a polymerizable compound, even though this compound is a compound having a polymerizable group.
The polymerizable group that the polymerizable compound has may be a radically polymerizable group or a cationically polymerizable group. The polymerizable group is preferably a radically polymerizable group.
The radically polymerizable group is preferably an ethylenically unsaturated group.
More specifically, examples of the radically polymerizable group include a (meth)acryloyl group, an allyl group, a vinylphenyl group, a vinyl group, and the like. From the viewpoint of reactivity, a (meth)acryloyl group is preferable.
The molecular weight of the polymerizable compound (weight-average molecular weight in a case where the polymerizable compound has molecular weight distribution) is preferably 50 or more and less than 2,500, and more preferably 50 or more and 2,000 or less.
From the viewpoint of UV printing durability, ink receptivity, chemical resistance, and on-press developability of a non-image area over time, the molecular weight of the polymerizable compound is preferably 1,500 or less.
From the viewpoint of UV printing durability of the lithographic printing plate to be obtained, the mass of the polymerizable compound per 1 mol of ethylenically unsaturated bonds (also called "ethylenically unsaturated bond equivalent") is preferably 200 g/mol or less, more preferably 50 g/mol or more and 200 g/mol or less, even more preferably 80 g/mol or more and 180 g/mol or less, and particularly preferably 100 g/mol or more and 150 g/mol or less.
In the present disclosure, the ethylenically unsaturated bond equivalent of the polymerizable compound can be specifically determined as follows, for example.

- Ethylenically unsaturated bond equivalent of dipentaerythritol hexaacrylate (DPHA, molecular weight: 578, number of ethylenically unsaturated bonds:6): 578/6 = 96.3 (g/mol)
- Ethylenically unsaturated bond equivalent of styrene (molecular weight: 104, number of ethylenically unsaturated bond: 1): 104/1 = 104 (g/mol)
- Ethylenically unsaturated bond equivalent of "mixture of 10 g of DPHA and 20 g of styrene": (10 + 20)/{10/96.3 + 20/104} = 101 (g/mol)

In this way, the ethylenically unsaturated bond equivalent in the present disclosure is determined by the above calculation method by identifying the molecular weight of a polymerizable compound, the number of ethylenically unsaturated bonds, and the composition of the polymerizable compound in the image-recording layer by known methods.
In the present disclosure, from the viewpoint of sensitivity and UV printing durability of the lithographic printing plate, the polymerizable compound preferably includes a polymerizable compound having functionalities of 3 or more (that is, having 3 or more polymerizable groups), more preferably includes a polymerizable compound having functionalities of 7 or more (that is, having 7 or more polymerizable groups), and even more preferably includes a polymerizable compound having functionalities of 10 or more (that is, having 10 or more polymerizable groups).
The polymerizable compound is preferably an addition polymerizable compound having an ethylenically unsaturated group as a polymerizable group (this type of polymerizable compound is also called ethylenically unsaturated compound).
Particularly, from the viewpoint of UV printing durability of the lithographic printing plate to be obtained, the polymerizable compound preferably includes an ethylenically unsaturated compound having functionalities of 3 or more (preferably having functionalities of 7 or more and more preferably having functionalities of 10 or more, and more preferably includes a (meth)acrylate compound having functionalities of 3 or more (preferably having functionalities of 7 or more and more preferably having functionalities of 10 or more).

[Oligomer]

One of the preferable aspects is an aspect in which the polymerizable compound in the image-recording layer is an oligomer.
In the present disclosure, an oligomer represents a polymerizable compound which has a molecular weight (weight-average molecular weight in a case where the compound has molecular weight distribution) of 600 or more and

10,000 or less and at least one polymerizable group.

From the viewpoint of excellent chemical resistance and excellent UV printing durability and excellently inhibiting the occurrence of residues during on-press development, the molecular weight of the oligomer is preferably 1,000 or more and 5,000 or less.

Furthermore, from the viewpoint of improving chemical resistance and UV printing durability, the number of polymerizable groups in one molecule of the oligomer is preferably 2 or more, more preferably 3 or more, even more preferably 6 or more, and particularly preferably 10 or more.

The upper limit of the number of polymerizable groups in the oligomer is not particularly limited. The number of polymerizable groups is preferably 20 or less.

From the viewpoint of further improving chemical resistance and UV printing durability and further inhibiting the occurrence of residues during on-press development, an oligomer having 7 or more polymerizable groups and a molecular weight of 1,000 or more and 10,000 or less is preferable, and an oligomer having 7 or more and 20 or less polymerizable groups and a molecular weight of 1,000 or more and 5,000 or less is more preferable.

From the viewpoint of further improving chemical resistance and UV printing durability, the oligomer preferably has at least one kind of compound selected from the group consisting of a compound having a urethane bond, a compound having an ester bond, and a compound having an epoxy residue, and more preferably has a compound having a urethane bond.

In the present disclosure, an epoxy residue refers to a structure formed of an epoxy group. For example, the epoxy residue means a structure similar to a structure established by the reaction between an acid group (carboxylic acid group or the like) and an epoxy group.

. Compound having urethane bond

The compound having a urethane bond, which is an example of oligomer, is not particularly limited. Examples thereof include a compound obtained by a reaction between a polyisocyanate compound and a compound having a hydroxyl group and a polymerizable group.

Examples of the polyisocyanate compound include polyisocyanate compounds having 2 to 5 functional groups. Among these, a polyisocyanate compound having 2 or 3 functional groups is preferable.

Preferable examples of the polyisocyanate compound include 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like. Furthermore, a biuret compound obtained by reacting the above polyisocyanate compound with a known amine compound may also be used.

As the compound having a hydroxyl group and a polymerizable group, a compound having one hydroxyl group and one or more polymerizable groups is preferable, and a compound having one hydroxyl group and two or more polymerizable groups is more preferable.

Examples of the compound having a hydroxyl group and a polymerizable group include hydroxyethyl (meth)acrylate, glycerin di(meth)acrylate, trimethylolpropane di(meth)acrylate, pentaerythritol tri(meth)acrylate, dipentaerythritol penta(meth)acrylate, and the like.

As the compound having a urethane bond, for example, a compound having at least a group represented by Formula (Ac-1) or Formula (Ac-2) is preferable, and a compound having at least a group represented by Formula (Ac-1) is more preferable.

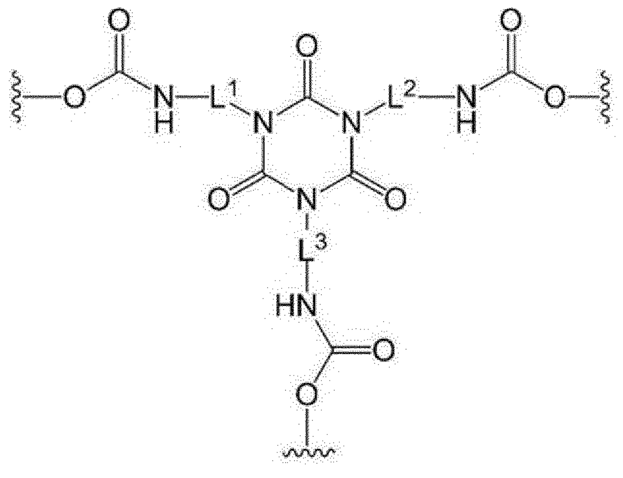

( Ac - 1 )

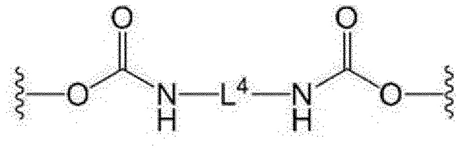

( Ac - 2 )

In Formula (Ac-1) and Formula (Ac-2), $L^1$ to $L^4$ each independently represent a divalent hydrocarbon group having 2 to 20 carbon atoms, and the portion of the wavy line represents a position binding to other structures.

$L^1$ to $L^4$ preferably each independently represent an alkylene group having 2 to 20 carbon atoms, more preferably each independently represent an alkylene group having 2 to 10 carbon atoms, and even more preferably each independently represent an alkylene group having 4 to 8 carbon atoms. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

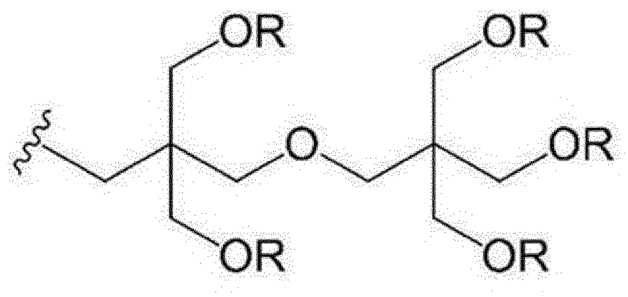

( Ae - 1 )

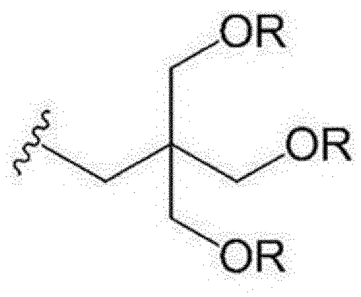

( Ae - 2 )

In Formula (Ae-1) and Formula (Ae-2), R each independently represents an acryloyloxy group or a methacryloyloxy group, and the portion of the wavy line represents a position binding to the portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the polyurethane by a polymer reaction.

For example, the compound having a urethane bond may be obtained by reacting a polyol compound having an acid group with a polyisocyanate compound so as to obtain a polyurethane oligomer and reacting this polyurethane oligomer with a compound having an epoxy group and a polymerizable group.

. Compound having ester bond

The number of polymerizable groups in the compound having an ester bond, which is an example of oligomer, is preferably 3 or more, and more preferably 6 or more.

. Compound having epoxy residue

As the compound having an epoxy residue, which is an example of oligomer, a compound containing a hydroxyl group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown below, but the oligomer used in the present disclosure is not limited thereto.

As the oligomer, commercially available products may also be used. Examples thereof include UA510H, UA-306H, UA-306I, and UA-306T (manufactured by KYOEISHA CHEMICAL Co.,LTD.), UV-1700B, UV-6300B, and UV7620EA (manufactured by NIHON GOSEI KAKO Co.,Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.

From the viewpoint of improving chemical resistance and UV printing durability and further inhibiting the occurrence of residues during on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least a polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 600.

From the viewpoint of excellent chemical resistance, excellent UV printing durability, and excellently inhibiting the occurrence of residues during on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than an oligomer (total amount in a case where the polymerizable compound includes two or more kinds of low-molecular-weight polymerizable compounds), from the viewpoint of chemical resistance and UV printing durability and inhibiting the occurrence of residues during on-press development, the ratio of the mass of the oligomer to the mass of the low-molecular-weight polymerizable compound (oligomer/low-molecular-weight polymerizable compound) is preferably 10/1 to 1/10, more preferably 10/1 to 3/7, and even more preferably 10/1 to 7/3, based on mass.

Examples of the low-molecular-weight polymerizable compound include unsaturated carboxylic acids (for example, acrylic acid, methacrylic acid, itaconic acid, crotonic acid, isocrotonic acid, maleic acid, and the like), and esters and amides thereof. Among these, esters of unsaturated carboxylic acids and polyhydric alcohol compounds and amides of unsaturated carboxylic acids and polyvalent amine compounds are preferably used. In addition, products of an addition reaction between unsaturated carboxylic acid esters or amides having a nucleophilic substituent such as a hydroxyl group, an amino group, or a mercapto group and monofunctional or polyfunctional isocyanates or epoxies, products of a dehydrocondensation reaction between the aforementioned unsaturated carboxylic acid esters or amides and a monofunctional or polyfunctional carboxylic acid, and the like are also suitably used. Furthermore, products of an addition reaction between unsaturated carboxylic acid esters or amides having an electrophilic substituent such as an isocyanate groups or an epoxy group and monofunctional or polyfunctional alcohols, amines, or thiols, and products of a substitution reaction between unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, a vinyl ether, or the like.

These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane.

In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxyl group are also suitable, and specific examples thereof include vinyl urethane compounds having two or more polymerizable vinyl groups in one molecule obtained by adding vinyl monomers having a hydroxyl group represented by Formula (M) to a polyisocyanate compound having two or more isocyanate groups in one molecule which is described in, for example, JP1973-41708B (JP-S48-41708B).

$$CH_2=C(R^{M4})COOCH_2CH(R^{M5})OH \quad (M)$$

In Formula (M), $R^{M4}$ and $R^{M5}$ each independently represent a hydrogen atom or a methyl group.

Furthermore, urethane acrylates described in JP1976-37193A (JP-S51-037193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

The details of how to use the polymerizable compound to be incorporated into the image-recording layer, such as the structure of the compound, whether the compound is used alone or used in combination with other compounds, and the amount of the compound to be added, can be randomly set.

Particularly, from the viewpoint of UV printing durability, the image-recording layer preferably contains two or more kinds of polymerizable compounds.

The content of the polymerizable compound (total content of polymerizable compounds in a case where the image-recording layer contains two or more kinds of polymerizable compounds) with respect to the total mass of the image-recording layer is preferably 5% by mass to 75% by mass, more preferably 10% by mass to 70% by mass, and even more preferably 15% by mass to 60% by mass.

[Particles]

The image-recording layer in the present disclosure contains particles.

The particles may be inorganic particles or organic particles.

Particularly, from the viewpoint of suppressing plate missing (preferably UV plate missing), as the particles to be incorporated into the image-recording layer, organic particles are preferable, and resin particles are more preferable.

Known inorganic particles can be used as inorganic particles, and metal oxide particles such as silica particles and titania particles can be suitably used.

[Resin particles]

Examples of the resin particles include particles containing an addition polymerization-type resin (that is, addition polymerization-type resin particles), particles containing a polyaddition-type resin (that is, polyaddition-type resin particles), particles containing a polycondensation-type resin (that is, polycondensation-type resin particles), and the like. Among these, addition polymerization-type resin particles or polyaddition-type resin particles are preferable.

These resin particles preferably have a three-dimensional crosslinked structure. Especially, it is preferable that the polyaddition-type resin particles have a three-dimensional crosslinked structure.

From the viewpoint of enabling thermal fusion, the resin particles may also be resin particles containing a thermoplastic resin (that is, thermoplastic resin particles).

The resin particles may be in the form of microcapsules, microgel (that is, crosslinked resin particles), or the like.

The resin particles are preferably selected from the group consisting of thermoplastic resin particles, thermally

reactive resin particles, resin particles having a polymerizable group, microcapsules encapsulating a hydrophobic compound, and microgel (crosslinked resin particles). Among these, resin particles having a polymerizable group are preferable.

In a particularly preferable embodiment, the resin particles have at least one ethylenically unsaturated group. The presence of such resin particles brings about effects of improving the printing durability of an exposed portion and improving the on-press developability of a non-exposed portion.

As the thermoplastic resin particles, the thermoplastic resin particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like are preferable.

Specific examples of resins constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these.

From the viewpoint of ink receptivity and UV printing durability, the thermoplastic resin particles preferably contain a resin that has a constitutional unit formed of an aromatic vinyl compound and a nitrile group-containing constitutional unit.

The aforementioned aromatic vinyl compound may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these, for example, 1-vinylnaphthalene is preferable.

Preferable examples of the constitutional unit formed of an aromatic vinyl compound include a constitutional unit represented by Formula A1.

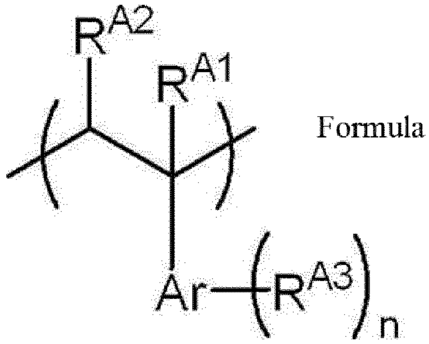

Formula A1

In Formula A1, $R^{A1}$ and $R^{A2}$ each independently represent a hydrogen atom or an alkyl group, Ar represents an aromatic ring group, $R^{A3}$ represents a substituent, and n represents an integer of 0 or greater and equal to or less than the maximum number of substituents of Ar.

In Formula A1, $R^{A1}$ and $R^{A2}$ preferably each independently represent a hydrogen atom or an alkyl group having 1 to 4 carbon atoms, more preferably each independently represent a hydrogen atom or a methyl group, and even more preferably both represent a hydrogen atom.

In Formula A1, Ar is preferably a benzene ring or a naphthalene ring, and more preferably a benzene ring.

In Formula A1, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.

In a case where there is a plurality of $R^{A3}$'s in Formula A1, the plurality of $R^{A3}$'s may be the same as or different from each other.

In Formula A1, n is preferably an integer of 0 to 2, more preferably 0 or 1, and even more preferably 0.

From the viewpoint of ink receptivity, the content of the constitutional unit formed of an aromatic vinyl compound is preferably higher than the content of the nitrile group-containing constitutional unit that will be described later. The content of the constitutional unit formed of an aromatic vinyl compound with respect to the total mass of the thermoplastic resin is more preferably 15% by mass to 85% by mass, and even more preferably 30% by mass to 70% by mass.

The nitrile group-containing constitutional unit is preferably introduced using a monomer having a nitrile group.

Examples of the monomer having a nitrile group include an acrylonitrile compound. As the monomer having a nitrile group, for example, (meth)acrylonitrile is suitable.

As the nitrile group-containing constitutional unit, a constitutional unit formed of (meth)acrylonitrile is preferable.

Preferable examples of the nitrile group-containing constitutional unit include a constitutional unit represented by Formula B1.

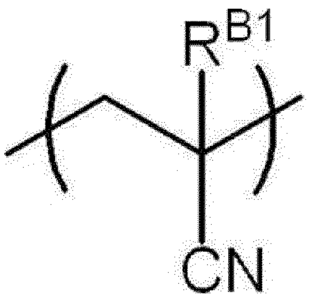

Formula B1

In Formula B1, $R^{B1}$ represents a hydrogen atom or an alkyl group,

In Formula B1, $R^{B1}$ is preferably a hydrogen atom or an alkyl group having 1 to 4 carbon atoms, more preferably a hydrogen atom or a methyl group, and even more preferably a hydrogen atom.

From the viewpoint of ink receptivity, the content of the nitrile group-containing constitutional unit is preferably lower than the content of the aforementioned constitutional unit formed of an aromatic vinyl compound. The content of the nitrile group-containing constitutional unit with respect to the total mass of the resin is more preferably 55% by mass to 90% by mass, and more preferably 60% by mass to 85% by mass.

In a case where the resin contained in the thermoplastic resin particles has the constitutional unit formed of an aromatic vinyl compound and the nitrile group-containing constitutional unit, the content ratio between the constitutional unit formed of an aromatic vinyl compound and the nitrile group-containing constitutional unit (constitutional unit formed of aromatic vinyl compound:nitrile group-containing constitutional unit) is preferably 5:5 to 9:1, and more preferably 6:4 to 8:2, based on mass.

From the viewpoint of UV printing durability and chemical resistance, the resin contained in the thermoplastic resin particles preferably further has a constitutional unit formed of a N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

Preferable examples of the constitutional unit formed of a N-vinyl heterocyclic compound include a constitutional unit represented by Formula C1.

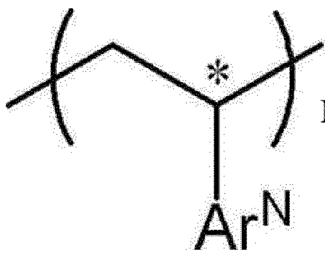

Formula C1

In Formula C1, $Ar^N$ represents a nitrogen atom-containing heterocyclic structure, and the nitrogen atom in $Ar^N$ is bonded to the carbon atom represented by *.

In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.

Furthermore, the heterocyclic structure represented by $Ar^N$ may have a known substituent.

The content of the constitutional unit formed of a N-vinyl heterocyclic compound with respect to the total mass of the thermoplastic resin is preferably 5% by mass to 50% by mass, and more preferably 10% by mass to 40% by mass.

The resin contained in the thermoplastic resin particles may contain an acidic group-containing constitutional unit. From the viewpoint of on-press developability and ink receptivity, it is preferable that the resin A do not contain an

acidic group-containing constitutional unit.

Specifically, in the thermoplastic resin, the content of the acidic group-containing constitutional unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

In the present disclosure, the acid value is determined by the measurement method based on JIS K0070: 1992.

From the viewpoint of ink receptivity, the resin contained in the thermoplastic resin particles may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth)acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may further have a known substituent. Preferable examples of the aryl (meth)acrylate compound include phenyl (meth)acrylate.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. Preferable examples of the aralkyl (meth)acrylate compound include benzyl (meth)acrylate.

In the resin contained in the thermoplastic resin particles, the content of the hydrophobic group-containing constitutional unit with respect to the total mass of the resin is preferably 5% by mass to 50% by mass, and more preferably 10% by mass to 30% by mass.

From the viewpoint of UV printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxyl group, an amino group, a nitrile group, a polyalkylene oxide structure, and the like.

From the viewpoint of UV printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, among the above hydrophilic groups, groups having a polypropylene oxide structure as a polyalkylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, as the aforementioned hydrophilic group, a group represented by Formula Z, which will be described later, is preferable.

Among the hydrophilic groups that the thermoplastic resin has, a group represented by Formula PO is preferable.

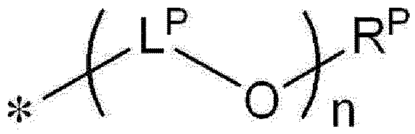
Formula PO

In Formula PO, $L^P$ each independently represents an alkylene group, $R^P$ represents a hydrogen atom or an alkyl group, and n represents an integer of 1 to 100.

In Formula PO, $L^P$ preferably each independently represents an ethylene group, a 1-methylethylene group, or

a 2-methylethylene group, and more preferably each independently represents an ethylene group.

In Formula PO, $R^P$ is preferably a hydrogen atom or an alkyl group having 1 to 18 carbon atoms, more preferably a hydrogen atom or an alkyl group having 1 to 10 carbon atoms, even more preferably a hydrogen atom or an alkyl group having 1 to 4 carbon atoms, and particularly preferably a hydrogen atom or a methyl group.

In Formula PO, n is preferably an integer of 1 to 10, and more preferably an integer of 1 to 4.

The content of the hydrophilic group-containing constitutional unit with respect to the total mass of the resin is preferably 5% by mass to 60% by mass, and more preferably 10% by mass to 30% by mass.

The resin contained in the thermoplastic resin particles may further contain other constitutional units. The resin can contain, as those other constitutional units, constitutional units other than the constitutional units described above without particular limitations. Examples thereof include constitutional units formed of an acrylamide compound, a vinyl ether compound, and the like.

Examples of the acrylamide compound include (meth)acrylamide, N-methyl (meth)acrylamide, N-ethyl (meth)acrylamide, N-propyl (meth)acrylamide, N-butyl (meth)acrylamide, N,N'-dimethyl (meth)acrylamide, N,N'-diethyl (meth)acrylamide, N-hydroxyethyl (meth)acrylamide, N-hydroxypropyl (meth)acrylamide, N-hydroxybutyl (meth)acrylamide, and the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, phenoxypolyethylene glycol vinyl ether, and the like.

In the thermoplastic resin, the content of those other constitutional units with respect to the total mass of the thermoplastic resin is preferably 5% by mass to 50% by mass, and more preferably 10% by mass to 30% by mass.

From the viewpoint of UV printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two or more kinds of thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). In the present specification, an extrapolated glass transition initiation temperature (hereinafter, called Tig in some cases) is used as the glass transition temperature.

Specifically, the glass transition temperature is measured by the method described below.

In order to determine the glass transition temperature, the device is kept at a temperature approximately 50°C lower than the expected Tg of the resin until the device stabilizes. Then, the resin is heated at a heating rate of 20°C/min to a temperature approximately 30°C higher than the temperature at which the glass transition ends, and a differential thermal analysis (DTA) curve or a DSC curve is plotted.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition temperature stepwise changes is maximum.

In a case where the thermoplastic resin particles contain two or more kinds of thermoplastic resins, Tg of the thermoplastic resins contained in the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents Tg of a second resin, and W2 represents the mass ratio of the second resin to the total mass of thermoplastic resin components in the thermoplastic resin particles, Tg0 (K) of the thermoplastic resin particles can be estimated according to the following FOX equation.

FOX equation:

$$1/Tg0 = (W1/Tg1) + (W2/Tg2)$$

Furthermore, in a case where the thermoplastic resin particles contain 3 kinds of resins or in a case where 3

kinds of thermoplastic resin particles containing different types of thermoplastic resins are contained in a pretreatment liquid, provided that Tgn (K) represents Tg of nth resin and Wn represents the mass ratio of the nth resin to the total mass of resin components in the thermoplastic resin particles, Tg of the thermoplastic resin particles can be estimated according to the following equation just as in the case described above.

FOX equation:

$$1/Tg0 = (W1/Tg1) + (W2/Tg2) + (W3/Tg3)\cdots + (Wn/Tgn)$$

In the present specification, Tg is a value measured by a differential scanning calorimeter (DSC). As the differential scanning calorimetry (DSC), for example, EXSTAR 6220 manufactured by SII NanoTechnology Inc. can be used.

Examples of the thermally reactive resin particles include resin particles having a thermally reactive group. The thermally reactive resin particles form a hydrophobilized region through crosslinking by a thermal reaction and the accompanying change in functional groups.

The thermally reactive group in the resin particles having a thermally reactive group may be a functional group that causes any reaction as long as chemical bonds are formed. The thermally reactive group is preferably a polymerizable group. Preferable examples of the polymerizable group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxyl group, a carboxy group, and the like), a carboxy group that causes a condensation reaction, a hydroxyl group or an amino group that is a reaction partner of the carboxy group, an acid anhydride that causes a ring-opening addition reaction, an amino group or a hydroxyl group which is a reaction partner of the acid anhydride, and the like.

The resin having a thermally reactive group may be an addition polymerization-type resin, a polyaddition-type resin, or a polycondensation-type resin or may be a thermoplastic resin.

As the microcapsules, for example, microcapsules are preferable which encapsulate at least some of the constituent components (preferably a hydrophobic compound) of the image-recording layer as described in JP2001-277740A and JP2001-277742A. In a preferable aspect of the image-recording layer containing microcapsules as resin particles, the image-recording layer is composed of microcapsules that encapsulate a hydrophobic component (that is, a hydrophobic compound) among the constituent components of the image-recording layer and a hydrophilic component (that is, a hydrophilic compound) that is on the outside of the microcapsules.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, reactive microgel having a polymerizable group on the surface thereof is particularly preferable.

In order to obtain microcapsules containing a constituent component of the image-recording layer, known synthesis methods can be used.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, reactive microgel having a polymerizable group on the surface thereof is particularly preferable.

In order to obtain microgel containing a constituent component of the image-recording layer, known synthesis methods can be used.

As the resin particles, from the viewpoint of printing durability, antifouling properties, and storage stability of the lithographic printing plate to be obtained, polyaddition-type resin particles having a three-dimensional crosslinked structure are preferable which are obtained by a reaction between a polyvalent isocyanate compound that is an adduct of a polyhydric phenol compound having two or more hydroxyl groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one kind of compound selected from the group consisting of propylene glycol, glycerin, and trimethylolpropane is even more preferable.

Preferable examples of the resin particles obtained by the reaction between a polyvalent isocyanate compound that is an adduct of a polyhydric phenol compound having two or more hydroxyl groups in a molecule and isophorone

diisocyanate and a compound having active hydrogen include the resin particles described in paragraphs "0032" to "0095" of JP2012-206495A.

As the resin particles, from the viewpoint of printing durability and solvent resistance of the lithographic printing plate to be obtained, addition polymerization-type resin particles are preferable which have a hydrophobic main chain and include both i) constitutional unit having a nitrile group directly bonded to the hydrophobic main chain and ii) constitutional unit having a pendant group including a hydrophilic polyalkylene oxide segment.

Preferable examples of the hydrophobic main chain include an acrylic resin chain.

Preferable examples of the constitutional unit i) described above include $-[CH_2CH(C\equiv N)-]$ or $-[CH_2C(CH_3)(C\equiv N)-]$.

It is easy to obtain the constitutional unit i), for example, from acrylonitrile or methacrylonitrile or from a combination of these.

Furthermore, as an alkylene oxide in the hydrophilic polyalkylene oxide segment that the constitutional unit ii) described above has, ethylene oxide or a propylene oxide is preferable, and ethylene oxide is more preferable.

The repetition number of the alkylene oxide structure is preferably 10 to 100, more preferably 25 to 75, and even more preferably 40 to 50.

Preferable examples of the addition polymerization-type resin particles having a hydrophobic main chain and including both i) constitutional unit having the pendant cyano group directly bonded to the hydrophobic main chain and ii) constitutional unit having a pendant group including the hydrophilic polyalkylene oxide segment include the particles described in paragraphs "0039" to "0068" of JP2008-503365A.

From the viewpoint of UV printing durability and on-press developability, the resin particles preferably have a hydrophilic group.

The hydrophilic group is not particularly limited as long as it has a hydrophilic structure, and examples thereof include an acid group such as a carboxy group, a hydroxyl group, an amino group, a nitrile group, a group having a polyalkylene oxide structure, and the like.

Among these, from the viewpoint of on-press developability and UV printing durability, a group having a polyalkylene oxide structure is preferable, and a group having a polyethylene oxide structure, a polypropylene oxide structure, or a polyethylene/propylene oxide structure is more preferable.

Furthermore, from the viewpoint of on-press developability and suppressing the occurrence of development residues during on-press development, the polyalkylene oxide structure preferably has a polypropylene oxide structure, and more preferably has a polyethylene oxide structure and a polypropylene oxide structure.

From the viewpoint of printing durability, receptivity, and on-press developability, the hydrophilic group preferably has a nitrile group-containing constitutional unit or a group represented by Formula Z, more preferably has a constitutional unit represented by Formula (AN) or a group represented by Formula Z, and particularly preferably has a group represented by Formula Z.

(Constitutional unit represented by Formula (AN))

It is preferable that the resin particles in the present disclosure have a constitutional unit represented by Formula (AN) that has a nitrile group as a hydrophilic group.

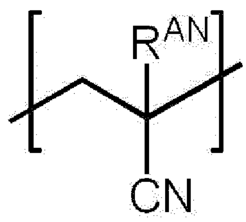

( AN )

In Formula (AN), $R^{AN}$ represents a hydrogen atom or a methyl group.

In order to introduce the constitutional unit represented by Formula (AN) into the resin particles, a resin (addition polymerization-type resin) having a cyano group-containing constitutional unit may be synthesized using a monomer having a nitrile group.

As the monomer having a nitrile group, for example, (meth)acrylonitrile is suitable.

From the viewpoint of UV printing durability, the content of the constitutional unit represented by Formula (AN) with respect to the total mass of the resin is preferably 5% by mass to 90% by mass, more preferably 20% by mass to

80% by mass, and particularly preferably 30% by mass to 60% by mass.

(Group represented by Formula Z)

It is preferable that the resin particles in the present disclosure have a group represented by Formula Z as a hydrophilic group.

*-Q-W-Y Formula Z

In formula Z, Q represents a divalent linking group, W represents a divalent group having a hydrophilic structure or a divalent group having a hydrophobic structure, and Y represents a monovalent group having a hydrophilic structure or a monovalent group having a hydrophilic structure, either W or Y has a hydrophilic structure, and * represents a binding site with another structure.

Furthermore, it is preferable that any of the hydrophilic structures included in Formula Z include a polyalkylene oxide structure.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a group having a polyalkylene oxide structure, and more preferably a polyalkyleneoxy group or a group in which $-CH_2CH_2NR^W-$ is bonded to one end of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represents a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms, and $R^W$ represents a hydrogen atom or an alkyl group.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. Particularly, the monovalent group having a hydrophilic structure is preferably a group having a polyalkylene oxide structure, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. $R^W$ in this group also represents a hydrogen atom or an alkyl group.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 7 to 120 carbon atoms (alkylaryl group), an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the resin particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

The group represented by Formula Z may function as a dispersible group for improving the dispersibility of the resin particles.

From the viewpoint of printing durability and on-press developability, the resin particles in the present disclosure preferably have a polymerizable group (preferably an ethylenically unsaturated group). Particularly, the resin particles more preferably include resin particles having a polymerizable group on the surface thereof. Using the resin particles having a polymerizable group makes it easy to suppress plate missing (preferably UV plate missing) and improves printing durability (preferably UV printing durability) as well.

From the viewpoint of printing durability, it is preferable that the resin particles in the present disclosure be resin particles having a hydrophilic group and a polymerizable group.

The polymerizable group may be a cationically polymerizable group or a radically polymerizable group. From the viewpoint of reactivity, the polymerizable group is preferably a radically polymerizable group.

The aforementioned polymerizable group is not particularly limited as long as it is a polymerizable group. From the viewpoint of reactivity, an ethylenically unsaturated group is preferable, a vinylphenyl group (styryl group), a

(meth)acryloxy group, or a (meth)acrylamide group is more preferable, and a (meth)acryloxy group is particularly preferable.

In addition, it is preferable that the resin constituting the resin particles having a polymerizable group have a polymerizable group-containing constitutional unit.

The polymerizable group may be introduced into the surface of the resin particles by a polymer reaction.

Furthermore, from the viewpoint of printing durability, receptivity, on-press developability, and inhibiting the occurrence of development residues during on-press development, the resin particles preferably contain a polyaddition-type resin having a urea bond, more preferably contain a polyaddition-type resin having a structure obtained by reacting at least an isocyanate compound represented by Formula (Iso) with water, and particularly preferably contain a polyaddition-type resin that has a structure obtained by reacting at least an isocyanate compound represented by Formula (Iso) with water and has a polyethylene oxide structure and a polypropylene oxide structure as polyoxyalkylene structures. Furthermore, the particles containing the polyaddition-type resin having a urea bond are preferably microcapsules or microgel.

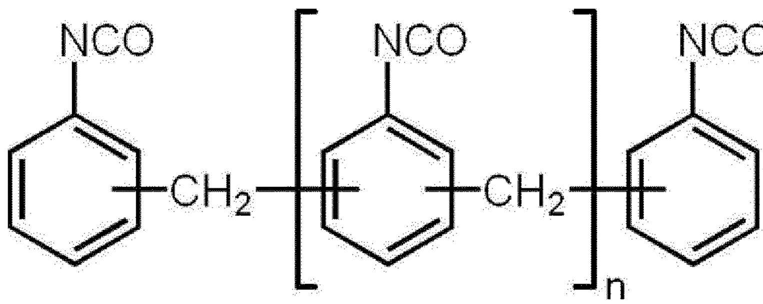

( Iso )

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water, the isocyanate group is partially hydrolyzed by water and generates an amino group. The generated amino group reacts with the isocyanate group and generates a urea bond, and a dimer is consequently formed. Furthermore, the following reaction is repeated to form a polyaddition-type resin having a urea bond.

In the following reaction, by adding a compound (compound having active hydrogen) such as an alcohol compound or an amine compound reactive with an isocyanate group, it is possible to introduce the structure of an alcohol compound, an amine compound, or the like to the polyaddition-type resin having a urea bond.

Preferable examples of the compound having active hydrogen include the aforementioned compound having active hydrogen.

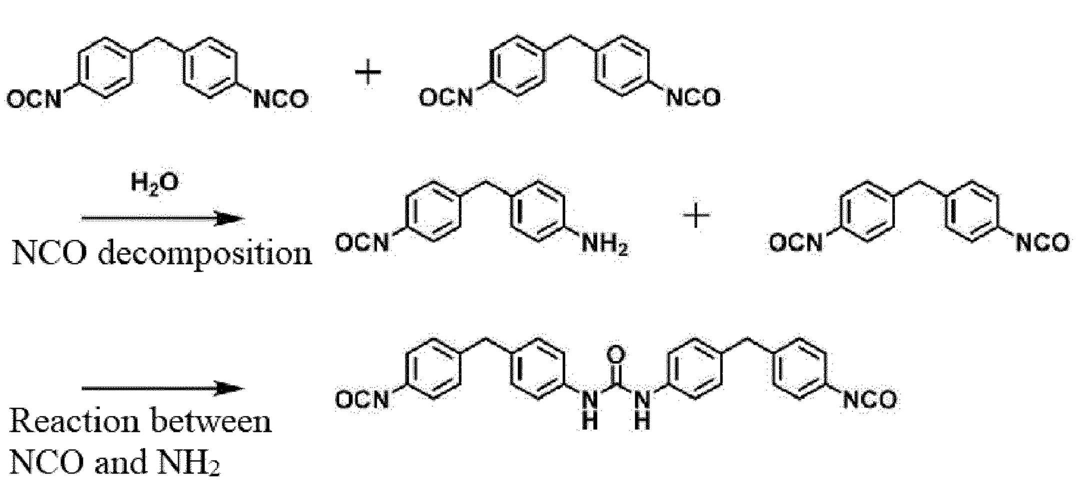


The polyaddition-type resin having a urea bond preferably has an ethylenically unsaturated group, and more preferably has a group represented by Formula (PETA).

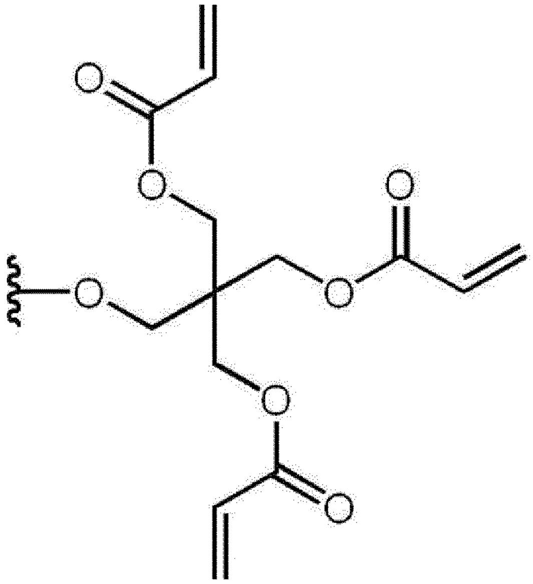

( PETA )

In Formula (PETA), the portion of the wavy line represents a binding position with other structures.

(Synthesis of resin particles)

The synthesis method of the resin particles is not particularly limited, and may be a method that makes it possible to synthesize particles with various resins described above. Examples of the synthesis method of the resin particles include known synthesis methods of resin particles, such as an emulsion polymerization method, a suspension polymerization method, a dispersion polymerization method, a soap-free polymerization method, and a microemulsion polymerization method.
In addition, for the synthesis of the resin particles, a known microcapsule synthesis method, a known microgel (crosslinked resin particle) synthesis method, and the like may be used.

(Particle diameter)

The arithmetic mean particle diameter of the particles in the present disclosure is preferably 1 nm to 500 nm, more preferably 10 nm to 400 nm, and even more preferably 20 nm to 350 nm.
The arithmetic mean particle diameter of particles is determined by the following method.
Particles are imaged with an electron microscope, particle diameters are measured for 5,000 random particles in the image, and the arithmetic mean thereof is calculated. In a case where the shape of the particles is not spherical, the equivalent circular diameter of the particles is adopted as the particle diameter.
One kind of particles may be used alone, or two or more kinds of particles may be used in combination.
From the viewpoint of suppressing plate missing (preferably UV plate missing), the content of the particles (preferably the resin particles) with respect to the total mass of the image-recording layer is preferably 1% by mass to 90% by mass, more preferably 5% by mass to 85% by mass, even more preferably 10% by mass to 80% by mass, and particularly preferably 15% by mass to 75% by mass.

[Infrared absorber]

It is preferable that the image-recording layer in the present disclosure contain an infrared absorber.
The infrared absorber has a function of converting absorbed infrared rays into heat and a function of being excited by infrared rays to transfer electrons and/or energy to the polymerization initiator described above.
The infrared absorber to be used in the image-recording layer is preferably a dye or pigment having an absorption maximum at a wavelength of 700 nm to 1,400 nm, and more preferably a dye.
Furthermore, in the image-recording layer, as an infrared absorber, the compound represented by Formula 1-1 (discoloring compound) described above may be used.
As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo

dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Furthermore, for example, a cyanine dye or an indolenine cyanine dye is preferable. Among these, a cyanine dye is particularly preferable.

The infrared absorber is preferably a cationic polymethine colorant having an oxygen or nitrogen atom at the meso-position. Preferable examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As the pigment to be used as the infrared absorber, the compounds described in paragraphs "0072" to "0076" of JP2008-195018A are preferable.

One kind of infrared absorber may be used alone, or two or more kinds of infrared absorbers may be used in combination.

The content of the infrared absorber with respect to the total mass of the image-recording layer is preferably 0.05% by mass to 30% by mass, more preferably 0.1% by mass to 20% by mass, and particularly preferably 0.2% by mass to 10% by mass.

[Relationship among electron-donating polymerization initiator, electron-accepting polymerization initiator, and infrared absorber]

The image-recording layer in the present disclosure preferably contains an electron-donating polymerization initiator, an electron-accepting polymerization initiator, and an infrared absorber. HOMO of the electron-donating polymerization initiator is preferably -6.0 eV or more, and LUMO of the electron-accepting polymerization initiator is preferably -3.0 eV or less.

More preferable aspects of HOMO of the electron-donating polymerization initiator and LUMO of the electron-accepting polymerization initiator are as described above.

Presumably, in the image-recording layer of the present disclosure, the electron-donating polymerization initiator, the infrared absorber, and the electron-accepting polymerization initiator may exchange energy, for example, in the manner described in the following chemical formula.

Accordingly, it is considered that in a case where HOMO of the electron-donating polymerization initiator is -6.0 eV or more and LUMO of the electron-accepting polymerization initiator is -3.0 eV or less, radicals may be more efficiently generated, and chemical resistance and UV printing durability may be therefore further improved easily.

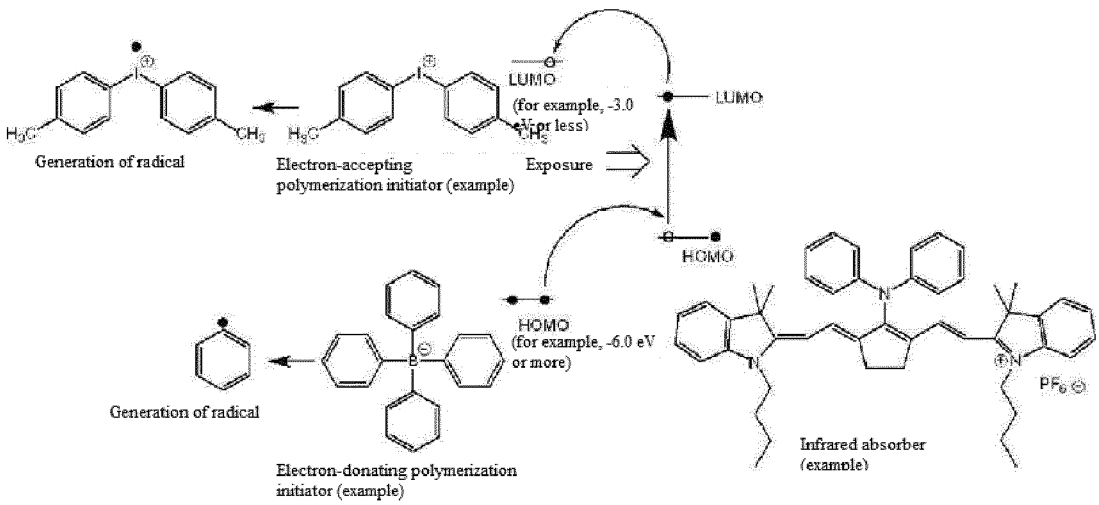

From the viewpoint of UV printing durability and chemical resistance, HOMO of the infrared absorber - HOMO of the electron-donating polymerization initiator (that is, a value obtained by subtracting HOMO of the electron-donating polymerization initiator from HOMO of the infrared absorber) is preferably 1.00 eV or less, and more preferably 0.70 eV or less. From the same viewpoint as above, HOMO of the infrared absorber - HOMO of the electron-donating polymerization initiator is preferably -0.20 eV or more, and more preferably -0.100 eV or more.

From the same viewpoint as above, HOMO of the infrared absorber - HOMO of the electron-donating polymerization initiator is preferably equal to 1.00 eV to -0.20 eV, and more preferably equal to 0.700 eV to -0.10 eV. The negative sign means that HOMO of the electron-donating polymerization initiator is higher than HOMO of the infrared absorber.

From the viewpoint of UV printing durability and chemical resistance, LUMO of the electron-accepting polymerization initiator - LUMO of the infrared absorber (that is, a value obtained by subtracting LUMO of the infrared absorber from LUMO of the electron-accepting polymerization initiator) is preferably 1.00 eV or less, and more preferably 0.70 eV or less. From the same viewpoint as above, LUMO of the electron-accepting polymerization initiator - LUMO of the infrared absorber is preferably -0.20 eV or more, and more preferably -0.100 eV or more.

From the same viewpoint as above, LUMO of the electron-accepting polymerization initiator - LUMO of the infrared absorber is preferably equal to 1.00 eV to -0.20 eV, and more preferably equal to 0.70 eV to -0.10 eV. The negative sign means that LUMO of the infrared absorber is higher than LUMO of the electron-accepting polymerization initiator.

[Other components]

The image-recording layer in the present disclosure may contain a binder polymer, a chain transfer agent, an oil sensitizing agent, a development accelerator, other additives, and the like, in addition to the components described above.

[Binder polymer]

The image-recording layer may contain a binder polymer.

The ammonium group-containing polymer in the aforementioned resin particles and the oil sensitizing agent which will be described later does not correspond to the binder polymer. That is, the binder polymer in the present disclosure is a polymer that is not in the form of particles.

As the binder polymer, known binder polymers (for example, a (meth) acrylic resin, a polyvinyl acetal resin, a polyurethane resin, and the like) used for the image-recording layer of a lithographic printing plate precursor can be suitably used.

As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

As a binder polymer having a poly(alkylene oxide) moiety in the main chain, a polyurethane resin is preferable.

In a case where the binder polymer has a poly(alkylene oxide) moiety in the side chain, examples of polymers include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

In addition, as the binder polymer, for example, a polymer compound is also preferable which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

As the star-shaped polymer compound, for example, the compounds described in JP2012-148555A can be preferably used.

Examples of the star-shaped polymer compound include the compound described in JP2008-195018A that has a polymerizable group such as an ethylenically unsaturated bond for improving the film hardness of an image area in a main chain or side chain and preferably in a side chain. The polymerizable group of the star-shaped polymer compound forms crosslinks between the molecules of the star-shaped polymer compound, which facilitates curing.

As the polymerizable group, an ethylenically unsaturated group such as a (meth)acryloyl group, a vinyl group, an allyl group, or a vinyl phenyl group (styryl group), an epoxy group, or the like is preferable, a (meth)acryloyl group, a

vinyl group, or a vinyl phenyl group (styryl group) is more preferable from the viewpoint of polymerization reactivity, and a (meth)acryloyl group is particularly preferable. These groups can be introduced into the polymer by a polymer reaction or copolymerization. Specifically, for example, it is possible to use a reaction between a polymer having a carboxy group in a side chain and glycidyl methacrylate or a reaction between a polymer having an epoxy group and an ethylenically unsaturated group-containing carboxylic acid such as methacrylic acid.

The molecular weight of the binder polymer that is a weight-average molecular weight (Mw) expressed in terms of polystyrene by GPC is preferably 2,000 or more, more preferably 5,000 or more, and even more preferably 10,000 to 300,000.

As the binder polymer, as necessary, a hydrophilic polymer such as polyacrylic acid or polyvinyl alcohol described in JP2008-195018A can be used in combination. In addition, a lipophilic polymer and a hydrophilic polymer can be used in combination.

One kind of binder polymer may be used alone, or two or more kinds of binder polymers may be used in combination.

The content of the binder polymer to be incorporated into the image-recording layer can be randomly set. The content of the binder polymer with respect to the total mass of the image-recording layer is preferably 1% by mass to 90% by mass, and more preferably 5% by mass to 80% by mass.

[Chain transfer agent]

The image-recording layer in the present disclosure may contain a chain transfer agent. The chain transfer agent contributes to the improvement of UV printing durability of the lithographic printing plate.

As the chain transfer agent, a thiol compound is preferable, a thiol compound having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

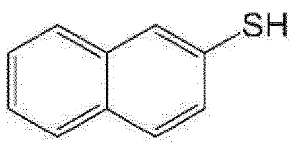

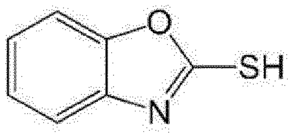
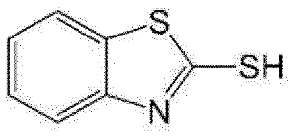
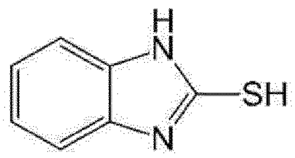

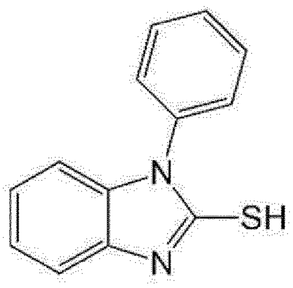
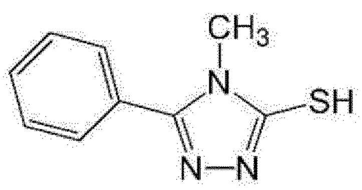
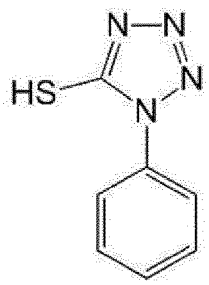

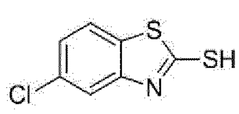
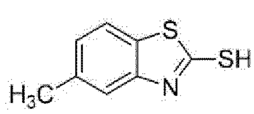
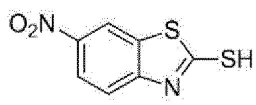
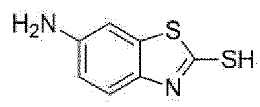

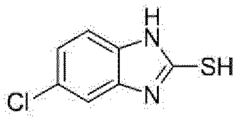 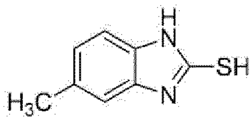 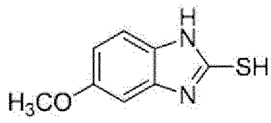 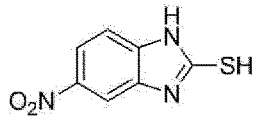

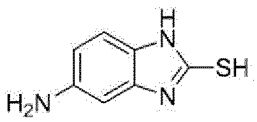 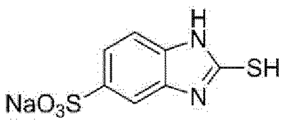 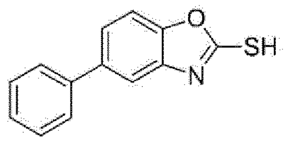

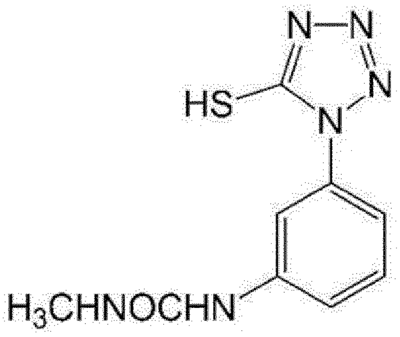 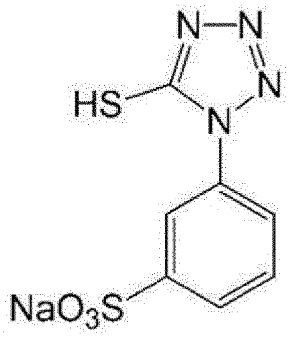

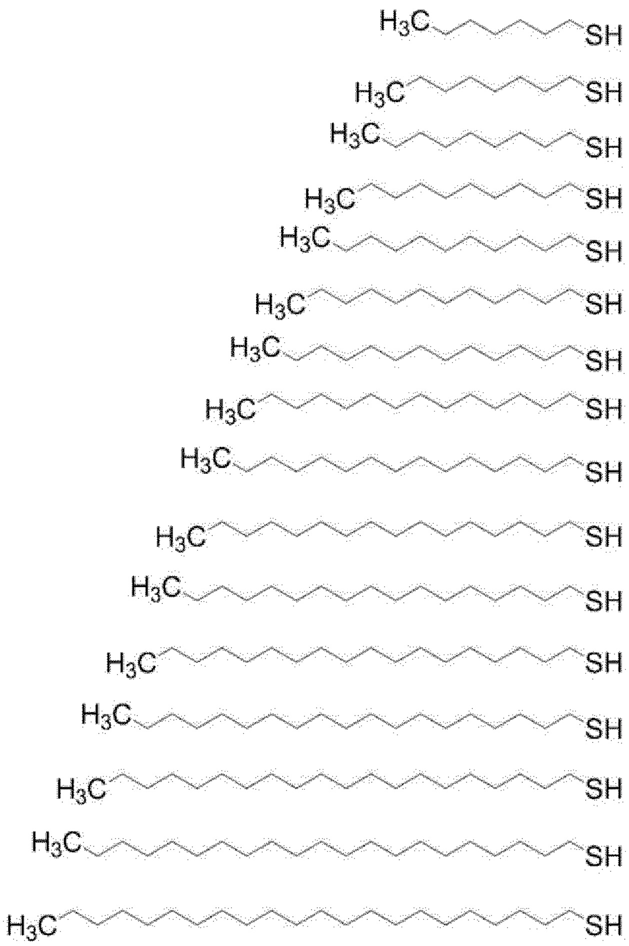 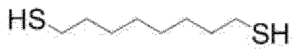 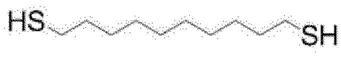

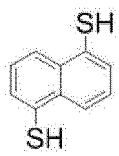 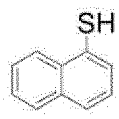

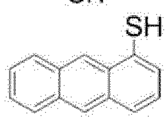 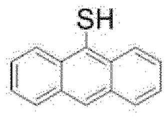

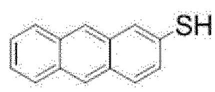 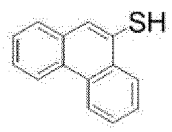

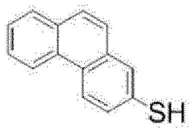 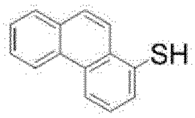

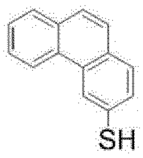 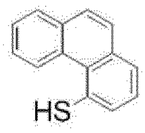

Only one kind of chain transfer agent may be added to the image-recording layer, or two or more kinds of chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by

mass to 30% by mass.

[Oil sensitizing agent]

In order to improve ink receptivity, the image-recording layer may contain an oil sensitizing agent.

As the oil sensitizing agent, the oil sensitizing agent used in the overcoat layer can be used, and preferable aspects thereof are also the same.

Particularly, in a case where an inorganic lamellar compound is incorporated into an overcoat layer, these oil sensitizing agents function as a surface coating agent for the inorganic lamellar compound and can inhibit the receptivity deterioration caused in the middle of printing by the inorganic lamellar compound.

The image-recording layer may contain only one kind of oil sensitizing agent, or two or more kinds of oil sensitizing agents may be used in combination.

One of the preferable aspects of the image-recording layer used in the present disclosure is an aspect in which the image-recording layer contains two or more kinds of compounds as oil sensitizing agents.

Specifically, from the viewpoint of satisfying both the on-press developability and receptivity, the image-recording layer in the present disclosure preferably uses, as an oil sensitizing agent, a combination of two or more compounds among a phosphonium compound, a nitrogen-containing low-molecular-weight compound, and an ammonium group-containing polymer, and more preferably uses a combination of two or more compounds among a phosphonium compound, quaternary ammonium salts, and an ammonium group-containing polymer.

The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.

[Development accelerator]

The image-recording layer in the present disclosure may contain a development accelerator.

The value of polarity element as an SP value of the development accelerator is preferably 6.0 to 26.0, more preferably 6.2 to 24.0, even more preferably 6.3 to 23.5, and particularly preferably 6.4 to 22.0.

In the present disclosure, as the value of polarity element as an SP value (solubility parameter, unit: $(cal/cm^3)^{1/2}$), the value of polarity element δp in the Hansen solubility parameters is used. The Hansen solubility parameters are obtained by dividing the solubility parameters introduced by Hildebrand into three components, a dispersion element δd, a polarity element δp, and a hydrogen bond element δh, and expressing the parameters in a three-dimensional space. In the present disclosure, the polarity element δp is used.

δp [$cal/cm^3$] is a dipole-dipole force element in the Hansen solubility parameters, V [$cal/cm^3$] is a molar volume, and μ [D] is a dipole moment. As δp, the following equation simplified by Hansen and Beerbower is generally used.

$$\delta_p = \frac{37.4\mu}{V^{1/2}}$$

The development accelerator is preferably a hydrophilic polymer compound or a hydrophilic low-molecular-weight compound.

In the present disclosure, "hydrophilic" means that the value of polarity element as an SP value is 6.0 to 26.0, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.

Examples of the hydrophilic polymer compound include a cellulose compound and the like. Among these, a cellulose compound is preferable.

Examples of the cellulose compound include cellulose or a compound obtained by modifying at least a part of cellulose (modified cellulose compound). Among these, a modified cellulose compound is preferable.

Preferable examples of the modified cellulose compound include a compound which is obtained by substituting at least some of hydroxyl groups of cellulose with at least one kind of group selected from the group consisting of an alkyl group and a hydroxyalkyl group.

The degree of substitution of the compound, which is obtained by substituting at least some of hydroxyl groups of cellulose with at least one kind of group selected from the group consisting of an alkyl group and a hydroxyalkyl group, is preferably 0.1 to 6.0, and more preferably 1 to 4.

As the modified cellulose compound, an alkyl cellulose compound or a hydroxyalkyl cellulose compound is preferable, and a hydroxyalkyl cellulose compound is more preferable.

Preferable examples of the alkyl cellulose compound include methyl cellulose.

Preferable examples of the hydroxyalkyl cellulose compound include hydroxypropyl cellulose.

The molecular weight of the hydrophilic polymer compound (weight-average molecular weight in a case where the compound has molecular weight distribution) is preferably 3,000 to 5,000,000, and more preferably 5,000 to 200,000.

Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.

Examples of the glycol compound include glycols such as ethylene glycol, diethylene glycol, triethylene glycol, propylene glycol, dipropylene glycol, and tripropylene glycol, and ether or ester derivatives of these compounds.

Examples of the polyol compound include glycerin, pentaerythritol, tris(2-hydroxyethyl) isocyanurate, and the like.

Examples of the organic amine compound include triethanolamine, diethanolamine, monoethanolamine, salts of these, and the like.

Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.

Examples of the organic sulfuric acid compound include alkyl sulfuric acid, alkyl ether sulfuric acid, salts of these, and the like.

Examples of the organic phosphonic acid compound include phenylphosphonic acid, salts thereof, and the like.

Examples of the organic carboxylic acid compound include tartaric acid, oxalic acid, citric acid, malic acid, lactic acid, gluconic acid, salts of these, and the like.

Examples of the betaine compound include a phosphobetaine compound, a sulfobetaine compound, a carboxybetaine compound, and the like. Among these, for example, trimethylglycine is preferable.

The molecular weight of the hydrophilic low-molecular-weight compound (weight-average molecular weight in a case where the compound has molecular weight distribution) is preferably 100 or more and less than 3,000, and more preferably 300 to 2,500.

The development accelerator is preferably a compound having a cyclic structure.

The cyclic structure is not particularly limited. Examples thereof include a glucose ring in which at least some of hydroxyl groups may be substituted, an isocyanuric ring, an aromatic ring which may have a heteroatom, an aliphatic ring which may have a heteroatom, and the like. Among these, for example, a glucose ring or an isocyanuric ring is preferable.

Examples of the compound having a glucose ring include the aforementioned cellulose compound.

Examples of the compound having an isocyanuric ring include the aforementioned tris(2-hydroxyethyl) isocyanurate and the like.

Examples of the compound having an aromatic ring include the toluene sulfonic acid and benzene sulfonic acid described above, and the like.

Examples of the compound having an aliphatic ring include a compound which is the aforementioned alkyl sulfate and has an alkyl group having a ring structure, and the like.

The compound having a cyclic structure preferably has a hydroxyl group.

Preferable examples of the compound having a hydroxyl group and a cyclic structure include the aforementioned cellulose compound and the aforementioned tris(2-hydroxyethyl) isocyanurate.

The development accelerator is preferably an onium salt compound.

Examples of the onium salt compound include an ammonium compound, a sulfonium compound, and the like. Among these, an ammonium compound is preferable.

Examples of the development accelerator which is an onium salt compound include trimethylglycine and the like.

The value of polarity element as an SP value of the onium salt compound in the electron-accepting polymerization initiator is not in a range of 6.0 to 26.0. This onium salt compound is not included in the development accelerator.

The image-recording layer may contain only one kind of development accelerator, or two or more kinds of development accelerators may be used in combination.

One of the preferable aspects of the image-recording layer in the present disclosure is an aspect in which the image-recording layer contains two or more kinds of compounds as a development accelerator.

Specifically, from the viewpoint of on-press developability and receptivity, the image-recording layer in the present disclosure preferably contains, as a development accelerator, the polyol compound and the betaine compound described above, the betaine compound and the organic sulfonic acid compound described above, or the polyol compound and the organic sulfonic acid compound described above.

The content of the development accelerator with respect to the total mass of the image-recording layer is preferably 0.1% by mass or more and 20% by mass or less, more preferably 0.5% by mass or more and 15% by mass or less, and more preferably 1% by mass or more and 10% by mass or less.

[Other additives]

As other components, a surfactant, a polymerization inhibitor, a higher fatty acid derivative, a plasticizer, an inorganic lamellar compound, and the like can be incorporated into the image-recording layer. Specifically, the description in paragraphs "0114" to "0159" of JP2008-284817A can be referred to.

[Formation of image-recording layer]

The image-recording layer in the lithographic printing plate precursor according to the present disclosure can be formed, for example, by preparing a coating solution by dispersing or dissolving the necessary components described above in a known solvent, coating a support with the coating solution by a known method such as bar coating, and drying the coating solution, as described in paragraphs "0142" and "0143" of JP2008-195018A.

As the solvent to be used in the coating solution, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One kind of solvent may be used alone, or two or more kinds of solvents may be used in combination. The concentration of solid contents in the coating solution is preferably 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

The film thickness of the image-recording layer in the lithographic printing plate precursor according to the present disclosure is preferably 0.1 μm to 3.0 μm, and more preferably 0.3 μm to 2.0 μm.

In the present disclosure, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Support>

The lithographic printing plate precursor according to the present disclosure has a support.

As the support, a support having a hydrophilic surface (also called "hydrophilic support") is preferable. The water contact angle of the hydrophilic surface is preferably less than 10°, and more preferably less than 5°.

As the water contact angle in the present disclosure, the contact angle of water droplets (after 0.2 seconds) on a surface at 25°C is measured using DM-501 manufactured by Kyowa Interface Science Co., Ltd.

The support of the lithographic printing plate precursor according to the present disclosure to be used can be appropriately selected from known supports for a lithographic printing plate precursor. As the support, an aluminum plate is preferable which has been roughened using a known method and has undergone an anodic oxidation treatment.

[Preferable aspect of support]

One of the examples of preferable aspects of the support used in the present disclosure (the aluminum support according to this example is also called "support (1)") is as below.

That is, the support (1) has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording

layer, and the average diameter of the micropores within the surface of the anodic oxide film is more than 10 nm and 100 nm or less.

The value of brightness L* of surface of anodic oxide film on the image-recording layer side in the L*a*b* color system is preferably 70 to 100.

Fig. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned so that the anodic oxide film 20a is closer to the image-recording layer side than the aluminum plate 18. That is, it is preferable that the lithographic printing plate precursor according to the present disclosure have at least an anodic oxide film, an image-recording layer, and a water-soluble resin layer in this order on an aluminum plate.

-Anodic oxide film-

Hereinafter, preferable aspects of the anodic oxide film 20a will be described.

The anodic oxide film 20a is a film prepared on a surface of the aluminum plate 18 by an anodic oxidation treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).

Within the surface of the anodic oxide film, the average diameter (average opening diameter) of the micropores 22a in the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 to 40 nm. The internal diameter of the pores may be larger or smaller than the pore diameter within the surface layer.

In a case where the average diameter is more than 10 nm, printing durability and image visibility are further improved. Furthermore, in a case where the average diameter is 100 nm or less, printing durability is further improved.

The average diameter of the micropores 22a is determined by observing the surface of the anodic oxide film 20a with a field emission scanning electron microscope (FE-SEM) at 150,000× magnification (N = 4), measuring the size (diameter) of 50 micropores existing in a range of 400 nm × 600 nm in the obtained 4 images, and calculating the arithmetic mean thereof.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The depth of the micropores 22a is not particularly limited, but is preferably 10 nm to 3,000 nm, more preferably 50 nm to 2,000 nm, and even more preferably 300 nm to 1,600 nm.

The depth is a value obtained by taking a photograph (150,000× magnification) of a cross section of the anodic oxide film 20a, measuring the depths of 25 or more micropores 22a, and calculating the average thereof.

The shape of the micropores 22a is not particularly limited. In Fig. 2, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.

In the L*a*b* color system, the value of brightness L* of the surface of the aluminum support 12a on the image-recording layer side (surface of the anodic oxide film 20a on the image-recording layer side) is preferably 70 to 100. Especially, the value of brightness L* is preferably 75 to 100 and more preferably 75 to 90, because printing durability and image visibility are better balanced in this range.

The brightness L* is measured using a color difference meter Spectro Eye manufactured by X-Rite, Incorporated.

For example, an aspect is also preferable in which the micropores in the support (1) are each composed of a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communication position, an average diameter of the large diameter portion within the surface of the anodic oxide film is 15 nm to 100 nm, and an average diameter of the small diameter portion at a communication position is 13 nm or less (hereinafter, the support according to this aspect will be also called "support (2)").

Fig. 2 is a schematic cross-sectional view of an embodiment of the aluminum support 12a that is different from what is shown in Fig. 1.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communication position to a position at a depth of 20 nm to 2,000 nm.

Hereinafter, the large diameter portion 24 and the small diameter portion 26 will be specifically described.

The average diameter of the large diameter portion 24 within the surface of the anodic oxide film 20b is the same as the average diameter of the micropores 22a in the surface of the anodic oxide film 20a, which is preferably 15 nm to 100 nm. The more suitable range thereof is also the same.

The method for measuring the average diameter of the large diameter portion 24 within the surface of the anodic oxide film 20b is the same as the method for measuring the average diameter of the micropores 22a in the surface of the anodic oxide film 20a.

The bottom portion of the large diameter portion 24 is in a position at a depth of 10 nm to 1,000 nm (hereinafter, also called depth D) from the surface of the anodic oxide film. That is, the large diameter portion 24 is a pore portion extending to a position at a depth of 10 nm to 1,000 nm from the surface of the anodic oxide film in the depth direction (thickness direction). The depth is preferably 10 nm to 200 nm.

The depth is a value obtained by taking a photograph (150,000× magnification) of a cross section of the anodic oxide film 20b, measuring the depths of 25 or more large diameter portions 24, and calculating the average thereof.

The shape of the large diameter portion 24 is not particularly limited. Examples of the shape of the large diameter portion 24 include a substantially straight tubular shape (substantially cylindrical shape) and a conical shape that tapers along the depth direction (thickness direction). Among these, a substantially straight tubular shape is preferable.

As shown in Fig. 2, the small diameter portion 26 is a pore portion that is in communication with the bottom portion of the large diameter portion 24 and further extends from the communication position in the depth direction (thickness direction).

The average diameter of the small diameter portion 26 at the communication position is preferably 13 nm or less. Particularly, the average diameter is preferably 11 nm or less, and more preferably 10 nm or less. The lower limit thereof is not particularly limited, but is 5 nm or more in many cases.

The average diameter of the small diameter portion 26 is obtained by observing the surface of the anodic oxide film 20a with FE-SEM at 150,000× magnification (N = 4), measuring the size (diameter) of the micropores (small diameter portion) existing in a range of 400 nm × 600 nm in the obtained 4 images, and calculating the arithmetic mean thereof. In a case where the large diameter portion is deep, as necessary, the upper portion of the anodic oxide film 20b (region where the large diameter portion is located) may be cut (for example, by using argon gas), then the surface of the anodic oxide film 20b may be observed with FE-SEM described above, and the average diameter of the small diameter portion may be determined.

In a case where the shape of the small diameter portion 26 is not circular, the equivalent circular diameter is used. "Equivalent circular diameter" is a diameter determined on an assumption that the opening portion is in the form of a circle having the same projected area as the projected area of the opening portion.

The bottom portion of the small diameter portion 26 is in a position 20 nm to 2,000 nm distant from the communication position with the large diameter portion 24 in the depth direction. In other words, the small diameter portion 26 is a pore portion that extends further from the communication position with the large diameter portion 24 in the depth direction (thickness direction), and the depth of the small diameter portion 26 is 20 nm to 2,000 nm. The depth is preferably 500 nm to 1,500 nm.

The depth is a value determined by taking a photograph (50,000X magnification) of a cross section of the anodic oxide film 20b, measuring the depths of 25 or more small diameter portions, and calculating the average thereof.

The shape of the small diameter portion 26 is not particularly limited. Examples of the shape of the small diameter portion 26 include a substantially straight tubular shape (substantially cylindrical shape) and a conical shape that tapers along the depth direction. Among these, a substantially straight tubular shape is preferable.

[Method for manufacturing aluminum support]

As a method for manufacturing the aluminum support in the present disclosure, for example, a manufacturing method is preferable in which the following steps are sequentially performed.

- · Roughening treatment step: step of performing roughening treatment on aluminum plate
- · Anodic oxidation treatment step: step of subjecting aluminum plate having undergone roughening treatment to anodic oxidation
- · Pore widening treatment step: step of bringing aluminum plate having anodic oxide film obtained by anodic oxidation treatment step into contact with aqueous acid solution or aqueous alkali solution so that diameter of micropores in anodic oxide film increases

Hereinafter, the procedure of each step will be specifically described.

(Roughening treatment step)

The roughening treatment step is a step of performing a roughening treatment including an electrochemical roughening treatment on the surface of the aluminum plate. This step is preferably performed before the anodic oxidation treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment and mechanical roughening treatment and/or a chemical roughening treatment may be performed in combination.

In a case where the mechanical roughening treatment and the electrochemical roughening treatment are combined, it is preferable to perform the electrochemical roughening treatment after the mechanical roughening treatment.

It is preferable to perform the electrochemical roughening treatment by using direct current or alternating current in an aqueous solution containing nitric acid or hydrochloric acid as a main component.

The method of the mechanical roughening treatment is not particularly limited. Examples thereof include the method described in JP1975-40047B (JP-S50-40047B).

Furthermore, the chemical roughening treatment is not particularly limited, and examples thereof include known methods.

After the mechanical roughening treatment, it is preferable to perform the following chemical etching treatment.

By the chemical etching treatment performed after the mechanical roughening treatment, the edge portion of surface irregularities of the aluminum plate smoothed, so that ink clotting that may occur during printing is prevented, the antifouling properties of the printing plate are improved, and unnecessary substances such as abrasive particles remaining on the surface are removed.

Examples of the chemical etching treatment include etching with an acid and etching with an alkali. One of the examples of particularly efficient etching methods is a chemical etching treatment using an aqueous alkali solution (hereinafter, also called "alkaline etching treatment").

The alkaline agent used in the aqueous alkali solution is not particularly limited. Examples thereof include caustic soda, caustic potash, sodium metasilicate, sodium carbonate, sodium aluminate, and sodium gluconate.

The aqueous alkali solution may contain aluminum ions.

The concentration of the alkaline agent in the aqueous alkali solution is preferably 0.01% by mass or more, and more preferably 3% by mass or more. Furthermore, the concentration of the alkaline agent is preferably 30% by mass or less.

In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").

The acid used in the aqueous acidic solution is not particularly limited, and examples thereof include sulfuric acid, nitric acid, and hydrochloric acid. The temperature of the aqueous acidic solution is preferably 20°C to 80°C.

As the roughening treatment step, a method is preferable in which the treatments described in an aspect A or an aspect B are performed in the following order.

-Aspect A-

(2) Chemical etching treatment using aqueous alkali solution (first alkaline etching treatment)
(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

-Aspect B-

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

As necessary, (1) mechanical roughening treatment may be performed before the treatment (2) of the aspect A or before the treatment (10) of the aspect B.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect A include aqueous solutions used in the electrochemical roughening treatment using direct current or alternating current. Examples thereof include an aqueous solution obtained by adding aluminum nitrate, sodium nitrate, ammonium nitrate, or the like to a 1 to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate; hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is an example of a waveform graph of alternating current used for an electrochemical roughening treatment

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 $A/dm^2$ to 200 $A/dm^2$ at both the anodic cycle side Ia and the cathodic cycle side Ic of the current. Ic/Ia is preferably 0.3 to 20. At a point time when the electrochemical roughening has ended, the total quantity of electricity that participates in the anodic reaction of the aluminum plate is preferably 25 $C/dm^2$ to 1,000 $C/dm^2$.

The electrochemical roughening using alternating current can be performed using the device shown in Fig. 4.

Fig. 4 is a lateral view showing an example of a radial cell in an electrochemical roughening treatment using alternating current.

In Fig. 4, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In Fig. 4, the arrow A1 represents a supply direction of an electrolytic solution, and the arrow A2 represents a discharge direction of the electrolytic solution. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is

supplied to flow in the space between the auxiliary anode 58 and the aluminum plate W.

In view of easily manufacturing a predetermined printing plate precursor, the amount of the aluminum plate dissolved by the second alkaline etching treatment is preferably 1.0 g/m$^2$ or more, and more preferably 2.0 g/m$^2$ to 10 g/m$^2$.

In view of easily manufacturing a predetermined printing plate precursor, the amount of the aluminum plate dissolved by the third alkaline etching treatment and the fourth alkaline etching treatment is preferably 0.01 g/m$^2$ to 0.8 g/m$^2$, and more preferably 0.05 g/m$^2$ to 0.3 g/m$^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

(Anodic oxidation treatment step)

The procedure of the anodic oxidation treatment step is not particularly limited as long as the aforementioned micropores can be obtained. Examples thereof include known methods.

In the anodic oxidation treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodic oxidation treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 5 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

(Pore widening treatment)

The pore widening treatment is a treatment of enlarging the diameter of micropores (also called pore diameter) present in the anodic oxide film formed by the aforementioned anodic oxidation treatment step (that is, a pore diameter enlarging treatment).

The pore widening treatment can be carried out by bringing the aluminum plate obtained by the anodic oxidation treatment step into contact with an aqueous acid solution or an aqueous alkali solution. The contact method is not particularly limited, and examples thereof include a dipping method and a spraying method.

<Undercoat layer>

The lithographic printing plate precursor according to the present disclosure preferably has an undercoat layer (called interlayer) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer inhibits the deterioration of printing durability and contributes to the improvement of developability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent group that can be adsorbed onto the surface of the support and hydrophilic groups. In order to improve adhesiveness to the image-recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more kinds of compounds may be used by being mixed together.

In a case where the compound used in the undercoat layer is a polymer, a copolymer of a monomer having an adsorbent group, a monomer having a hydrophilic group, and a monomer having a crosslinking group is preferable.

As the adsorbent group groups that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive

groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

In order to prevent contamination over time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer is formed by known coating methods. The coating amount (solid content) of the undercoat layer is preferably 0.1 mg/$m^2$ to 100 mg/$m^2$, and more preferably 1 mg/$m^2$ to 30 mg/$m^2$.

The lithographic printing plate precursor according to the present disclosure may have other layers in addition to those described above.

Known layers can be adopted as those other layers without particular limitations. For example, as necessary, a backcoat layer may be provided on a surface of the support that is opposite to the image-recording layer side.

«Method of preparing lithographic printing plate and lithographic printing method»

It is possible to prepare a lithographic printing plate by performing image exposure and a development treatment on the lithographic printing plate precursor according to the present disclosure.

The method of preparing a lithographic printing plate according to the present disclosure preferably includes: a step of subjecting the lithographic printing plate precursor according to the present disclosure to image-wise light exposure (hereinafter, this step will be also called "exposure step"); and a step of removing the image-recording layer in a non-image area by supplying at least one material selected from the group consisting of a printing ink and dampening water on a printer (hereinafter, this step will be also called "on-press development step").

The lithographic printing method according to the present disclosure preferably includes: a step of subjecting the lithographic printing plate precursor according to the present disclosure to image-wise light exposure (exposure step); a step of removing the image-recording layer in a non-image area on a printer by supplying at least one material selected from the group consisting of a printing ink and dampening water so that a lithographic printing plate is prepared (on-press development step); and a step of performing printing by using the obtained lithographic printing plate (hereinafter, also called "printing step").

Hereinafter, regarding the method of preparing a lithographic printing plate according to the present disclosure and the lithographic printing method according to the present disclosure, preferable aspects of each step will be described in order. Note that the lithographic printing plate precursor according to the present disclosure can also be developed using a developer.

Hereinafter, the exposure step and the on-press development step in the method of preparing a lithographic printing plate will be described. The exposure step in the method of preparing a lithographic printing plate according to the present disclosure is the same step as the exposure step in the lithographic printing method according to the present disclosure. Furthermore, the on-press development step in the method of preparing a lithographic printing plate according to the present disclosure is the same step as the on-press development step in the lithographic printing method according to the present disclosure.

<Exposure step>

The method of preparing a lithographic printing plate according to the present disclosure preferably includes: an exposure step of subjecting the lithographic printing plate precursor according to the present disclosure to image-wise light exposure so that an exposed portion and a non-exposed portion are formed. The lithographic printing plate precursor according to the present disclosure is preferably exposed to a laser through a transparent original picture having a linear image, a halftone dot image, or the like or subjected to image-wise light exposure by laser light scanning

according to digital data or the like.

The wavelength of a light source to be used in preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method of preparing a lithographic printing plate according to the present disclosure preferably includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer, so that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. What is supplied first to the surface of the plate may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor according to the present disclosure, a light source having a wavelength of 300 nm to 450 nm or 750 nm to 1,400 nm is preferably used. A light source of 300 nm to 450 nm is preferable for a lithographic printing plate precursor including an image-recording layer containing sensitizing dye having maximum absorption in such a wavelength range. As the light source of 750 nm to 1,400 nm, those described above are preferably used. As the light source of 300 nm to 450 nm, a semiconductor laser is suitable.

<Printing step>

The lithographic printing method according to the present disclosure includes a printing step of printing a recording medium by supplying a printing ink to the lithographic printing plate.

The printing ink is not particularly limited, and various known inks can be used as desired. In addition, preferable examples of the printing ink include oil-based ink or ultraviolet-curable ink (UV ink).

In the printing step, as necessary, dampening water may be supplied.

Furthermore, the printing step may be successively carried out after the on-press development step without stopping the printer.

The recording medium is not particularly limited, and known recording media can be used as desired.

In the method of preparing a lithographic printing plate from the lithographic printing plate precursor according to the present disclosure and in the lithographic printing method according to the present disclosure, as necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result

in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

## Examples

Hereinafter, the present disclosure will be specifically described based on examples, but the present disclosure is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value measured by gel permeation chromatography (GPC) and expressed in terms of polystyrene.

<Preparation of support>

(Preparation of support A)

(a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 $g/m^2$.

(b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

(c) Electrochemical roughening treatment

Next, an electrochemical roughening treatment was performed using alternating current and an electrolytic solution having a hydrochloric concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 $A/dm^2$ in terms of the peak current value of the alternating current waveform. In addition, the quantity of electricity was 450 $C/dm^2$ which was the total quantity of electricity used for the aluminum plate to have an anodic reaction, and the electrolysis treatment was performed 4 times by conducting electricity of 112.5 $C/dm^2$ for 4 seconds at each treatment session. A carbon electrode was used as the counter electrode of the aluminum plate. Then, a rinsing treatment was performed.

(d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 $g/m^2$. Then, a rinsing treatment was performed.

(e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(f) Anodic oxidation treatment

By using an anodic oxidation treatment device 610 for direct current electrolysis having the structure shown in Fig. 5, an anodic oxidation treatment was performed to form an anodic oxide film.

The anodic oxidation treatment was performed under the conditions of a sulfuric acid concentration in the electrolytic solution of 170 g/L, an electrolytic solution temperature 50°C, a current density of 30 A/$dm^2$, and a film amount 2.4 g/$m^2$.

In the anodic oxidation treatment device 610 shown in Fig. 5, an aluminum plate 616 is transported as indicated by the arrow in Fig. 5. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 so as to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodic oxidation device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(g) Pore widening treatment

The aluminum plate having undergone the above anodic oxidation treatment was immersed in an aqueous solution of caustic soda at a temperature of 40°C and having a caustic soda concentration of 5% by mass and an aluminum ion concentration of 0.5% by mass for 3 seconds, thereby performing a pore widening treatment. Then, rinsing was performed by means of spraying.

The details of the obtained support A are as below.

Support A: average diameter of micropores within the surface of the anodic oxide film: 12 nm, value of brightness L* of the surface of the anodic oxide film in the L*a*b* color system: 81

(Preparation of support B)

An aluminum alloy plate made of a material 1S having a thickness of 0.3 mm was subjected to (A-a) Mechanical roughening treatment (brush grain method) to (A-i) Desmutting treatment in aqueous acidic solution described in paragraphs "0126" to "0134" of JP2012-158022A.

Then, an anodic oxide film was formed by performing (A-j) First-stage anodic oxidation treatment to (A-m) Third-stage anodic oxidation treatment described in paragraphs "0135" to "0138" of JP2012-158022A by appropriately adjusting the treatment conditions, and the obtained support was used as a support B.

A rinsing treatment was performed between all the treatment steps. After the rinsing treatment, water was drained using a nip roller.

The details of the obtained support B are as below.

Support B: value of brightness L* of surface of anodic oxide film in L*a*b* color system: 83, average diameter of large diameter portion of micropores within surface of oxide film: 35 nm (depth 100 nm), average diameter of small diameter portion of micropores at communication position: 10 nm (depth 1,000 nm), ratio of depth of large diameter portion to average diameter of large diameter portion: 2.9

[Examples 1 to 29 and Comparative Example 1]

(Formation of undercoat layer)

The support A or B was coated with a coating solution for an undercoat layer having the following composition so that the dry coating amount of 20 $mg/m^2$ was obtained, and the support was dried in an oven at 100°C for 30 seconds, thereby forming an undercoat layer.

<Coating solution for undercoat layer>

- Polymer (P-1) [the following structure, weight-average molecular weight of 200,000]: 0.18 parts
- Hydroxyethyl iminodiacetic acid: 0.10 parts
- Water: 61.4 parts

(P-1)

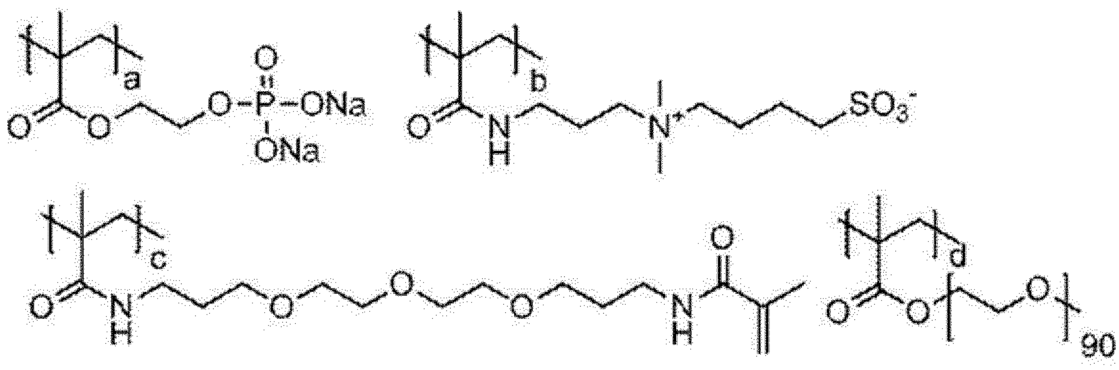

a / b / c / d = 14.2 / 71.8 / 9.0 / 5.0 (wt%)
a / b / c / d = 19.0 / 72.8 / 7.8 / 0.4 (mol%)

(Formation of image-recording layer)

By bar coating, the undercoat layer was coated with a coating solution for an image-recording layer having the following composition (here, the coating solution for an image-recording layer contained the components described in Tables 1 and 2, and the solid contents thereof were adjusted to 6% by mass by using a mixed solvent of 1-methoxy-2-propanol (MFG):methyl ethyl ketone (MEK):methanol = 4: 4:1 (mass ratio)). The support was dried in oven at 120°C for 40 seconds, thereby forming an image-recording layer having a dry coating amount of 1.0 $g/m^2$.
In Example 28, instead of 0.1 parts of the electron-accepting polymerization initiator and 0.025 parts of the electron-donating polymerization initiator, 0.125 parts of a compound in the form of a conjugate salt of the electron-accepting polymerization initiator and the electron-donating polymerization initiator was used.

<Coating solution for image-recording layer>

·Particles (solid content): amount described in Tables 1 and 2 (parts)
·Infrared absorber: 0.02 parts
·Electron-accepting polymerization initiator: 0.1 parts
·Electron-donating polymerization initiator: 0.025 parts
·Polymerizable compound: 0.3 parts
·Anionic surfactant (A-1) [the following structure]: 0.03 parts
·Fluorine-based surfactant (W-1) [the following structure]: 0.004 parts

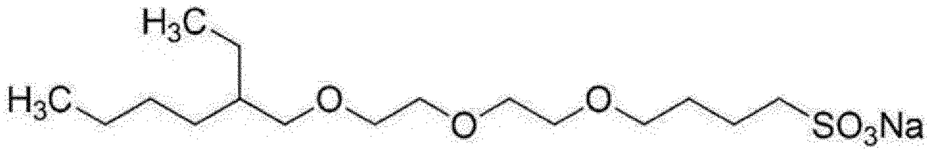

A - 1

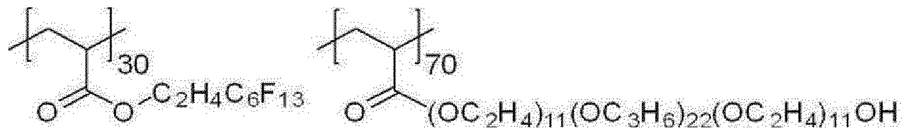

W - 1
Mw = 13,000

(Formation of overcoat layer)

The image-recording layer was bar-coated with a coating solution for an overcoat layer containing the components described in the following Table 3 (here, the coating solution for an overcoat layer contained the components described in Table 3, and the solid content thereof was adjusted to 20% by mass by using deionized water), followed by drying in an oven at 120°C for 60 seconds, thereby forming an overcoat layer having a dry coating amount of 0.15 g/m$^2$.

A lithographic printing plate precursor was obtained through the above steps.

<Evaluation of lithographic printing plate precursor>

[UV plate missing]

By using Magnus 800 Quantum (platesetter) manufactured by Kodak Japan Ltd. that was equipped with an infrared semiconductor laser, the obtained lithographic printing plate precursor was exposed under the conditions of output of 27 W, an outer drum rotation speed of 450 rpm, and a resolution of 2,400 dpi (dot per inch, 1 inch is equal to 2.54 cm) (irradiation energy equivalent to 110 mJ/cm$^2$).

The exposure image included a solid image and an amplitude modulation screen (AM screen) as a 50% halftone dot chart.

A piano wire having a diameter of 150 $\mu$m was attached to the halftone dot portion of the exposed precursor obtained as above in the direction perpendicular to the rotation direction of the plate cylinder, and the precursor was mounted on the Kikuban-sized cylinder of printer SX-74 manufactured by Heidelberger Druckmaschinen AG without being subjected to a development treatment. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on 4,000 sheets of TOKUBISHI art paper (manufactured by MITSUBISHI PAPER MILLS LIMITED., ream weight: 76.5 kg) at a printing rate of 10,000 sheets/hour. Then, the piano wire was removed, and at a point in time when 100 sheets were printed, an evaluation sample was collected.

Regarding the evaluation score for plate missing, the evaluation sample was visually assessed by sensory evaluation on a scale of 1 to 10. "10" means that halftone density was not reduced at all in the portion to which the piano wire was attached.

The results are shown in Tables 1 and 2.

[On-press developability]

The exposed precursor obtained in the same manner as described in Evaluation of UV plate missing was mounted on a Kikuban-sized (636 mm x 939 mm) cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with 80 L of dampening water containing 2.0% by mass of dampening water S-Z1 (manufactured by FUJIFILM Corporation), and an ultraviolet-curable ink T&K UV OFS K-HS black GE-M (manufactured by T&K TOKA CO., LTD.) was used as printing ink. The dampening water and ink were supplied by a standard automatic printing start method, and then printing was performed 500 sheets of TOKUBISHI art paper (ream weight: 76.5 kg, manufactured by MITSUBISHI PAPER MILLS LIMITED.) at a printing rate of 10,000 sheets/hour.

During printing, the number of printing papers used until no ink was transferred to a non-image area was

measured as the on-press developability. It can be said that the smaller the number of printing papers, the better the on-press developability.

The results are shown in Tables 1 and 2.

[Residues of on-press development]

As soon as printing was performed to evaluate on-press developability, the state where the removed residues adhered to the dampening roller was visually observed. In this way, the development residues generated during on-press development (that is, residues of on-press development) were assessed by sensory evaluation on a scale of 1 to 10. "10" means that no residue was attached to the dampening roller.

The results are shown in Tables 1 and 2.

[Visibility: measurement of brightness change ΔL before and after exposure]

In Luxel PLATESETTER T-9800 manufactured by FUJIFILM Global Graphic Systems that is equipped with an infrared semiconductor laser with a wavelength of 830 nm, the obtained lithographic printing plate precursor is exposed under the conditions of output of 99.5%, outer drum rotation speed of 220 rpm, and resolution of 2,400 dpi (energy density of 110 $mJ/cm^2$). The exposure was carried out in an environment of 25°C and 50% RH.

The brightness change of the lithographic printing plate precursor before and after exposure was measured. The brightness change was measured using a spectrocolorimeter eXact manufactured by X-Rite, Incorporated. By using the L* value (brightness) in the L*a*b* color system, the absolute value of a difference between the L* value of the image-recording layer after the exposure and the L* value of the image-recording layer before the exposure was adopted as the brightness change ΔL. In the evaluation, the larger the ΔL, the better the visibility of the exposed portion. The obtained values of ΔL are described in the column of "ΔL (immediately after exposure)" of Tables 1 and 2.

Furthermore, the obtained lithographic printing plate precursor was stored for 24 hours in a dark storage place where the temperature and humidity were controlled to 25°C and 70% RH For the lithographic printing plate precursor after storage, ΔL was measured by the same method as above. The obtained values of ΔL are described in the column of "ΔL (after 24 hours)" in Tables 1 and 2.

[Table 1]

| | Support | Image-recording layer | | | | | | | | | Overcoat layer | Evaluation | | | | |
|---|---|---|---|---|---|---|---|---|---|---|---|---|---|---|---|---|
| | | Particles | | | Infrared absorber | Electron-donating polymerization initiator | Electron-accepting polymerization initiator | Polymerizable compound | H-H difference [eV] | L-L difference [eV] | | UV plate missing | On-press developability | Development residues | ΔL (immediately after exposure) | ΔL (after 24 hours) |
| | | No. | Arithmetic mean particle diameter [nm] | Content [parts] | | | | | | | | | | | | |
| Example 1 | B | Particles 1-1 | 200 | 0.4 | IR-1 | B-1 | I-1 | M-1 | 0.64 | 0.64 | OC6 | 10 | 15 | 10 | 6 | 6 |
| Example 2 | B | Particles 1-2 | 160 | 0.4 | IR-1 | B-1 | I-1 | M-1 | 0.64 | 0.64 | OC6 | 10 | 30 | 10 | 6 | 6 |
| Example 3 | B | Particles 1-3 | 300 | 0.4 | IR-1 | B-1 | I-1 | M-1 | 0.64 | 0.64 | OC6 | 9 | 15 | 9 | 6 | 6 |
| Example 4 | B | Particles 1-1 | 200 | 0.2 | IR-1 | B-1 | I-1 | M-1 | 0.64 | 0.64 | OC6 | 9 | 20 | 8 | 6 | 6 |
| Example 5 | B | Particles 1-1 | 200 | 0.6 | IR-1 | B-1 | I-1 | M-1 | 0.64 | 0.64 | OC6 | 10 | 30 | 10 | 6 | 6 |
| Example 6 | B | Particles 2 | 280 | 0.4 | IR-1 | B-1 | I-1 | M-1 | 0.64 | 0.64 | OC6 | 10 | 15 | 7 | 6 | 6 |
| Example 7 | B | Particles 3 | 25 | 0.4 | IR-1 | B-1 | I-1 | M-1 | 0.64 | 0.64 | OC6 | 8 | 20 | 6 | 6 | 6 |
| Example 8 | B | Particles 4 | 200 | 0.4 | IR-1 | B-1 | I-1 | M-1 | 0.64 | 0.64 | OC6 | 8 | 20 | 6 | 6 | 6 |
| Example 9 | B | Particles 5 | 200 | 0.4 | IR-1 | B-1 | I-1 | M-1 | 0.64 | 0.64 | OC6 | 7 | 20 | 5 | 6 | 6 |
| Example 10 | B | Particles 6 | 100 | 0.4 | IR-1 | B-1 | I-1 | M-1 | 0.64 | 0.64 | OC6 | 5 | 20 | 3 | 6 | 6 |
| Example 11 | B | Particles 1-1 | 200 | 0.4 | IR-2 | B-1 | I-1 | M-1 | 0.68 | 0.65 | OC6 | 9 | 15 | 10 | 5 | 5 |
| Example 12 | B | Particles 1-1 | 200 | 0.4 | IR-3 | B-1 | I-1 | M-1 | 0.69 | 0.60 | OC6 | 10 | 15 | 10 | 6 | 6 |

(continued)

| | Support | Image-recording layer | | | | | | | | | Overcoat layer | Evaluation | | | | |
|---|---|---|---|---|---|---|---|---|---|---|---|---|---|---|---|---|
| | | Particles | | | Infrared absorber | Electron-donating polymerization initiator | Electron-accepting polymerization initiator | Polymerizable compound | H-H difference [eV] | L-L difference [eV] | | UV plate missing | On-press developability | Development residues | ΔL (immediately after exposure) | ΔL (after 24 hours) |
| | | No. | Arithmetic mean particle diameter [nm] | Content [parts] | | | | | | | | | | | | |
| Example 13 | B | Particles 1-1 | 200 | 0.4 | IR-4 | B-1 | I-1 | M-1 | 0.78 | 0.48 | OC6 | 6 | 15 | 10 | 3 | 3 |
| Example 14 | B | Particles 1-1 | 200 | 0.4 | IR-1 | B-1 | 1-2 | M-1 | 0.45 | 0.64 | OC6 | 10 | 15 | 10 | 6 | 6 |
| Example 15 | B | Particles 1-1 | 200 | 0.4 | IR-1 | B-2 | I-1 | M-1 | 0.64 | 1.34 | OC6 | 8 | 15 | 10 | 4 | 4 |
| Example 16 | B | Particles 1-1 | 200 | 0.4 | IR-1 | B-1 | I-1 | M-2 | 0.64 | 0.64 | OC6 | 7 | 15 | 7 | 6 | 6 |
| Example 17 | B | Particles 1-1 | 200 | 0.4 | IR-1 | B-1 | I-1 | M-3 | 0.64 | 0.64 | OC6 | 7 | 15 | 7 | 6 | 6 |

[Table 2]

| | Support | Image-recording layer | | | | | | | | | Overcoat layer | Evaluation | | | | |
|---|---|---|---|---|---|---|---|---|---|---|---|---|---|---|---|---|
| | | Particles | | | Infrared absorber | Electron-donating polymerization initiator | Electron-accepting polymerization initiator | Polymerizable compound | H-H difference [eV] | L-L difference [eV] | | UV plate missing | On-press developability | Development residues | ΔL (immediately after exposure) | ΔL (after 24 hours) |
| | | No. | Arithmetic mean particle diameter [nm] | Content [parts] | | | | | | | | | | | | |
| Example 18 | B | Particles 1-1 | 200 | 0.4 | IR-1 | B-1 | I-1 | M-1 | 0.64 | 0.64 | OC1 | 10 | 15 | 10 | 4 | 4 |
| Example 19 | B | Particles 1-1 | 200 | 0.4 | IR-1 | B-1 | I-1 | M-1 | 0.64 | 0.64 | OC2 | 6 | 15 | 10 | 10 | 10 |
| Example 20 | B | Particles 1-1 | 200 | 0.4 | IR-1 | B-1 | I-1 | M-1 | 0.64 | 0.64 | OC3 | 10 | 15 | 10 | 5 | 5 |
| Example 21 | B | Particles 1-1 | 200 | 0.4 | IR-1 | B-1 | I-1 | M-1 | 0.64 | 0.64 | OC4 | 10 | 15 | 10 | 3 | 3 |
| Example 22 | B | Particles 1-1 | 200 | 0.4 | IR-1 | B-1 | I-1 | M-1 | 0.64 | 0.64 | OC5 | 10 | 15 | 10 | 6 | 6 |
| Example 23 | B | Particles 1-1 | 200 | 0.4 | IR-1 | B-1 | I-1 | M-1 | 0.64 | 0.64 | OC7 | 10 | 15 | 10 | 6 | 6 |
| Example 24 | B | Particles 1-1 | 200 | 0.4 | IR-1 | B-1 | I-1 | M-1 | 0.64 | 0.64 | OC8 | 10 | 15 | 10 | 6 | 6 |
| Example 25 | B | Particles 1-1 | 200 | 0.4 | IR-1 | B-1 | I-1 | M-1 | 0.64 | 0.64 | OC9 | 10 | 15 | 10 | 6 | 4 |
| Example 26 | B | Particles 1-1 | 200 | 0.4 | IR-1 | B-1 | I-1 | M-1 | 0.64 | 0.64 | OC10 | 10 | 15 | 10 | 6 | 6 |
| Example 27 | B | Particles 1-1 | 200 | 0.4 | IR-1 | B-1 | I-1 | M-1 | 0.64 | 0.64 | OC11 | 10 | 15 | 10 | 7 | 5 |
| Example 28 | B | Particles 1-1 | 200 | 0.4 | IR-1 | BI-1 | | M-1 | 0.64 | 0.64 | OC6 | 10 | 15 | 10 | 6 | 6 |
| Example 29 | A | Particles 1-1 | 200 | 0.4 | IR-1 | B-1 | I-1 | M-1 | 0.64 | 0.64 | OC6 | 7 | 15 | 10 | 6 | 6 |

(continued)

| | | Image-recording layer | | | | | | | | | | Evaluation | | | | |
|---|---|---|---|---|---|---|---|---|---|---|---|---|---|---|---|---|
| | Support | Particles | | | Infrared absorber | Electron-donating polymerization initiator | Electron-accepting polymerization initiator | Polymerizable compound | H-H difference [eV] | L-L difference [eV] | Overcoat layer | UV plate missing | On-press developability | Development residues | ΔL (immediately after exposure) | ΔL (after 24 hours) |
| | | No. | Arithmetic mean particle diameter [nm] | Content [parts] | | | | | | | | | | | | |
| Comparative Example 1 | A | N/A | | | IR-2 | B-1 | 1-2 | M-3 | 0.49 | 0.65 | OC6 | 4 | 40 | 2 | 6 | 6 |

[Table 3]

| | | OC1 | OC2 | OC3 | OC4 | OC5 | OC6 | OC7 | OC8 | OC9 | OC10 | OC11 |
|---|---|---|---|---|---|---|---|---|---|---|---|---|
| components | Discoloring compound (decomposable compound) | cya-1 | cya-1 | cya-2 | cya-3 | cya-3 | cya-3 | cya-5 | cya-6 | cya-7 | cya-4 | cya-3 |
| | Content [parts] | 0.02 | 0.2 | 0.02 | 0.02 | 0.02 | 0.02 | 0.02 | 0.02 | 0.02 | 0.02 | 0.02 |
| | Water-soluble polymer | Mowiol 4-88 (PVA) | Mowiol 8-88 (PVA) | Mowiol 4-88 (PVA) | Mowiol 4-88 (PVA) | Mowiol 8-88 (PVA) | Mowiol 8-88 (PVA) | Mowiol 8-88 (PVA) | Mowiol 8-88 (PVA) | Mowiol 8-88 (PVA) | Mowiol 8-88 (PVA) | Mowiol 8-88 (PVA) |
| | Content [parts] | 1.0 | 1.0 | 1.0 | 0.4 | 1.0 | 0.7 | 0.7 | 0.7 | 0.7 | 0.7 | 0.7 |
| | Water-soluble polymer | - | - | - | Mowiol 8-88 (PVA) | WP-1 | WP-1 | WP-1 | WP-1 | WP-1 | WP-1 | WP-1 |
| | Content [parts] | - | - | - | 1.6 | 0.2 | 0.2 | 0.2 | 0.2 | 0.2 | 0.2 | 0.2 |
| | Hydrophobic polymer | - | - | - | - | - | P-1 | P-2 | P-1 | P-1 | P-1 | P-1 |
| | Content [parts] | - | - | - | - | - | 0.5 | 0.5 | 0.5 | 0.5 | 0.5 | 0.5 |
| | Discoloring compound (acid color former) | - | - | - | - | - | - | - | - | S-1 | | S-1 |
| | Content [parts] | - | - | - | - | - | - | - | - | 0.05 | | 0.05 |
| | Acid generator | - | - | - | - | - | - | - | - | Int-1 | | Int-1 |
| | Content [parts] | - | - | - | - | - | - | - | - | 0.1 | | 0.1 |
| | Oil sensitizing agent | - | - | - | - | - | - | - | A-1 | - | | - |
| | Content [parts] | - | - | - | - | - | - | - | 0.02 | - | | - |

In Tables 1 and 2, "H - H difference" represents the value of HOMO of infrared absorber - HOMO of electron-donating polymerization initiator, "L - L differnce" represents the value of LUMO of electron-accepting polymerization initiator - LUMO of infrared absorber.

Details of the components described in Tables 1 to 3 are as below.

[Particles]

(Synthesis of Particles 1-1)

A polyfunctional isocyanate compound (polymeric MDI WANNATE (registered trademark) PM-200: manufactured by Wanhua Chemical Group Co.,Ltd.): 6.66 g, a 50% by mass ethyl acetate solution of "TAKENATE (registered trademark) D-116N (adduct of trimethylolpropane (TMP), m-xylylene diisocyanate (XDI), and polyethylene glycol monomethyl ether (EO90) (the following compound)" manufactured by Mitsui Chemicals, Inc.: 5.46 g, a 65% by mass ethyl acetate solution of a polymerizable compound M-2 having the following structure": 11.53 g, ethyl acetate: 18.66 g, 0.36 g of 1-docosanol (KALCOL 220-80, manufactured by Kao Corporation, solubility in water: < 1% by mass), and PIONIN (registered trademark) A-41-C manufactured by TAKEMOTO OIL & FAT Co., Ltd.: 0.45 g were mixed together and stirred at room temperature (25°C) for 15 minutes, thereby obtaining an oil-phase component.

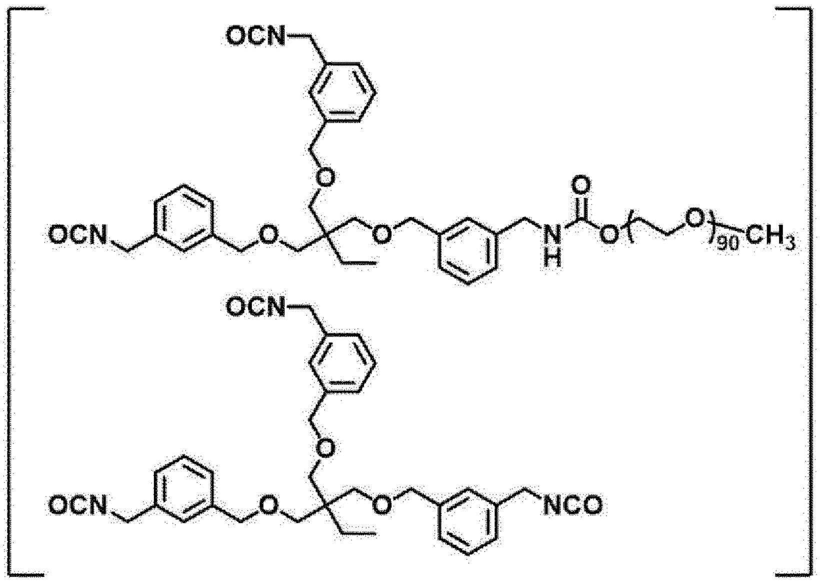

mix

D-116N

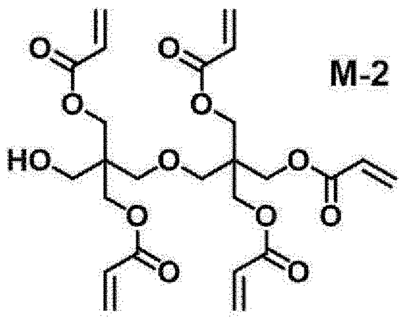

M-2

As a water-phase component, distilled water: 46.89 g was added to the obtained oil-phase component and mixed together, and the obtained mixture was emulsified at a rotation speed of 12,000 rpm for 12 minutes by using a homogenizer, thereby obtaining an emulsion.

The obtained emulsion was added to 16.66 g of distilled water, and stirred. Then, the obtained liquid was heated to 45°C, and stirred for 4 hours in a state of being kept at 45°C so that ethyl acetate was distilled off from the liquid. Then, the liquid from which ethyl acetate was distilled off was heated to 45°C and stirred for 48 hours in a state of being

kept at 45°C, thereby obtaining microcapsule-type particles 1-1 made of a polyaddition-type resin in a liquid. Thereafter, the liquid containing the particles 1-1 was diluted with distilled water so that the concentration of solid contents was 20% by mass, thereby obtaining an aqueous dispersion of the particles 1-1.

The arithmetic mean particle diameter of the particles 1-1 measured by the aforementioned method was 200 nm.

(Synthesis of particles 1-2 and 1-3)

An aqueous dispersion (concentration of solid contents: 20% by mass) of microcapsule-type particles 1-2 was obtained in the same manner as in the synthesis of the microcapsule-type particles 1-1, except that the rotation speed of the homogenizer during emulsification was changed from 12,000 rpm to 16,000 rpm.

The arithmetic mean particle diameter of the particles 1-2 measured by the aforementioned method was 160 nm.

An aqueous dispersion (concentration of solid contents: 20% by mass) of microcapsule-type particles 1-3 was obtained in the same manner as in the synthesis of the microcapsule-type particles 1-1, except that the rotation speed of the homogenizer during emulsification was changed from 12,000 rpm to 6,000 rpm.

The arithmetic mean particle diameter of the particles 1-3 measured by the aforementioned method was 300 nm.

(Synthesis of particles 2)

<Microgel solution>

Microgel: 2.640 parts
Distilled water: 2.425 parts

Microgel used in the aforementioned microgel solution was prepared by the following method.

-Preparation of polyvalent isocyanate compound-

Bismuth tris(2-ethylhexanoate) (NEOSTAN U-600, manufactured by NITTO KASEI CO., LTD., 0.043 parts) was added to an ethyl acetate (25.31 g) suspension solution of 17.78 parts (80 molar equivalents) of isophorone diisocyanate and 7.35 parts (20 molar equivalents) of the following polyhydric phenol compound (1), and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

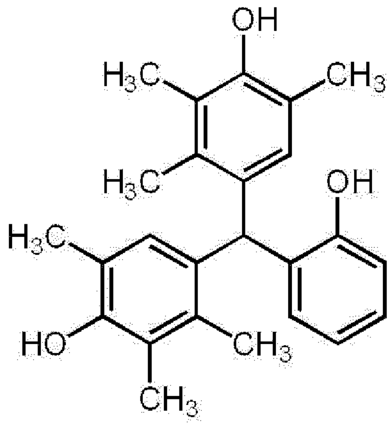

Polyhydric phenol compound (1)

-Preparation of microgel-

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 g of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C

for 24 hours. Distilled water was added thereto so that the concentration of solid contents was adjusted to 20% by mass, thereby obtaining an aqueous dispersion of microgel.

The arithmetic mean particle diameter of the microgel measured by the aforementioned method was 280 nm.

-Oil-phase component-

(Component 1) ethyl acetate: 12.0 parts
(Component 2) an adduct obtained by addition of trimethylolpropane (6 molar equivalents), xylene diisocyanate (18 molar equivalents), and polyoxyethylene having one methylated terminal (1 molar equivalent, the number of repeating oxyethylene units: 90) (50% by mass ethyl acetate solution, manufactured by Mitsui Chemicals, Inc.): 3.76 parts
(Component 3) polyvalent isocyanate compound (1) (as 50% by mass ethyl acetate solution): 15.0 parts
(Component 4) 65% by mass ethyl acetate solution of dipentaerythritol pentaacrylate (SR-399, manufactured by Sartomer Company Inc.): 11.54 parts
(Component 5) 10% ethyl acetate solution of sulfonate type surfactant (PIONIN A-41-C, manufactured by TAKEMOTO OIL & FAT Co., Ltd.): 4.42 parts

-Water-phase component-

Distilled water: 46.87 parts

(Synthesis of particles 3)

An aqueous dispersion of thermoplastic resin particles was prepared by seed emulsion polymerization using styrene and acrylonitrile as monomers.

First, it was confirmed that the following surfactants were present in the reactor to which monomers were not yet added.

A 2 L double-jacketed reactor was filled with 10.35 g of Chemfac PB-133 (Chemfac PB-133 manufactured by Chemax Inc., an alkyl ether phosphate surfactant), 1.65 g of NaHCO3, and 1,482.1 g of demineralized water. Nitrogen was caused to flowed in the reactor and heated to 75°C. At a point in time when the temperature of the contents of the reactor reached 75°C, a 1.5% monomer mixture (that is, a monomer mixture of 2.29 g of styrene and 1.16 g of acrylonitrile) was added.

The monomer mixture was emulsified at 75°C for 15 minutes, and then 37.95 g of a 2% by mass aqueous sodium persulfate solution was added thereto. Then, the reactor was heated to a temperature of 80°C for 30 minutes.

The rest of the monomer mixture (a monomer mixture of 150.1 g of styrene and 76.5 g of acrylonitrile) was then added to the reaction mixture for 180 minutes. The monomer mixture was added together with an extra amount of aqueous sodium persulfate solution (37.95 g of a 2% by mass aqueous $Na_2S_2O_8$ solution). After the addition of the monomer mixture was finished, the reactor was heated at 80°C for 60 minutes. In order to reduce the amount of residual monomers, distillation was performed under reduced pressure at 80°C for 1 hour. Subsequently, the reactor was cooled to room temperature, 100 ppm of Proxel Ultra 5 (manufactured by ARCH UK BIOCIDES LIMITED, and a 5% by mass aqueous solution of 1,2-benzisothiazol-3(2H)-one) was added thereto as a disinfectant, thereby preparing an aqueous dispersion of thermoplastic resin particles (solid content 20% by mass).

The thermoplastic resin particles had a compositional ratio of constitutional unit formed of styrene:constitutional unit formed of acrylonitrile = 2:1 (mass ratio), had an arithmetic mean particle diameter of 25 nm, and a glass transition temperature of 120°C.

(Synthesis of particles 4)

Dispersion unit: the following compound B-1 (n = 45): 10.0 parts, 85.0 parts of distilled water, and 240.0 parts of n-propanol were added to a four-neck flask, and the mixture was heated and stirred at 70°C in a nitrogen atmosphere.

Then, a mixture of the following compound A-1: 20.0 parts, the following compound A-2: 70.0 parts, and 0.7 parts of 2,2'-azobisisobutyronitrile that were mixed together in advance was added dropwise for 2 hours to the four-neck flask.

After the dropwise addition ended, the reaction continued for 5 hours, then 0.5 parts of 2,2'-azobisisobutyronitrile was added thereto, and the solution was heated to 80°C. The reaction was performed for a total of 19 hours by adding 0.4 parts of 2,2'-azobisisobutyronitrile every 6 hours.

The reaction solution was left to cool to room temperature (25°C), thereby obtaining a dispersion of particles

4 (solid content 23%).

The arithmetic mean particle diameter of the particles 4 was 200 nm.

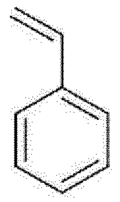

A-1

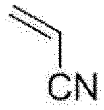

A-2

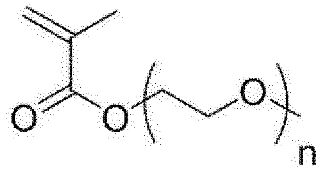

B-1

(Preparation of particles 5)

As particles 5, polystyrene particles (Polybead Polystyrene Microspheres (2.5% Solids-Latex), 0.20 μm (manufactured by Polysciences, Inc.), arithmetic mean particle diameter: 200 nm) were prepared.

(Preparation of particles 6)

As particles 6, silica particles (MP-1040 (manufactured by Nissan Chemical Corporation), arithmetic mean particle diameter: 100 nm) were prepared.

[Infrared absorber]

IR-1: Compound having the following structure (HOMO: -5.27 eV, LUMO: -3.66 eV)
IR-2: Compound having the following structure (HOMO: -5.26 eV, LUMO: -3.70 eV)
IR-3: Compound having the following structure (HOMO: -5.31 eV, LUMO: -3.71 eV)
IR-4: Compound having the following structure (HOMO: -5.43 eV, LUMO: -3.80 eV)

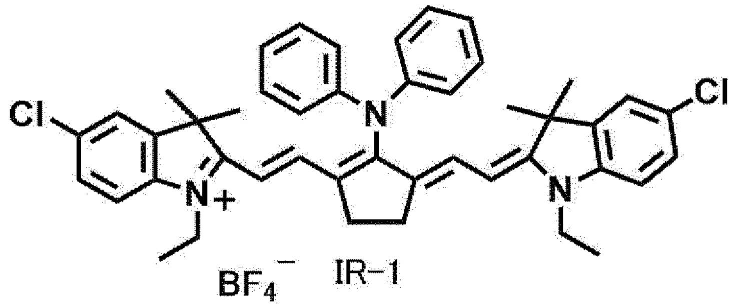

IR-1

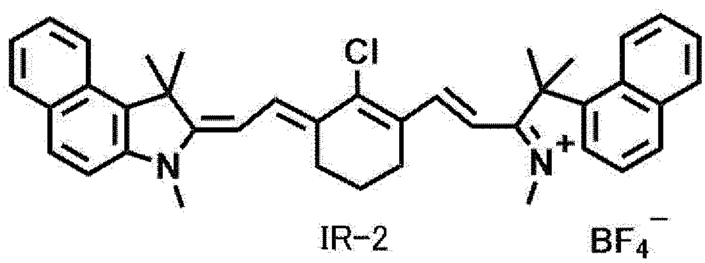

IR-2

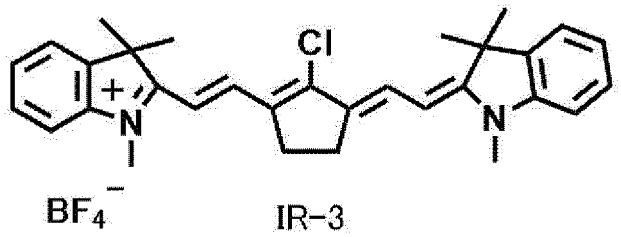

IR-3

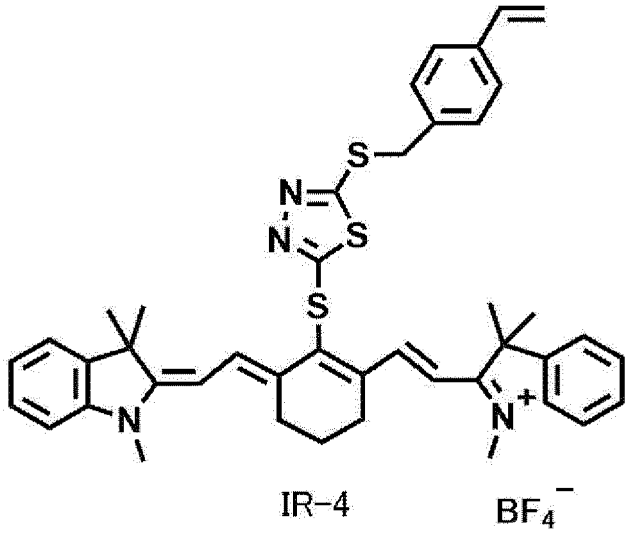

IR-4

[Electron-donating polymerization initiator]

B-1: Compound having the following structure, (HOMO = -5.91 eV)
B-2: Compound having the following structure, (HOMO = -6.61 eV)

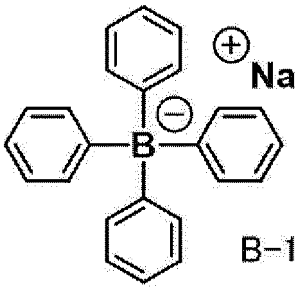

B-1

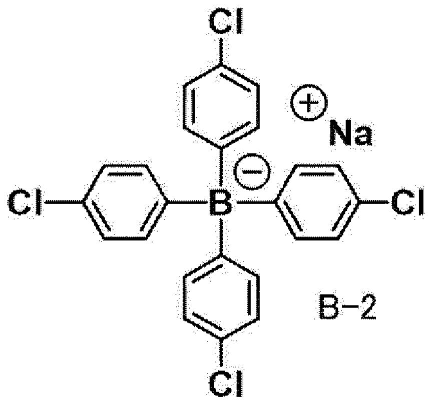

B-2

[Electron-accepting polymerization initiator]

1-1: Compound having the following structure, (LUMO = -3.02 eV)
1-2: Compound having the following structure, (LUMO = -3.21 eV)

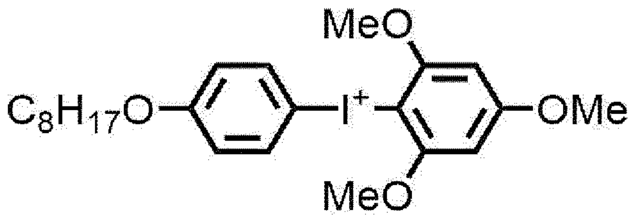

I-1

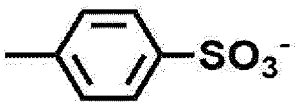

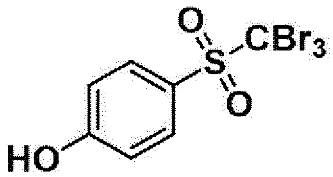

I-2

[Compound in the form of conjugate salt of electron-accepting polymerization initiator and electron-donating polymerization initiator]

BI-1: Compound having the following structure (HOMO of electron-accepting polymerization initiator component: -5.91, LUMO of electron-donating polymerization initiator component: -3.02)

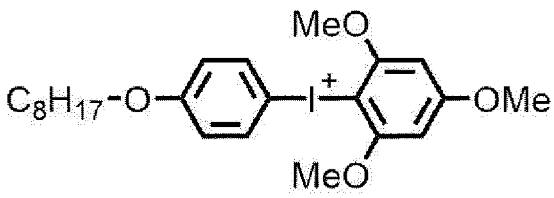

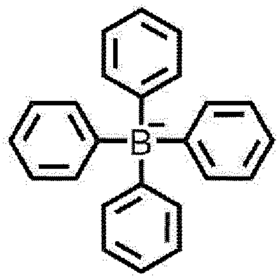

BI-1

[Polymerizable compound]

M-1: Compound having the following structure
M-2: Compound having the following structure (ethoxylated isocyanuric acid triacrylate, A-9300 manufactured by SHIN-NAKAMURA CHEMICAL CO., LTD.)
M-3: Mixture of compounds having the following structure (FST 510 manufactured by AZ Electronic Materials)

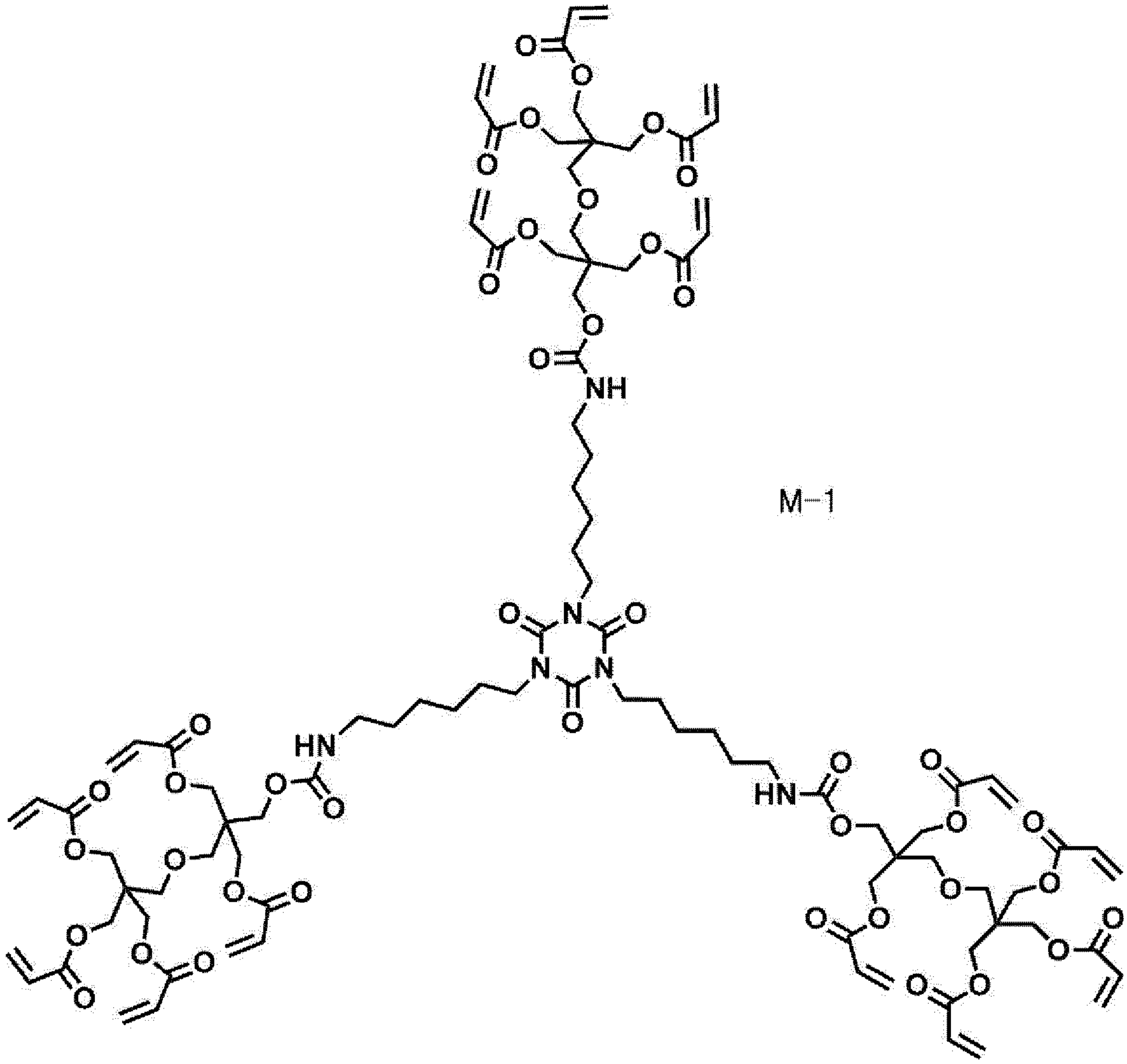

M-1

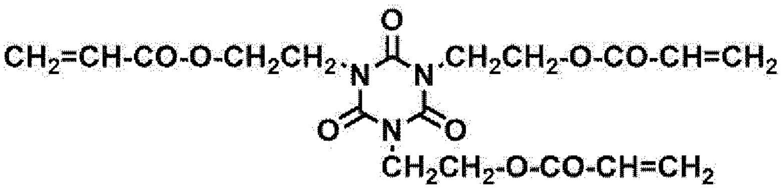

M-2

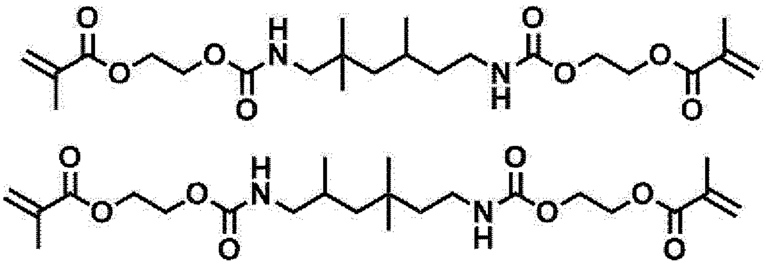

M-3

Hereinafter, details of the components shown in Table 3 will be described.

[Discoloring compound]

(Decomposable compound)
cya-1 to cya-6: Compounds having the following structures

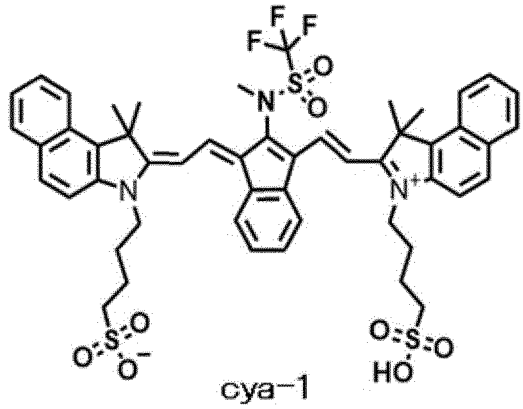

cya-1

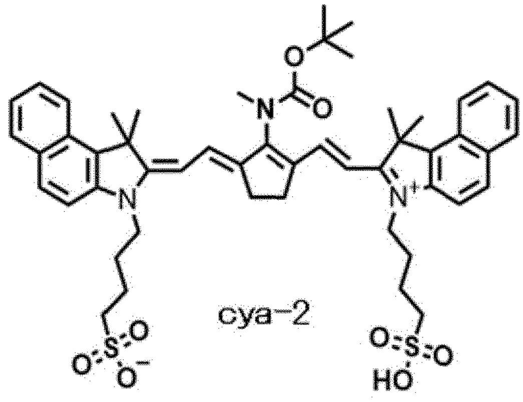

cya-2

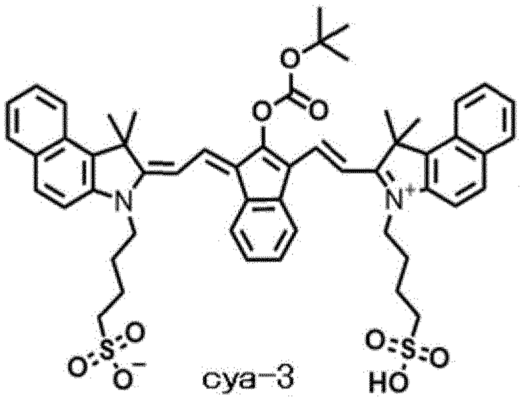

cya-3

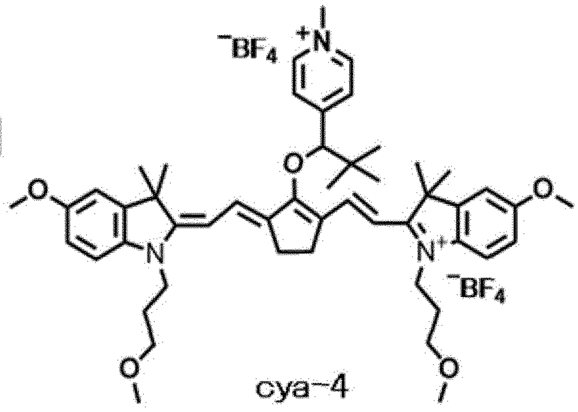

cya-4

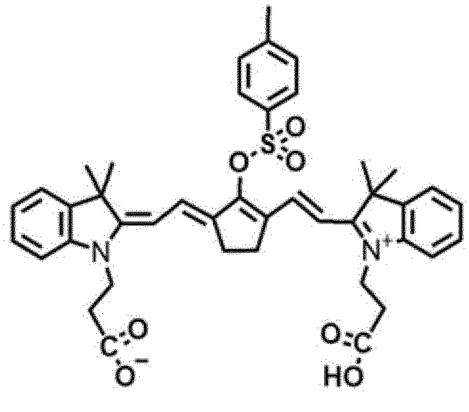

cya-5

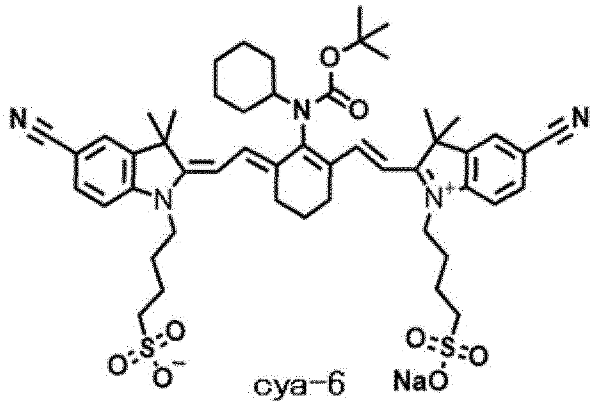

cya-6

(Acid color former)

S-1: Compound having the following structure

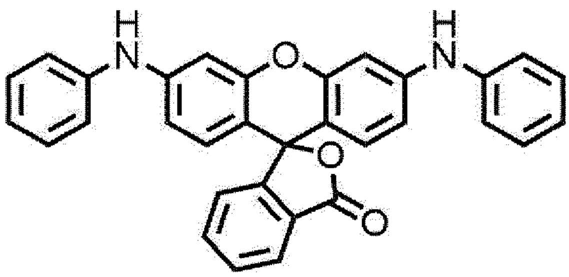

S-1

cya-7: Compound having the following structure (non-decomposable compound)

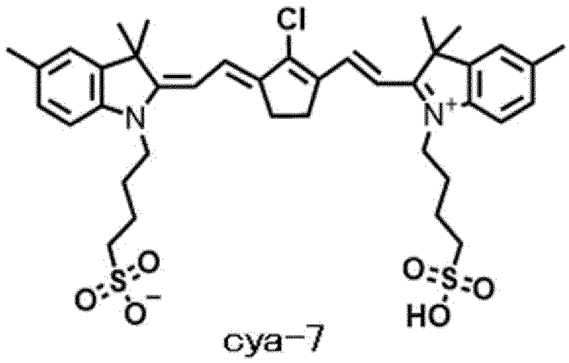

cya-7

(Water-soluble polymer)

Mowiol 4-88: Polyvinyl alcohol (PVA) particles having a saponification degree of 88 mol%, Mowiol (registered trademark) 4-88 manufactured by Sigma-Aldrich Inc.
Mowiol 8-88: Polyvinyl alcohol (PVA) particles having a saponification degree of 88 mol%, Mowiol (registered trademark) 8-88 manufactured by Sigma-Aldrich Inc.
WP-1: compound having the following structure (polyvinylpyrrolidone, weight-average molecular weight 45,000)

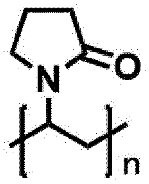

WP-1

(Hydrophobic polymer)

P-1: compound having the following structure (polyvinylidene chloride, weight-average molecular weight: 40,000)
P-2: compound having the following structure (styrene-methyl acrylate copolymer, weight-average molecular weight: 40,000)

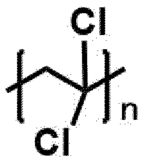

P-1

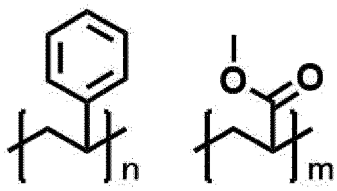

P-2

(Acid generator)

Int-1: Compound having the following structure

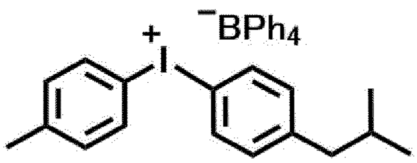

Int-1

(Oil sensitizing agent)

A-1: Compound having the following structure

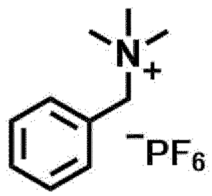

A-1

As is evident from Tables 1 and 2, unlike the lithographic printing plate precursors according to comparative examples, the lithographic printing plate precursors according to examples make it possible to obtain a lithographic printing plate inhibited from causing UV plate missing.

Furthermore, it has been confirmed that the lithographic printing plate precursors according to examples are excellent in the visibility of exposed portions, have excellent on-press developability, and excellently suppress development residues.

Explanation of References

18: aluminum plate
12a, 12b: aluminum support
20a, 20b: anodic oxide film
22a, 22b: micropore
24: large diameter portion
26: small diameter portion
50: main electrolytic cell
51: alternating current power source
52: radial drum roller
53a, 53b: main pole
54: electrolytic solution supply port
55: electrolytic solution
56: auxiliary anode
60: auxiliary anode tank
A1: supply direction of electrolytic solution
A2: discharge direction of electrolytic solution
ta: anodic reaction time
tc: cathodic reaction time
tp: time taken for current to reach peak from 0
Ia: peak current on anodic cycle side
Ic: peak current on cathodic cycle side
W: aluminum plate
AA: current of anodic reaction of aluminum plate
CA: current of cathodic reaction of aluminum plate
610: anodic oxidation treatment device
616: aluminum plate
618: electrolytic solution
612: power supply tank
614: electrolytic treatment tank
616: aluminum plate
620: power supply electrode
622: roller
624: nip roller
626: electrolytic solution
628: roller
630: electrolysis electrode
634: direct current power source
ECa: current of anodic reaction of aluminum plate
ECb: current of cathodic reaction of aluminum plate

The entire disclosure of Japanese Patent Application No. 2020-034242, filed February 28, 2020, is incorporated into the present specification by reference. All of documents, patent applications, and technical standards described in the present specification are incorporated into the present specification by reference to approximately the same extent as a case where it is specifically and respectively described that the respective documents, patent applications, and technical standards are incorporated by reference.

## Claims

1. A lithographic printing plate precursor comprising, in the following order:

   a support;

an image-recording layer; and
an overcoat layer,
wherein the image-recording layer comprises a polymerization initiator, a polymerizable compound, and particles, and
the overcoat layer comprises a discoloring compound.

**2.** The lithographic printing plate precursor according to claim 1,
wherein the particles are addition polymerization-type resin particles.

**3.** The lithographic printing plate precursor according to claim 1,
wherein the particles are polyaddition-type resin particles.

**4.** The lithographic printing plate precursor according to claim 3,
wherein the polyaddition-type resin particles have a three-dimensional crosslinked structure.

**5.** The lithographic printing plate precursor according to claim 1,
wherein the particles are thermoplastic resin particles.

**6.** The lithographic printing plate precursor according to any one of claims 1 to 5,

wherein the particles comprise a hydrophilic group, and
the hydrophilic group comprises a group represented by Formula Z,

-Q-W-Y Formula Z

wherein, in Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with another structure.

**7.** The lithographic printing plate precursor according to claim 6,
wherein any of the hydrophilic structures comprises a polyalkylene oxide structure.

**8.** The lithographic printing plate precursor according to any one of claims 1 to 7,
wherein the particles further comprise a polymerizable group.

**9.** The lithographic printing plate precursor according to any one of claims 1 to 8,
wherein an arithmetic mean particle diameter of the particles is 1 nm to 500 nm.

**10.** The lithographic printing plate precursor according to any one of claims 1 to 9,
wherein in a case where the lithographic printing plate precursor is exposed to infrared having a wavelength of 830 nm at an energy density of 110 $mJ/cm^2$, a brightness change $\Delta L$ before and after the exposure is 1 or more.

**11.** The lithographic printing plate precursor according to any one of claims 1 to 10,
wherein the discoloring compound comprises a decomposable compound that decomposes due to exposure to infrared.

**12.** The lithographic printing plate precursor according to claim 11,
wherein the discoloring compound comprises a decomposable compound that decomposes by either or both of heat and electron transfer resulting from exposure to infrared.

**13.** The lithographic printing plate precursor according to claim 11 or 12,
wherein the decomposable compound is a cyanine dye.

**14.** The lithographic printing plate precursor according to any one of claims 11 to 13,

wherein the decomposable compound is a compound represented by Formula 1-1,

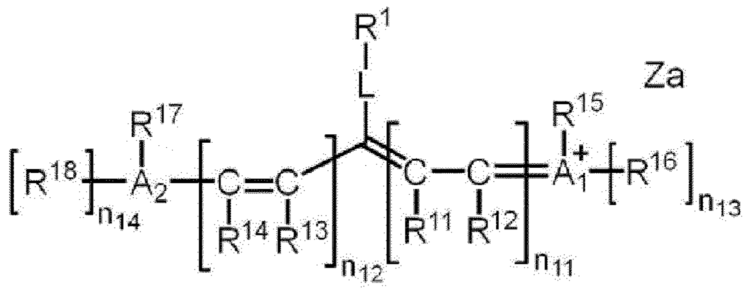

Formula 1-1

wherein, in Formula 1-1, $R^1$ represents a group that is represented by any of Formula 2 to Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge,

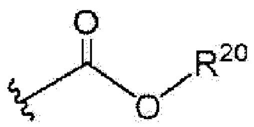

Formula 2

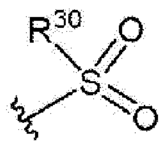

Formula 3

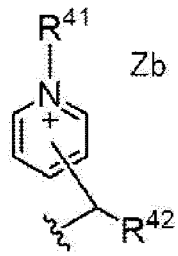

Formula 4

in Formula 2 to Formula 4, $R^{20}$, $R^{30}$, $R^{41}$, and $R^{42}$ each independently represent an alkyl group or an aryl group, Zb represents a counterion that neutralizes charge, and a wavy line represents a binding site with the group represented by L in Formula 1-1.

**15.** The lithographic printing plate precursor according to any one of claims 1 to 14,
wherein the discoloring compound comprises an acid color former.

**16.** The lithographic printing plate precursor according to any one of claims 1 to 15,
wherein the overcoat layer further comprises a water-soluble polymer.

**17.** The lithographic printing plate precursor according to claim 16,
wherein the water-soluble polymer comprises polyvinyl alcohol having a saponification degree of 50% or more.

**18.** The lithographic printing plate precursor according to any one of claims 1 to 17,
wherein the overcoat layer further comprises an oil sensitizing agent.

**19.** The lithographic printing plate precursor according to any one of claims 1 to 18,
wherein the polymerization initiator comprises an electron-donating polymerization initiator and an electron-accepting polymerization initiator.

**20.** The lithographic printing plate precursor according to claim 19,
wherein the polymerization initiator comprises a compound in the form of a conjugate salt of the electron-donating polymerization initiator and the electron-accepting polymerization initiator.

**21.** The lithographic printing plate precursor according to claim 19,

wherein the electron-accepting polymerization initiator comprises a compound represented by Formula (II),

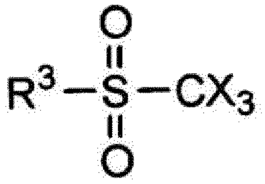

(II)

wherein, in Formula (II), X represents a halogen atom, and $R^3$ represents an aryl group.

**22.** The lithographic printing plate precursor according to any one of claims 19 to 21,

wherein the image-recording layer comprises an infrared absorber, and
HOMO of the infrared absorber - HOMO of the electron-donating polymerization initiator is 0.70 eV or less.

**23.** The lithographic printing plate precursor according to any one of claims 19 to 22,

wherein the image-recording layer comprises an infrared absorber, and
LUMO of the electron-accepting polymerization initiator - LUMO of the infrared absorber is 0.70 eV or less.

**24.** The lithographic printing plate precursor according to any one of claims 1 to 23,
wherein the polymerizable compound comprises a polymerizable compound having functionalities of 7 or more.

**25.** The lithographic printing plate precursor according to any one of claims 1 to 24,
wherein the polymerizable compound comprises a polymerizable compound having functionalities of 10 or more.

**26.** The lithographic printing plate precursor according to any one of claims 1 to 25,

wherein the support comprises an aluminum plate and an anodic oxide film of aluminum disposed on the aluminum plate,
the anodic oxide film is at a position closer to a side of the image-recording layer than the aluminum plate and has micropores extending in a depth direction from a surface of the anodic oxide film on the side of the image-recording layer, and
an average diameter of the micropores within the surface of the anodic oxide film is more than 10 nm and 100 nm or less.

**27.** The lithographic printing plate precursor according to claim 26,

wherein the micropores are each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communication position,
an average diameter of the large diameter portion within the surface of the anodic oxide film is 15 nm to 100 nm, and
an average diameter of the small diameter portion at the communication position is 13 nm or less.

**28.** A method of preparing a lithographic printing plate, comprising:

a step of subjecting the lithographic printing plate precursor according to any one of claims 1 to 27 to image-wise light exposure; and
a step of supplying at least one material selected from the group consisting of a printing ink and dampening water on a printer so as to remove the image-recording layer in a non-image area.

**29.** A lithographic printing method comprising:

a step of subjecting the lithographic printing plate precursor according to any one of claims 1 to 27 to image-wise light exposure;
a step of supplying at least one material selected from the group consisting of a printing ink and dampening water on a printer so as to remove the image-recording layer in a non-image area and to prepare a lithographic

printing plate; and
a step of performing printing by using the obtained lithographic printing plate.

FIG. 1

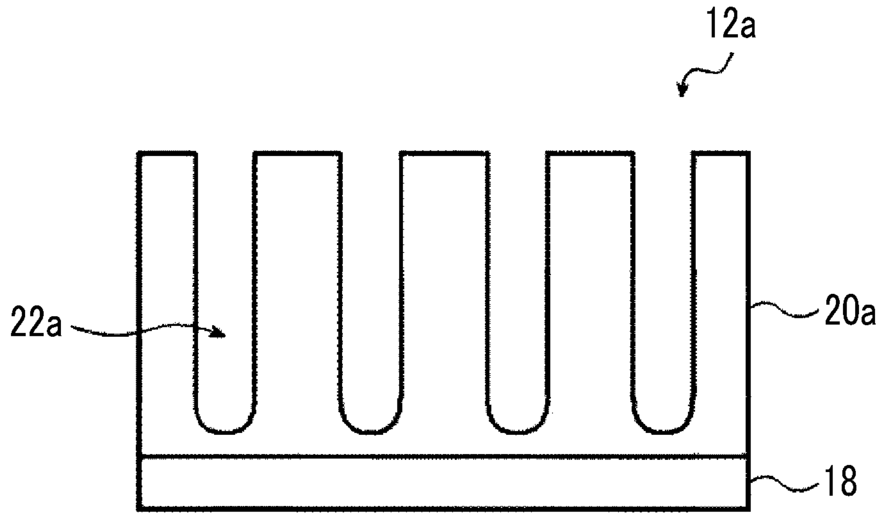


FIG. 2

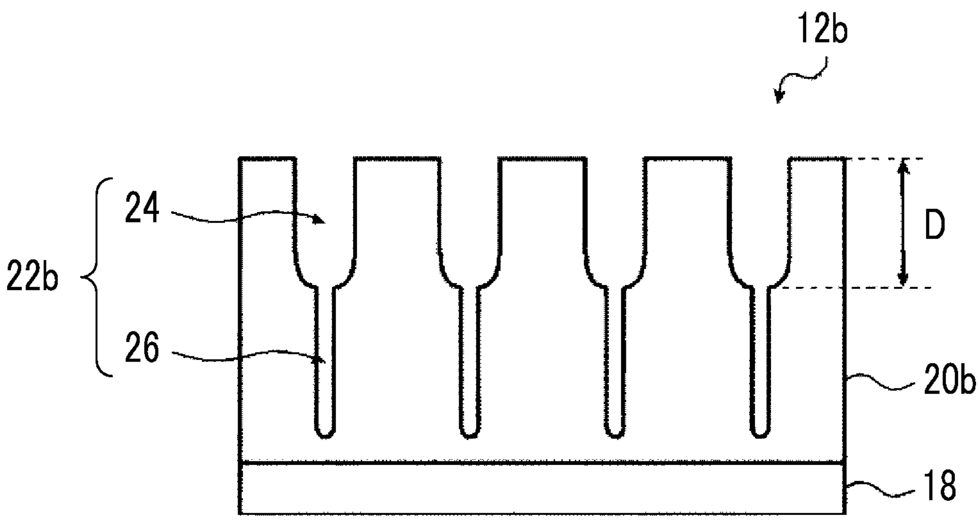

FIG. 3

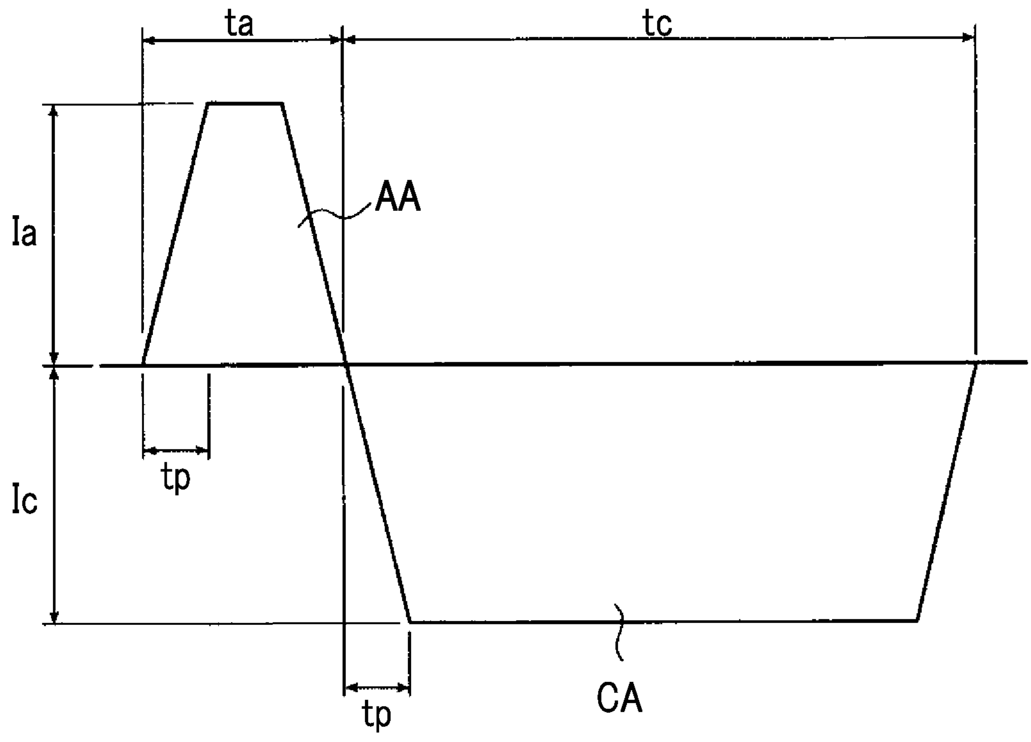

FIG. 4

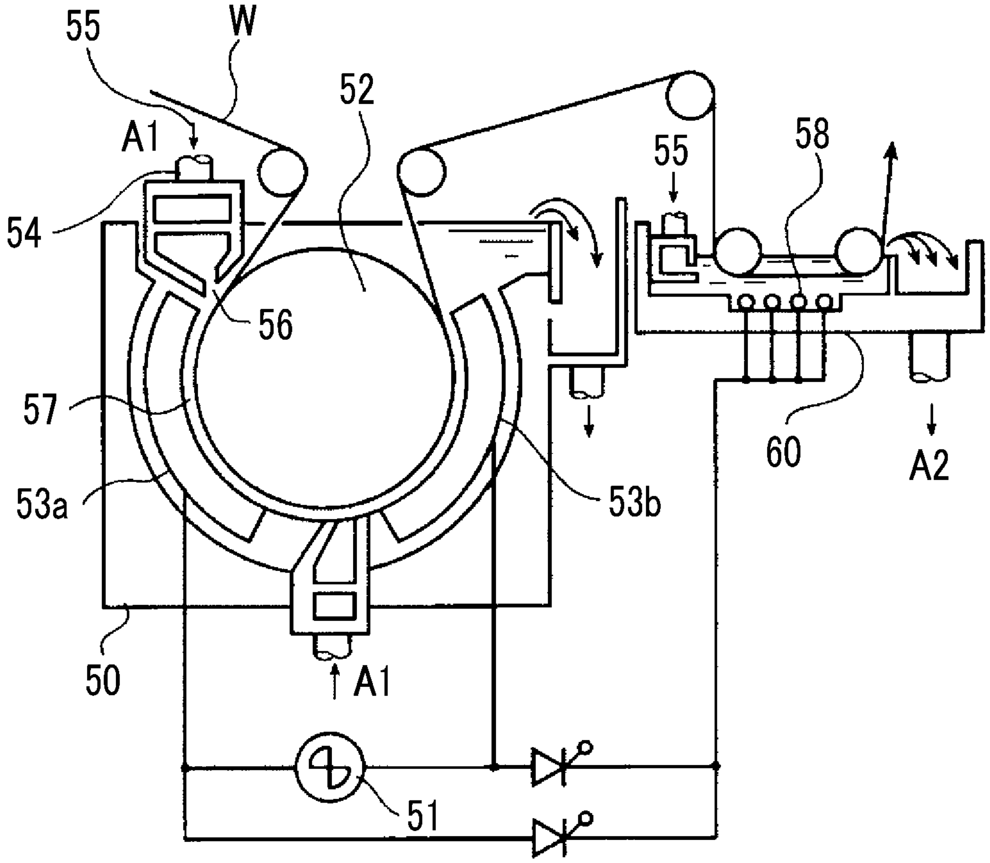

FIG. 5

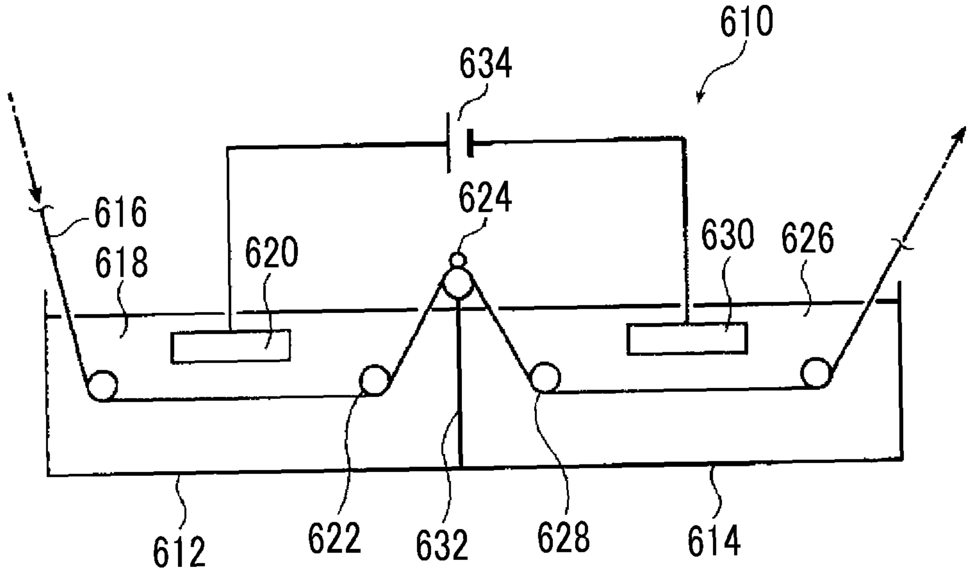

**INTERNATIONAL SEARCH REPORT**

International application No. PCT/JP2021/007164

A. CLASSIFICATION OF SUBJECT MATTER
B41N 1/14(2006.01)i; G03F 7/00(2006.01)i; G03F 7/004(2006.01)i; G03F 7/029(2006.01)i; G03F 7/031(2006.01)i; G03F 7/11(2006.01)i
FI: B41N1/14; G03F7/004 501; G03F7/004 505; G03F7/11 501; G03F7/029; G03F7/031; G03F7/00 503

According to International Patent Classification (IPC) or to both national classification and IPC

B. FIELDS SEARCHED

Minimum documentation searched (classification system followed by classification symbols)
B41N1/14; G03F7/00; G03F7/004; G03F7/029; G03F7/031; G03F7/11

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-96027 A (FUJI PHOTO FILM CO., LTD.) 13 April 2006 (2006-04-13) claims 1-10, paragraphs [0204], [0282]-[0283], [0298]-[0353] | 1-5, 8-10, 15-17, 28-29<br>6-7, 11-14, 18-27 |
| Y | WO 2019/044087 A1 (FUJIFILM CORPORATION) 07 March 2019 (2019-03-07) claims 1, 8, 9 | 6-7, 11-14, 18-27 |
| Y | WO 2016/027886 A1 (FUJIFILM CORPORATION) 25 February 2016 (2016-02-25) claims 13, 16, paragraph [0182] | 11-14, 18-25 |
| Y | US 2009/0269699 A1 (MUNNELLY, Heidi M. et al.) 29 October 2009 (2009-10-29) paragraph [0158] | 19-25 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 May 2021 (10.05.2021) | 25 May 2021 (25.05.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/007164

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2018/092661 A1 (FUJIFILM CORPORATION) 24 May 2018 (2018-05-24) claims 13-15, 17, paragraph [0294] | 19-25 |
| Y | JP 2013-504084 A (EASTMAN KODAK COMPANY) 04 February 2013 (2013-02-04) paragraph [0074] | 21, 24-25 |
| Y | WO 2018/159710 A1 (FUJIFILM CORPORATION) 07 September 2018 (2018-09-07) paragraphs [0037], [0110] | 24-25 |

Form PCT/ISA/210 (continuation of second sheet) (January 2015)

**INTERNATIONAL SEARCH REPORT**
Information on patent family members

International application No.
PCT/JP2021/007164

| Patent Documents referred in the Report | Publication Date | Patent Family | Publication Date |
|---|---|---|---|
| JP 2006-96027 A | 13 Apr. 2006 | US 2006/0024612 A1 claims 1-19, paragraphs [0213], [0309]-[0311], [0333]-[0367]<br>EP 1621338 A1 | |
| WO 2019/044087 A1 | 07 Mar. 2019 | US 2019/0061404 A1 claims 1, 8<br>EP 3476616 A1<br>CN 109729714 A<br>BR 112018072411 A2 | |
| WO 2016/027886 A1 | 25 Feb. 2016 | US 2017/0123315 A1 claims 13, 16, paragraph [0324]<br>EP 3184590 A1<br>CN 106661338 A<br>BR 112017003349 A2 | |
| US 2009/0269699 A1 | 29 Oct. 2009 | EP 2113381 A2 | |
| WO 2018/092661 A1 | 24 May 2018 | US 2019/0329545 A1 claims 9-10, paragraph [0682]<br>EP 3543790 A1<br>CN 109952536 A<br>BR 112019009802 A2 | |
| JP 2013-504084 A | 04 Feb. 2013 | US 2012/0152139 A1 paragraphs [0082]-[0088]<br>WO 2011/026907 A1<br>EP 2293144 A1<br>CN 102483588 A | |
| WO 2018/159710 A1 | 07 Sep. 2018 | US 2019/0088473 A1 paragraphs [0106], [0292]<br>EP 3456547 A1<br>CN 109153279 A<br>BR 112019015835 A2 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019219560 A
- JP 2008503365 A
- JP 2019219560 A
- JP 2005250216 A
- JP 2006259137 A
- JP 2006297907 A
- JP 2007050660 A
- JP 2008284858 A
- JP 2009090645 A
- JP 2009208458 A
- WO 2016047392 A
- JP 2008195018 A
- JP 8108621 A
- JP H08108621 A
- JP 61166544 A
- JP S61166544 A
- JP 2002328465 A
- JP 2002162741 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S4841708 B
- JP 51037193 A
- JP S51037193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2012206495 A
- JP 2001133969 A
- JP 2002023360 A
- JP 2002040638 A
- JP 2002278057 A
- JP 2007090850 A
- JP 5005005 A
- JP H055005 A
- JP 2001222101 A
- JP 2012148555 A
- JP 2008284817 A
- JP 50040047 B
- JP S5040047 B
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2012158022 A
- JP 2020034242 A

**Non-patent literature cited in the description**


- Polymer Handbook. VII-698-711
- Polymer Handbook
- *Research Disclosure,* January 1992, (33303
- Dye Handbooks. Society of Synthetic Organic Chemistry, 1970